# EUROPEAN PATENT APPLICATION

(11) **EP 4 646 085 A1**
(43) Date of publication of application: **05.11.2025**
(21) Application number: 24173289.0
(22) Date of filing: 30.04.2024
(51) Int. Cl.: H10K 85/60

(54) **INDACENE COMPOUNDS AND THE USE THEREOF**

(71) Applicant: CREDOXYS GmbH, 01187 Dresden (DE)
(72) Inventor: KISHONI, Adrian, 01187 Dresden (DE); DOROK, Sascha, 01187 Dresden (DE); PAPMEYER, Marcus, 01187 Dresden (DE); STOLZ, Julia, 01187 Dresden (DE)

(57) **Abstract**

The present invention relates to compounds of formula (I) as well as to their use as organic doping agent, as transport layer, as hole injection layer, as organic semiconductor itself, or as hole transport layer. The invention also relates to organic semiconductive materials, electronic components, semiconductor units, and doped semiconductor layers in which the compounds of formula (I) are used as well as to a method do prepare such a doped semiconductor layer.

## Description

The present invention relates to compounds of formula (I) as well as to their use as organic doping agent, as transport layer, as hole injection layer, as organic semiconductor itself, or as hole transport layer. The invention also relates to organic semiconductive materials, electronic components, semiconductor units, and doped semiconductor layers in which the compounds of formula (I) are used as well as to a method do produce such a doped semiconductor layer.

### BACKGROUND OF THE INVENTION

Organic electronics focuses on the development, characterization and application of new materials, both based on small organic molecules and polymers with certain desired electronic properties for the production of electronic components.

These include, for example, organic field-effect transistors (OFETs), such as organic thin-film transistors (OTFTs), organic electroluminescent devices, such as organic light-emitting diodes (OLEDs), organic solar cells (OSCs), e.g. exciton solar cells, dye-sensitized solar cells (DSSCs), or perovskite solar cells; electrophotography, e.g., photoconductive materials in organic photoconductors (OPCs); organic optical detectors; organic photoreceptors; light-emitting electrochemical cells (LECs); and organic laser diodes.

It is known that organic semiconductor matrices can be strongly influenced in terms of their electrical conductivity by doping. Such organic semiconductor layers of semiconductor matrix material can be built either from compounds with electron donor properties (p-type conductors) or from compounds with electron acceptor properties (n-type conductors). Unlike inorganic semiconductors, organic semiconductors have very low intrinsic charge carrier density. To achieve good semiconductor properties, organic semiconductor matrix materials are therefore usually doped. For n-doping, strong electron donors (n-dopants) are used to transfer an electron to the LUMO (lowest unoccupied molecular orbital) of the semiconductor matrix (n-doping), resulting in a free electron on the matrix (SOMO - singly occupied molecular orbital). For p-doping, strong electron acceptors (p-dopants) are used to remove an electron from the HOMO (highest occupied molecular orbital) of the semiconductor matrix (p-doping), leaving a hole. In other words, for effective p-doping, the LUMO of the dopant must be similar or below the HOMO energy of the matrix. The p-dopant acts as an acceptor for an electron, leaving a moving hole (SOMO) in the matrix. Due to the requirement of such a deep LUMO of the p-dopant, only very few materials are suitable for an application as p-dopant.

Known p-dopants for electron donor materials are electron acceptors such as tetracy-anoquione methane (TCNQ), 2,3,5,6-tetrafluorotetracyano-1,4-benzoquinone methane (F4TCNQ), trinaphthylenes (HATNA), metal oxides such as MoOs or WO₃, or radialene compounds as e.g. described in EP 2180029. The acceptor molecules generate so-called holes in the semiconductor matrix materials (hole transport materials) by electron transfer processes, and the conductivity of the semiconductor matrix material (hole transport material) is more or less changed depending on the number and mobility of the holes.

Known as a matrix material with hole transport properties are for example, N,N'-perarylated benzidines such as TPD or N,N',N"-perarylated starburst compounds such as the substance TDATA, or, however, also certain metal phthalocyanines, such as in particular zinc phthalocyanine ZnPc . Such kind of electron acceptor compounds are e.g. described in EP2180029 A1, which regards the use of radialene compounds as doping agents for an organic semiconductive matrix material.

However, the compounds or compound classes described above have disadvantages for technical use in the production of doped semiconductors or corresponding electronic components with such doped layers as they have too high absorption coefficients, are too volatile, exhibit an unstable evaporation rate, have a too low electron affinity and/or show low thermostability. A high absorption leads to an unwanted reduction of efficiency in light-emitting components (such as OLEDs) and light-converting components (such as solar cells). High volatility, unstable evaporation behaviour and low thermostability results in undesired irregularities in the performance of the electronic component and reduction of component stability. In addition, some of these substance classes have very high manufacturing costs.

Furthermore, there are new developments in the field of p-dopants, e.g. metal complexes are applied as p-dopants. A very promising class of p-dopants are based on Cerium (IV) complexes as described in EP 4029069 A1 or in EP4305681A1. The continuous development of novel hole transport materials with unprecedented properties also requires the development of novel p-dopants with versatile doping properties.

In addition, in a European patent application with the application number EP 22 20 4731, which is not yet disclosed, several compounds are described.

It is an object of the present invention to overcome the disadvantages of the state of the art, in particular to make new organic compounds available that can be used in particular as doping agent for the doping of organic semiconductors, that can furthermore be more readily handled in the production process and that result in electronic components whose organic semi-conductive materials can be reproducibly manufactured. Furthermore, the present invention is providing a versatile structure class that allows the design of electron acceptor compounds by tethering different types of substituents. In particular, hole transport materials with a wide range of HOMO-levels shall be dopable by the new organic mesomeric compounds.

This object is solved by the independent claims of the present application. Preferred embodiments are disclosed in the subclaims.

### SUMMARY OF THE INVENTION

**A first object of the invention is an electronic component** comprising at least one compound of the formula (I): 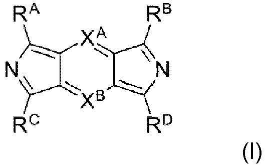
or their radical anions, radical anionic salts, dianions, dianionic salts, or their charge transfer complexes with donors,
in which
X^{A} is selected from C-H, nitrogen (N), C-CF₃ and C-R^{E},
X^{B} is selected from C-H, nitrogen (N), C-CF₃ and C-R^{F}, and
wherein in compounds of formula (I) R^{A}, R^{B}, R^{C}, R^{D}, R^{E}, and R^{F} are independently selected from
C₆-C₁₄-aryl or heteroaryl,
wherein heteroaryl has 4 to 13 carbon atoms,
wherein heteroaryl has 1, 2 or 3 identical or different heteroatoms or heteroatom-containing groups as ring members, selected from N, O, S, SO and SO₂, wherein C₆-C₁₄-aryl and heteroaryl are unsubstituted or substituted by 1, 2, 3, 4 or 5 identical or different radicals R^{G};
wherein R^{G} is selected from CN, F, CF₃, CI, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or
different radicals selected from F, CF₃, CN, C₁-C₄-alkyl and C₁-C₄-haloalkyl, with the proviso that 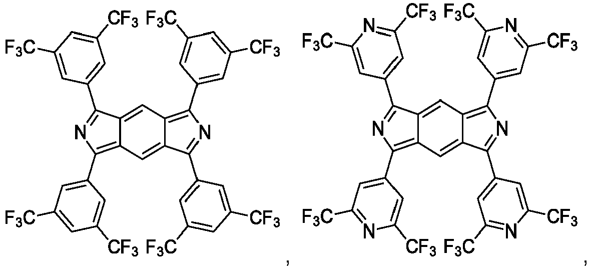 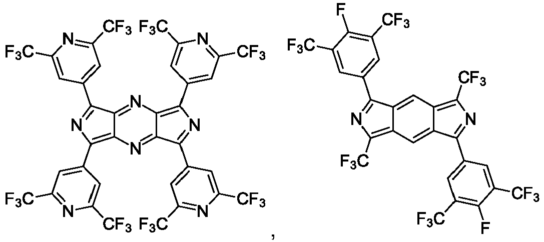 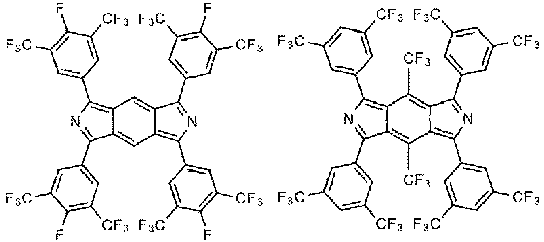
are excluded.

A preferred embodiment is an **electronic component** comprising at least one compound of the formula (I): 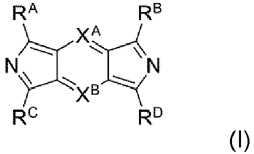
or their radical anions, radical anionic salts, dianions, dianionic salts, salts or their charge transfer complexes with donors,
in which
X^{A} can be chosen from C-H, nitrogen (N), C-CF₃, C-F, and C-R^{E},
X^{B} can be chosen from C-H, nitrogen (N), C-CF₃ and C-R^{F}, and
wherein in compounds of formula (I) each of R^{A}, R^{B}, R^{C}, and R^{D} can be independently selected from one of
   the formulas (11.1) - (II.46): 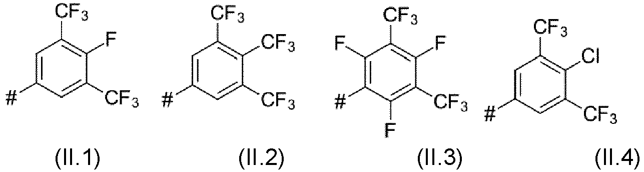 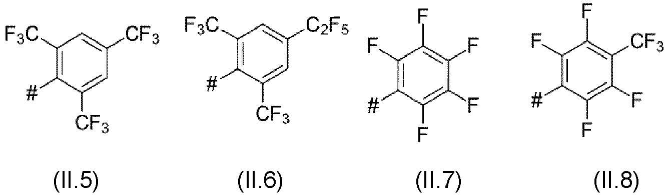 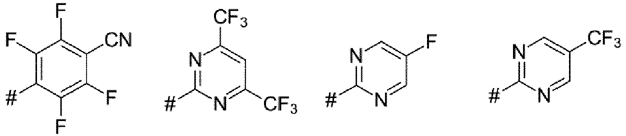 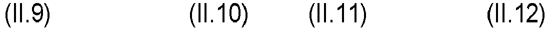 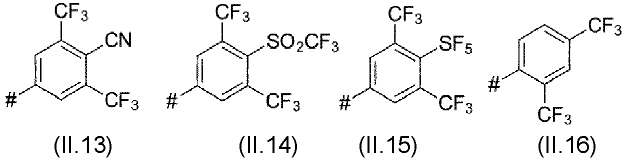 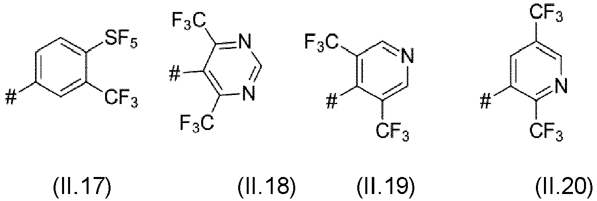 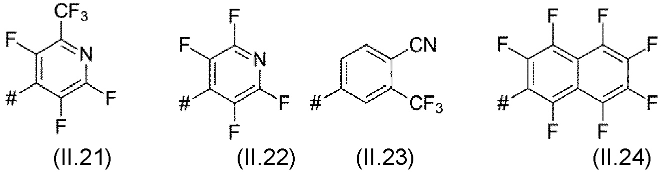 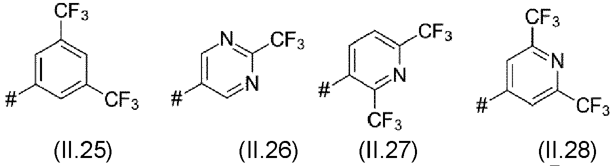 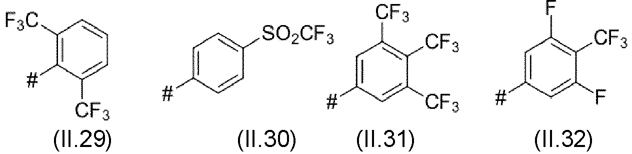 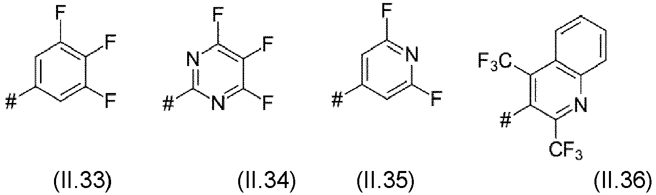 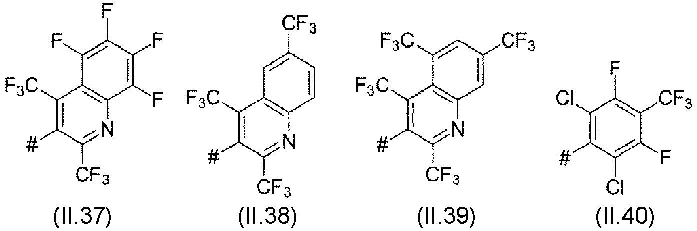 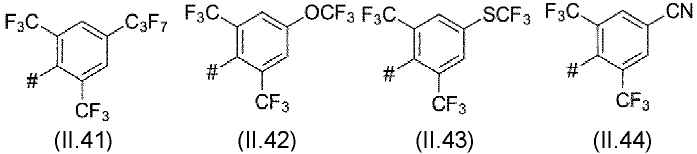 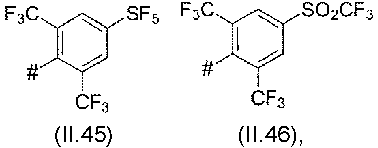
wherein in compounds of formula (I) each of R^{E} and R^{F} can be independently selected from one of
   the formulas (11.1) - (II.46): 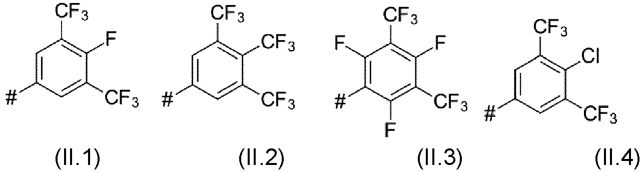 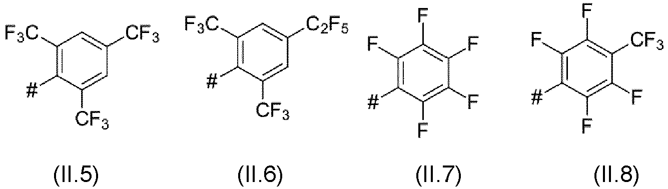 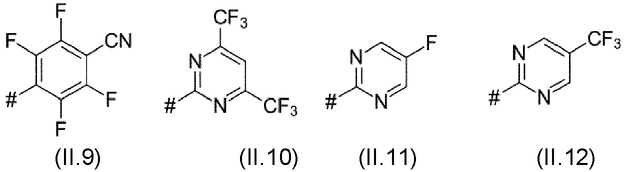 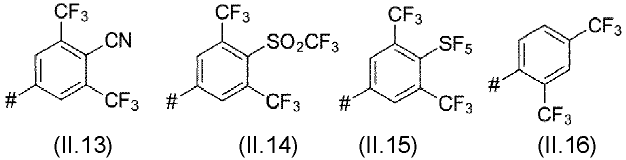 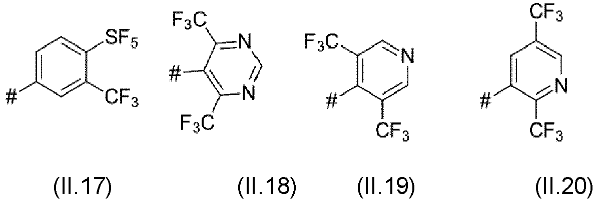 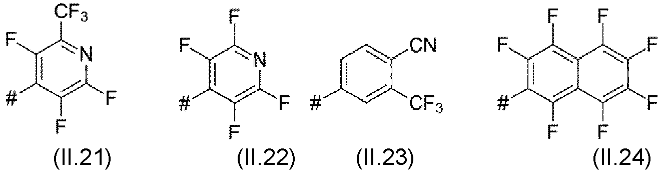 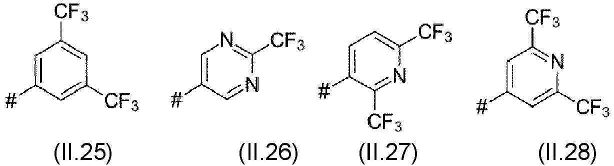 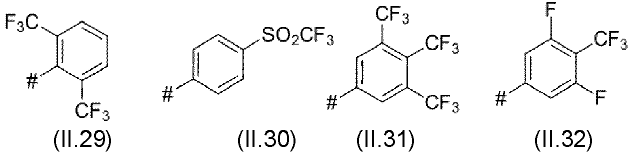 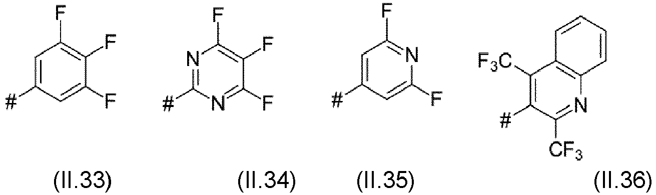 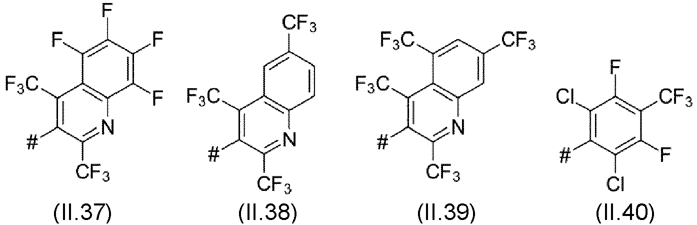 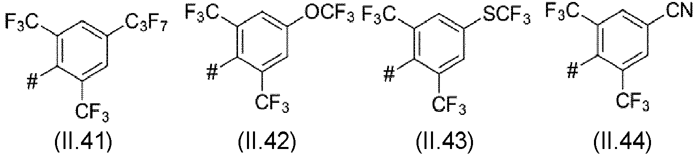 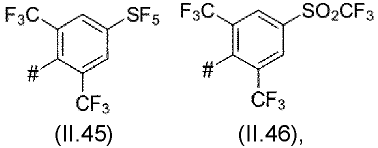
where # denotes the bond to the remaining molecule of formula (I), with the proviso that 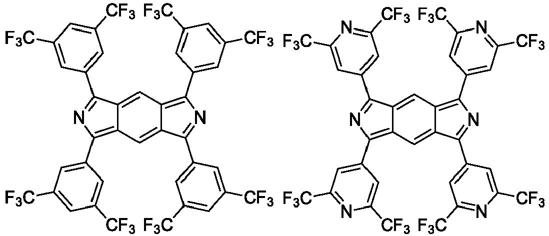 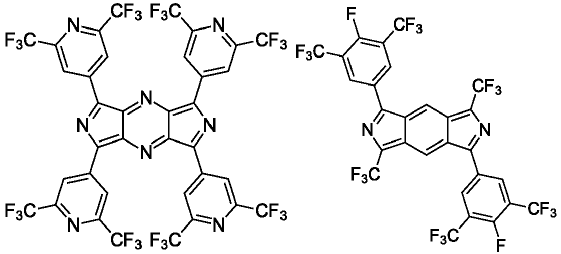 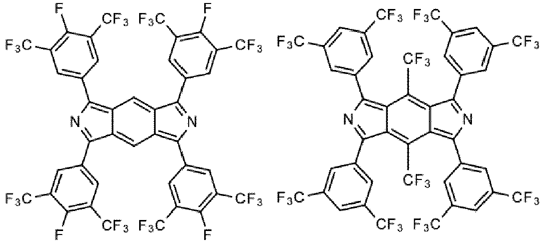
are excluded.

Another embodiment of the invention is the electronic component according to the invention in the form of an organic light-emitting diode, a photovoltaic cell, an organic solar cell, an organic diode, an organic sensor, an organic field effect transistor or an organic battery.

**A further object of the invention is a** compound of the formula (I): 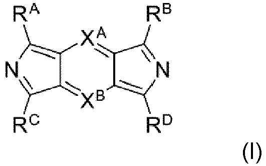
or their radical anions, radical anionic salts, dianions, dianionic salts, or their charge transfer complexes with donors,
in which
X^{A} is selected from C-H, nitrogen (N), C-CF₃ and C-R^{E},
X^{B} is selected from C-H, nitrogen (N), C-CF₃ and C-R^{F}, and
wherein in compounds of formula (I) R^{A}, R^{B}, R^{C}, R^{D}, R^{E}, and R^{F} are independently selected from C₆-C₁₄-aryl or heteroaryl,
wherein heteroaryl has 4 to 13 carbon atoms,
wherein heteroaryl has 1, 2 or 3 identical or different heteroatoms or heteroatom-containing groups as ring members, selected from N, O, S, SO and SO₂,
wherein C₆-C₁₄-aryl and heteroaryl are unsubstituted or substituted by 1, 2, 3, 4 or 5 identical or different radicals R^{G};
wherein R^{G} is selected from CN, F, CF₃, CI, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or different radicals selected from F, CF₃, CN, C₁-C₄-alkyl and C₁-C₄-haloalkyl, with the proviso that 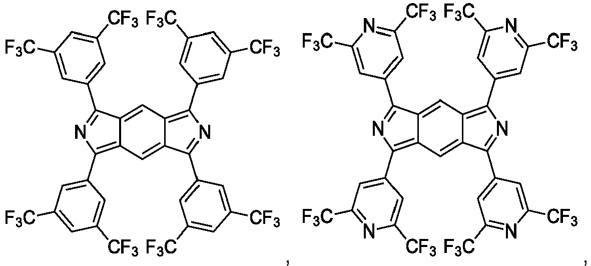 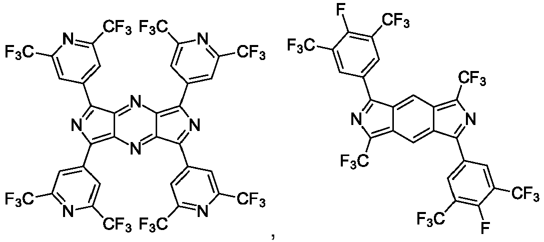 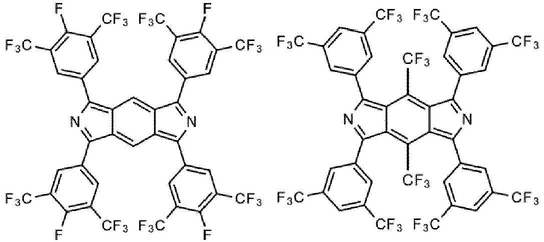
are excluded.

A preferred embodiment is a compound of the formula (I): 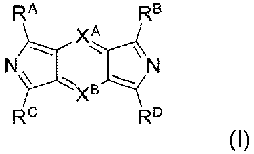
or their radical anions, radical anionic salts, dianions, dianionic salts, salts or their charge transfer complexes with donors,
in which
X^{A} can be chosen from C-H, nitrogen (N), C-CF₃, C-F, and C-R^{E},
X^{B} can be chosen from C-H, nitrogen (N), C-CF₃ and C-R^{F}, and
wherein in compounds of formula (I) each of R^{A}, R^{B}, R^{C}, R^{D}, R^{E}, and R^{F} can be independently selected from one of the formulas (11.1) - (11.46): 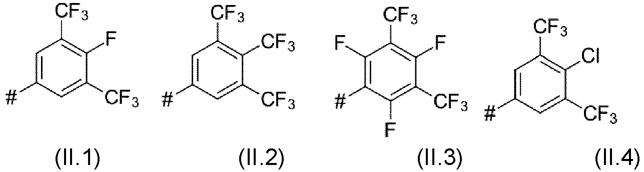 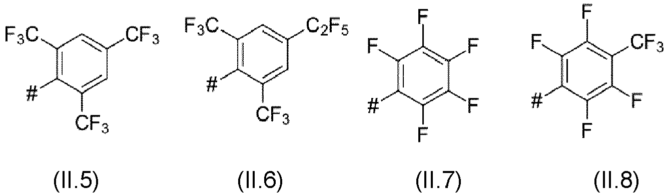 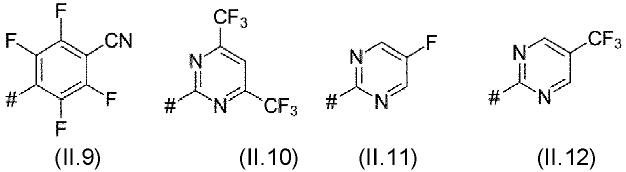 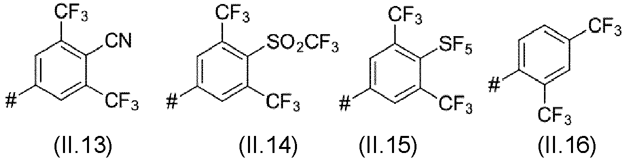 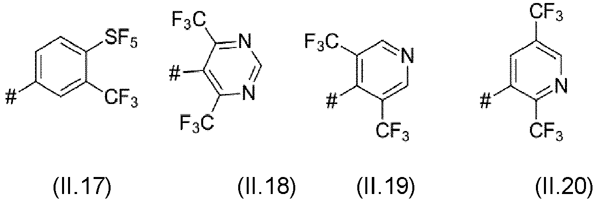 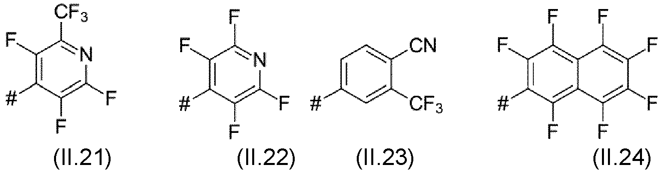 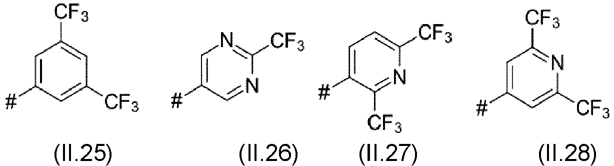 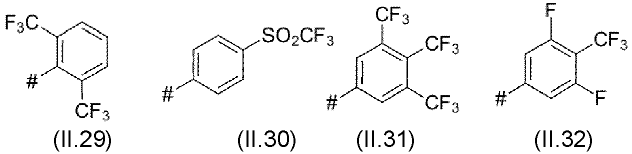 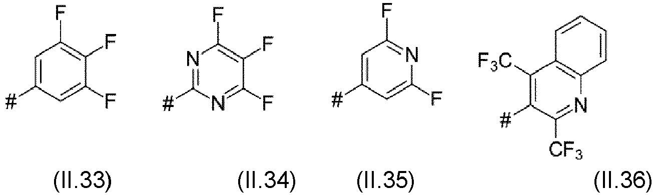 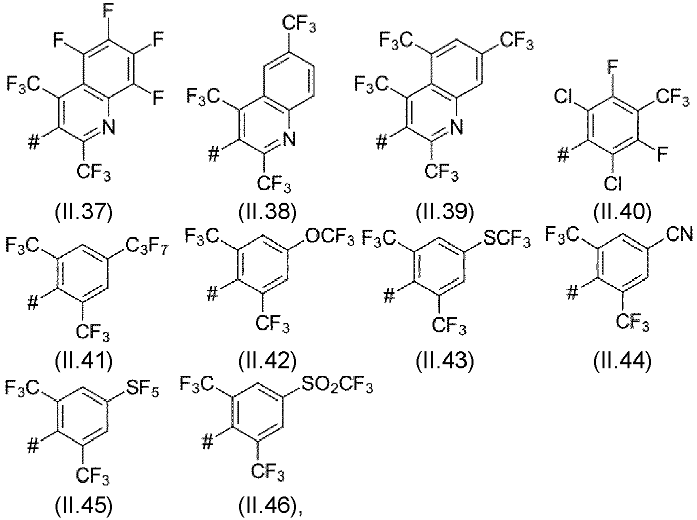
where # denotes the bond to the remaining molecule of formula (I), with the proviso that 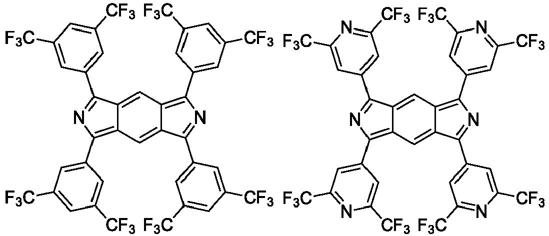 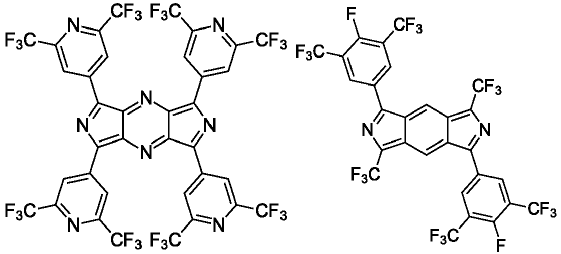 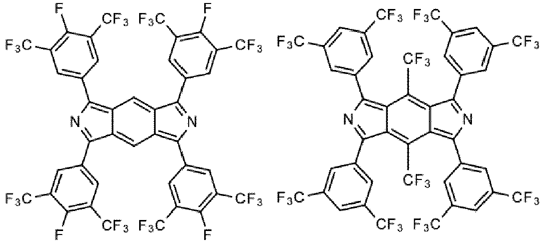
are excluded.

A further object of the invention is a **doped semiconductor layer** comprising at least one electron donor and at least one doping agent, wherein the doping agent is a compound of the formula (I) according to the invention. In a preferred embodiment, the electron donor is a triaryl amine-based compound, comprising at least one or more nitrogen atoms exhaustively substituted by aromatic moieties. The doping agent is preferably a compound of formulae (I), in particular compounds of formulae (1.1), (1.2), (1.3), (I.4), (1.5), (I.6), and (1.7),
preferably compounds of formulae (I.1.01), (I.1.02), (I.1.03), (I.1.04), (I.1.05), (I.1.06), (I.1.07), (I.1.08), (I.1.09), (I.1.10), (I.1.11), (I.1.12), (I.1.13), (I.1.14), (I.1.15), (I.1.16), (I.1.17), (I.1.18), (I.1.19), (I.1.20), (I.1.21), (I.1.22), (I.1.23), (I.1.24), (I.1.25), (I.1.26), (I.1.27), (I.1.28), (I.1.29), (I.1.30), (I.1.31), (I.1.32), (I.1.33), (I.1.34), (I.1.35), (I.1.36), (I.1.37), (I.1.38), (I.1.39), and (1.1.40) as defined herein and/or (I.2.01), (I.2.02), (I.2.03), (I.2.04), (I.2.05), (I.2.06), (I.2.07), (I.2.08), (I.2.09), (I.2.10), (I.2.11), (I.2.12), (I.2.13), (I.2.14), (I.2.15), (I.2.16), (I.2.17), (I.2.18), (I.2.19), (I.2.20), (I.2.21), (I.2.22), (I.2.23), (I.2.24), (I.2.25), (I.2.26), (I.2.27), (I.2.28), (I.2.29), (I.2.30), (I.2.31), (I.2.32), (I.2.33), (I.2.34), (I.2.35), (I.2.36), (I.2.37), (I.2.38), (I.2.39), (I.2.40), and (1.2.41) as defined herein and/or
(I.3.01), (I.3.02), (I.3.03), (I.3.04), (I.3.05), (I.3.06), (I.3.07), (I.3.08), (I.3.09), (I.3.10), (I.3.11), (I.3.12), (I.3.13), (I.3.14), (I.3.15), (I.3.16), (I.3.17), (I.3.18), (I.3.19), (I.3.20),
(1.3.21), (1.3.22), (1.3.23), (1.3.24), (1.3.25), (1.3.26), (1.3.27), (1.3.28), (1.3.29), (1.3.30), (1.3.31), (1.3.32), (1.3.33), (1.3.34), (1.3.35), (1.3.36), (1.3.37), (1.3.38), (1.3.39), (1.3.40), and (1.3.41) as defined herein and/or
(1.4.01), (I.4.02), (I.4.03), (1.4.04), (I.4.05), (I.4.06), (I.4.07), (I.4.08), (1.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (I.4.23), (I.4.24), (I.4.25), (I.4.26), (I.4.27), (I.4.28), (I.4.29), (I.4.30), (1.4.31), (1.4.32), (1.4.33), (I.4.34), (I.4.35), (I.4.36), (I.4.37), and (1.4.38) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), (1.5.28), (1.5.29), (1.5.30), (1.5.31), (1.5.32), (1.5.33), (1.5.34), (1.5.35), (1.5.36), (1.5.37), (1.5.38), (1.5.39), (1.5.40), and (1.5.41) as defined herein and/or
(1.6.01), (1.6.02), (I.6.03), (I.6.04), (1.6.05), (I.6.06), (I.6.07), (I.6.08), (I.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), (I.6.28), (I.6.29), (I.6.30), (1.6.31), (1.6.32), (I.6.33), (I.6.34), (I.6.35), (I.6.36), (I.6.37), (I.6.38), (I.6.39), and (I.6.40) as defined herein and/or
(1.7.01), (1.7.02), (1.7.03), (1.7.04), (1.7.05), (1.7.06), (1.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), (1.7.26), (1.7.27), (1.7.28), (1.7.29), (1.7.30), (1.7.31), (1.7.32), (1.7.33), (1.7.34), (1.7.35), (1.7.36), (1.7.37), (1.7.38), (1.7.39), and (1.7.40) as defined herein.

A further object of the invention is a **use** of at least one compound of formula (I), in particular compounds of formulae (1.1), (1.2), (1.3), (1.4), (1.5), (1.6), and (1.7),
preferably compounds of formulae (1.1.01), (1.1.02), (1.1.03), (1.1.04), (1.1.05), (1.1.06), (1.1.07), (1.1.08), (1.1.09), (1.1.10), (1.1.11), (1.1.12), (1.1.13), (1.1.14), (1.1.15), (1.1.16), (1.1.17), (1.1.18), (1.1.19), (1.1.20), (1.1.21), (1.1.22), (1.1.23), (1.1.24), (1.1.25), (1.1.26), (I.1.27), (I.1.28), (I.1.29), (I.1.30), (I.1.31), I.1.32), (I.1.33), (I.1.34), (I.1.35), (I.1.36), (I.1.37), (I.1.38), (I.1.39), and (I.1.40) as defined herein and/or (I.2.01), (I.2.02), (I.2.03), (I.2.04), (I.2.05), (I.2.06), (I.2.07), (I.2.08), (I.2.09), (I.2.10), (I.2.11), I.2.12), (I.2.13), (I.2.14), (I.2.15), (I.2.16), (I.2.17), (I.2.18), (I.2.19), (I.2.20), (I.2.21), (I.2.22), (I.2.23), (I.2.24), (I.2.25), (I.2.26), (I.2.27), (I.2.28), (I.2.29), (I.2.30), (I.2.31), (I.2.32), (I.2.33), (I.2.34), (I.2.35), (I.2.36), (I.2.37), (I.2.38), (I.2.39), (I.2.40), and (1.2.41) as defined herein and/or
(I.3.01), (I.3.02), (I.3.03), (I.3.04), (I.3.05), (I.3.06), (I.3.07), (I.3.08), (I.3.09), (I.3.10), (I.3.11), (1.3.12), (1.3.13), (1.3.14), (1.3.15), (1.3.16), (1.3.17), (1.3.18), (1.3.19), (1.3.20), (1.3.21), (1.3.22), (1.3.23), (1.3.24), (1.3.25), (1.3.26), (1.3.27), (1.3.28), (1.3.29), (1.3.30), (1.3.31), (1.3.32), (1.3.33), (1.3.34), (1.3.35), (1.3.36), (1.3.37), (1.3.38), (1.3.39), (1.3.40), and (1.3.41) as defined herein and/or
(1.4.01), (1.4.02), (1.4.03), (I.4.04), (I.4.05), (I.4.06), (I.4.07), (1.4.08), (I.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (I.4.23), (I.4.24), (I.4.25), (I.4.26), (1.4.27), (I.4.28), (I.4.29), (I.4.30), (1.4.31), (1.4.32), (I.4.33), (I.4.34), (I.4.35), (I.4.36), (1.4.37), and (I.4.38) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), (1.5.28), (1.5.29), (1.5.30), (1.5.31), (1.5.32), (1.5.33), (1.5.34), (1.5.35), (1.5.36), (1.5.37), (1.5.38), (1.5.39), (1.5.40), and (1.5.41) as defined herein and/or
(1.6.01), (1.6.02), (I.6.03), (I.6.04), (I.6.05), (I.6.06), (1.6.07), (I.6.08), (I.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), (I.6.28), (I.6.29), (I.6.30), (1.6.31), (1.6.32), (I.6.33), (I.6.34), (I.6.35), (I.6.36), (I.6.37), (I.6.38), (I.6.39), and (I.6.40) as defined herein and/or
(1.7.01), (1.7.02), (1.7.03), (1.7.04), (1.7.05), (1.7.06), (1.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), (1.7.26), (1.7.27), (1.7.28), (1.7.29), (1.7.30), (1.7.31), (1.7.32), (1.7.33), (1.7.34), (1.7.35), (1.7.36), (1.7.37), (1.7.38), (1.7.39), and (1.7.40) as defined herein, as organic doping agent for the doping of an organic semiconductive matrix material, as matrix layers, as transport layer, as blocker layer, as hole injection layer, as organic semiconductor itself, organic semiconductive matrix material or as hole transport.

A further object of the invention is the use of an electronic component as defined herein as organic semiconductor,
- as a redox doping agent in organic semiconductor layers, as p-dopant in hole transport layers,
- as a charge injector in a charge injection layer,
- as a charge extractor in a charge extraction layer,
- as a sublayer of a pn-junction, especially as a sublayer of a charge-generation layer or a charge conversion layer
- as an acceptor compound in charge-transfer complexes, or
- as a cathode material in organic and redox flow batteries.

A further object of the invention is a **method for the preparation of a doped semiconductor layer,** wherein a hole transport material and a compound of general formula (I) according to the invention is used. The method comprises at least one of the following steps:
(a) Simultaneous evaporation of the hole transport material and the compound of formula (I).
(b) Evaporation of a pre-mixed material containing the hole transport material and at least one compound of general formula (I) from one single source.
(c) Sequential deposition of the hole transport material and at least one compound of general formula (I).
(d) Doping of a hole transport (HT) layer by a solution containing at least one compound of general formula (I) followed by evaporation of the solvent by thermal treatment.
(e) Surface doping of a layer of a hole transport material by a layer of at least one compound of general formula (I) applied to one or both surfaces of the layer of a hole transport material.
(f) Preparing a solution of a hole transport material and at least one compound of general formula (I) and forming a film from the solution.

### DESCRIPTION OF THE INVENTION

The invention has the following advantages:
- The compounds of formula (I) have only low production costs.
- The compounds of formula (I) have a wide application range due to their antiaromatic nature, in particular the compounds of formula (I) can be used for a p-side application in organic electronic devices
- The compounds of formula (I) are advantageously suitable as electron acceptors for use as p-dopants and as electron transport materials in organic-electronic components.- The compounds of formula (I) according to the invention lead to a better conductivity of the semiconductor layers as compared to known electron acceptors.
- Furthermore, the compounds of formula (I) are characterized by a higher doping efficiency and can accept up to two electrons per molecule.
- Doped layers comprising a matrix material and a compound of formula (I) show only a low absorption, in particular in the visible range and in near-infrared.

Therefore, parasitic absorption and emission can be reduced or even prevented.
- The compounds of formula (I) show good evaporation behavior in high vacuum during processing.
- The compounds of formula (I) are suitable for the production of organic and hybrid opto-electronic components, both by means of solvent processing and by vacuum reprocessing.
- Due to their antiaromatic nature, the compounds of formula (I) provide two electron acceptors, i.e. the compounds tend to accept two electrons in order to reach an aromatic state. Accordingly, the resulting compounds formed in the vicinity of electron donors are bisanions or dianions.
   Advantageously, the compounds according to the invention tend to accept more than one electron and therefore show a high doping efficiency.
   In addition, the resulting bisanions or dianions are in an aromatic state and accordingly have a very low absorption, especially in the visible and near-infrared range.

For clarity, the term "indacenes", as used in the sense of the invention, comprises indazenes as well as aza indazenes wherein one, two, three or four carbon atoms are replaced by nitrogen.

The expression "halogen" denotes in each case fluorine, bromine, chlorine or iodine, particularly fluorine, chlorine and bromine.

In the context of the invention, the prefix Cn-Cm indicates the number of carbon atoms that a molecule or residue designated thereby may contain.

In the context of the invention, alkyl refers to unbranched or branched saturated hydrocarbon groups.

In the context of the invention, the expression C1-C4-alkyl refers to unbranched or branched saturated hydrocarbon groups having 1 to 4 carbon atoms. C1-C4-alkyl are e.g. methyl, ethyl, propyl, 1-methylethyl, butyl, 1-methylpropyl or 2-methylpropyl, 1,1-dimethylethyl.

The expression "aryl" comprises in the context of the invention mono- or polynuclear aromatic hydrocarbon radicals with usually 6 to 14, especially preferably 6 to 10 carbon atoms. Examples of aryl are especially phenyl, naphthyl, indenyl, fluorenyl, anthracenyl, phenanthrenyl, naphthacenyl, chrysenyl, pyrenyl, etc. and especially phenyl or naphthyl.

The term heteroaryl (hetaryl) includes mono- and polycyclic (e.g. bicyclic or tricyclic) heteroaromatic radicals having 4 to 13 carbon atoms, wherein hetaryl has 1, 2, 3 or 4 identical or different heteroatoms or heteroatom-containing groups as ring members, selected from N, NR⁷, O, S, SO and SO₂, preferably selected from N, O and S. The hetaryl group may be attached to the remainder of the molecule via a ring carbon or via a ring heteroatom e.g. via a nitrogen. Examples of 5- or 6-membered aromatic heterocyclic rings (also called heteroaromatic rings or hetaryl) are 2-pyrrolyl, 3-pyrrolyl, 3-pyrazolyl, 4-pyrazolyl, 5-pyrazolyl, 2-imidazolyl, 4-imidazolyl, 1,3,4-triazol-2-yl, 2-pyridinyl, 3-pyridinyl, 4-pyridinyl, 3-pyridazinyl, 4-pyridazinyl, 2-pyrimidinyl, 4-pyrimidinyl, 5-pyrimidinyl and 2-pyrazinyl. Examples of 10-membered aromatic heterocyclic rings are 2-quinoliny-, 3-quinolinyl, 1-isoquinolinyl.

The terms radical anions, radical anionic salts, dianions, dianionic salts describe ionic compounds that result from the electron transfer, i.e. reduction, of a non-charged parent compound with one electron in case of radical anions and radical anion salts and two electrons in the case of dianions and dianionic salts.

The term charge transfer complexes describe a supramolecular assembly of an electron donor, for example an hole transport material and an electron acceptor, for example a p-dopant.

The expression "CN" denotes the cyano group (-C=N).

The expression "haloalkyl" refers to partially or fully halogenated alkyl chains. In other words, one or more hydrogen atoms, for example 1, 2, 3, 4 or 5 hydrogen atoms bonded to one or more carbon atoms of alkyl, are replaced by a halogen atom, in particular by fluorine or chlorine.

### Compounds of formula (I)

A preferred embodiment of the invention is an **electronic component** comprising at least one compound of the formula (I): 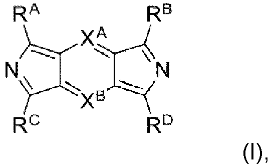
in which
X^{A} is selected from C-H, nitrogen (N), C-CF₃ and C-R^{E},
X^{B} is selected from C-H, nitrogen (N), C-CF₃ and C-R^{F}, and
wherein in compounds of formula (I) R^{A}, R^{B}, R^{C}, and R° are independently selected from
C₆-C₁₄-aryl or heteroaryl,
Wherein heteroaryl has 4 to 13 carbon atoms,
wherein heteroaryl has 1, 2 or 3 identical or different heteroatoms or heteroatom-containing groups as ring members, selected from N, O, S, SO and SO₂, wherein C₆-C₁₄-aryl and heteroaryl are unsubstituted or substituted by 1, 2, 3, 4 or 5 identical or different radicals R^{G};
wherein R^{G} is selected from CN, F, CF₃, CI, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or
different radicals selected from F, CF₃, CN, C₁-C₄-alkyl and C₁-C₄-haloalkyl, wherein, in compounds of formula (I) R^{E}, and R^{F} are independently selected from C6-C14-aryl or heteroaryl,
Wherein heteroaryl has 4 to 13 carbon atoms,
wherein heteroaryl has 1, 2 or 3 identical or different heteroatoms or heteroatom-containing groups as ring members, selected from N, O, S, SO and SO₂, wherein C₆-C₁₄-aryl and heteroaryl are unsubstituted or substituted by 1, 2, 3, 4 or 5 identical or different radicals R^{G};
wherein R^{G} is selected from CN, F, CF₃, CI, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or
different radicals selected from F, CF₃, CN, C₁-C₄-alkyl and C₁-C₄-haloalkyl,
with the proviso that 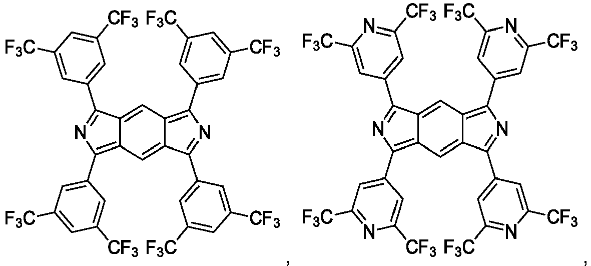 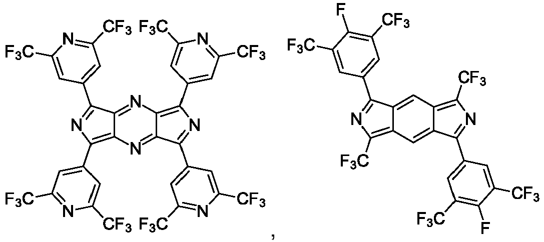 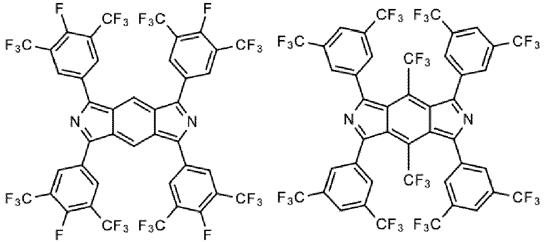
are excluded.

In a preferred embodiment, the invention relates to a compound of the formula (I): 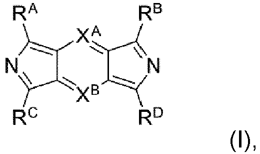
in which
X^{A} can be chosen from C-H, nitrogen (N), C-CF₃ and C-R^{E},
X^{B} can be chosen from C-H, nitrogen (N), C-CF₃ and C-R^{F}, and
wherein in compounds of formula (I) R^{A}, R^{B}, R^{C}, and R^{D} are independently selected from one of
the formulas (11.1) - (11.46): 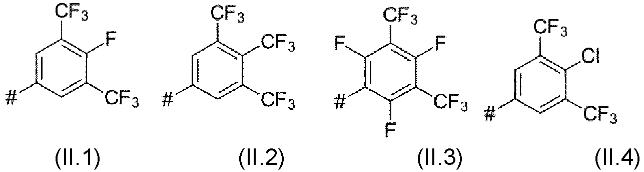 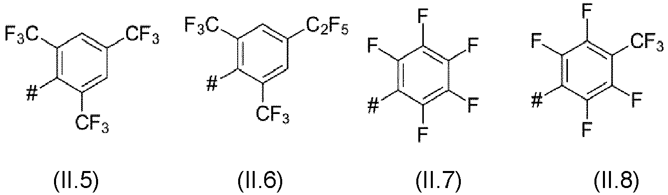 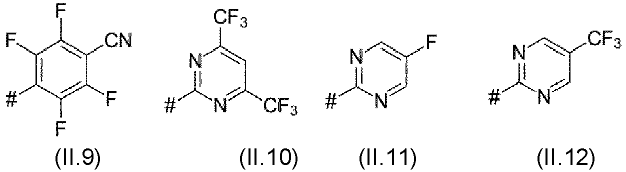 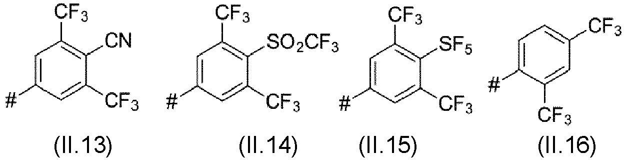 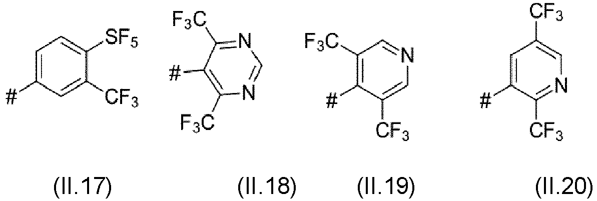 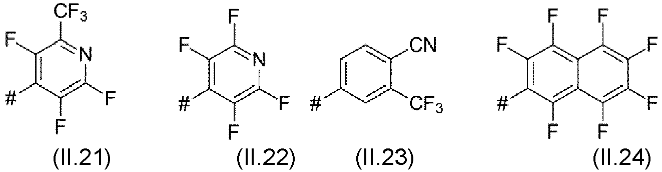 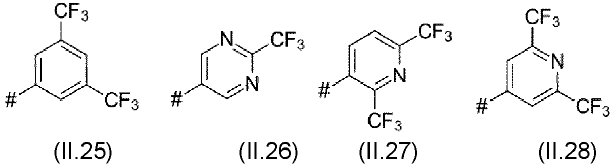 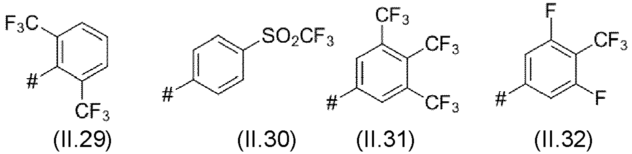 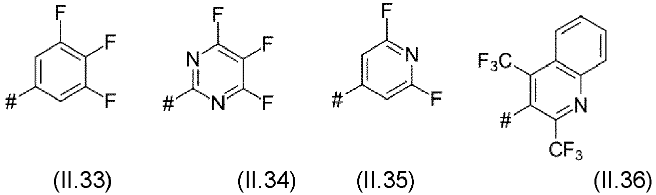 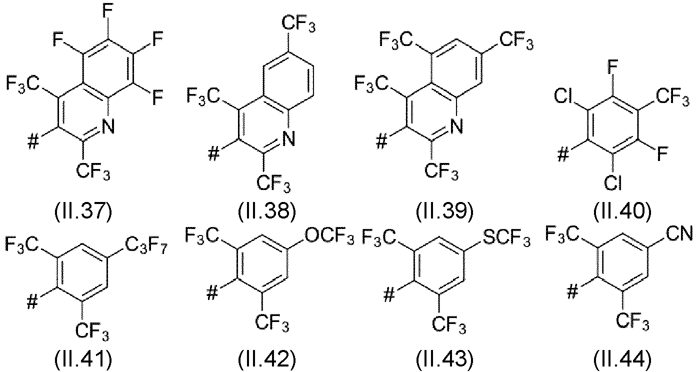 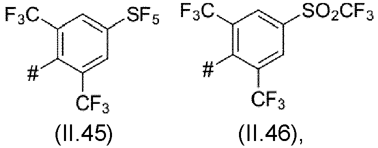 where # denotes the bond to the remaining molecule of formula (I),
wherein in compounds of formula (I) R^{E}, and R^{F} are independently selected from one of the formulas (11.1) - (11.46): 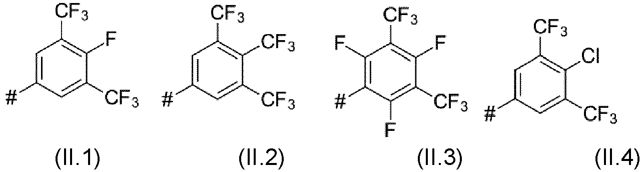 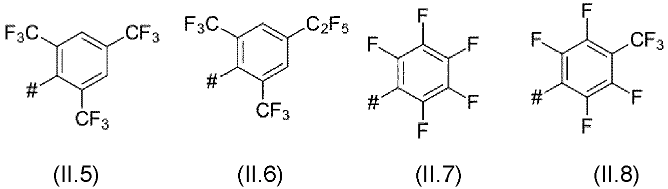 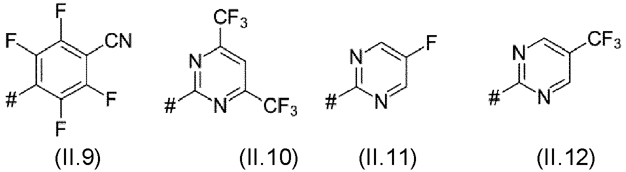 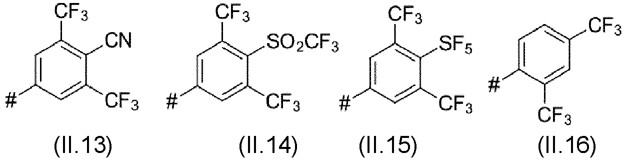 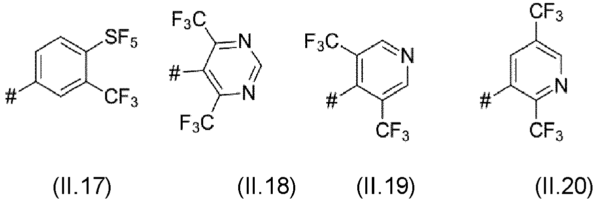 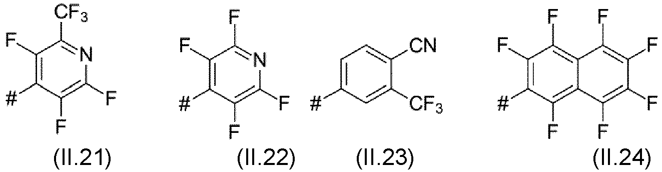 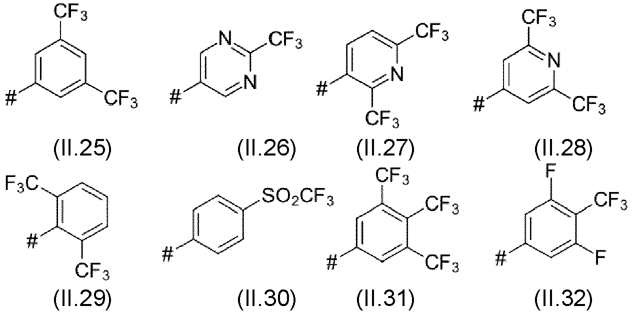 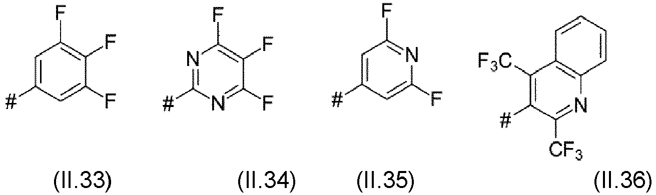 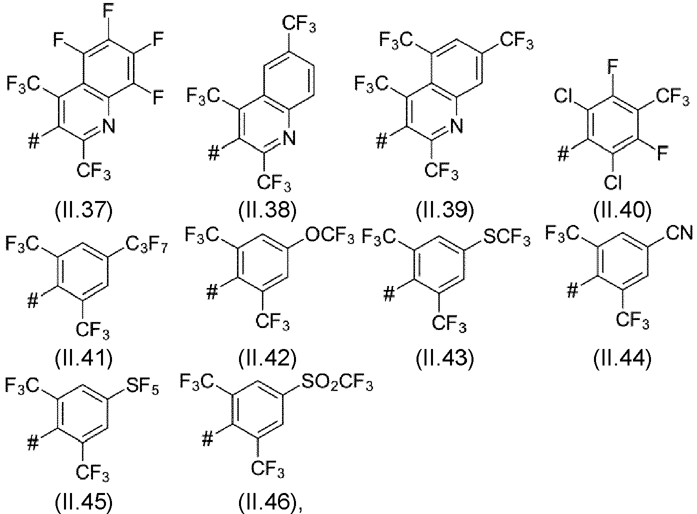
where # denotes the bond to the remaining molecule of formula (I), with the proviso that 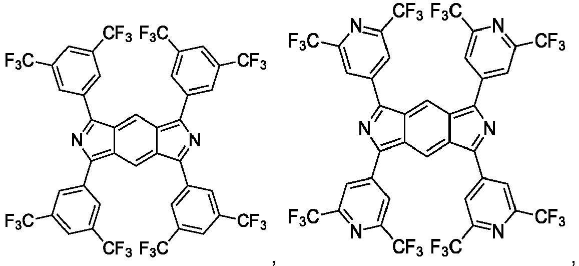 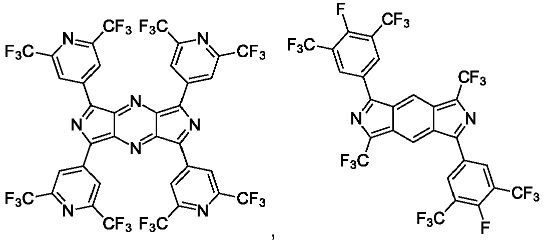 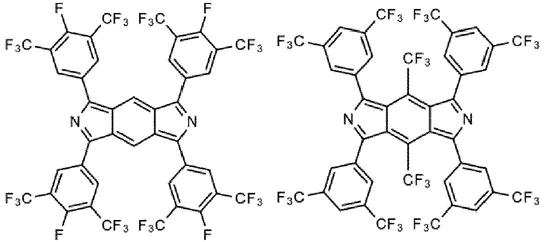
are excluded.

The invention relates to compounds of formula (I), wherein the radical anions X^{A},X^{B}, X^{C}, X^{D}, X^{E}, and X^{F} as one of the meanings as defined above. Further the invention relates to the use of at least one compound of formula (I), in particular compounds of formulae (1.1), (1.2), (1.3), (1.4), (1.5), (1.6), and (1.7) as defined below, or their radical anions, radical anionic salts, dianions, dianionic salts, or their charge transfer complexes with donors, in organic devices.

Preferred are compounds of formula (I), wherein X^{A} and X^{B} are C-H.

In a preferred embodiment of formula (I) X^{A} and X^{B} are C-CF₃.

Preferred are compounds of formula (I), in particular compounds which are selected from compounds of the following formulae (1.1) - (1.7) 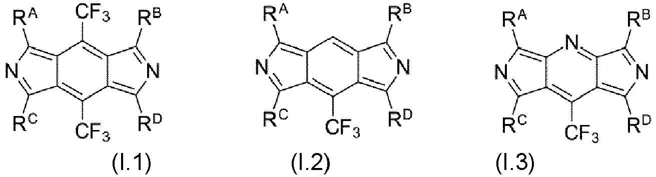 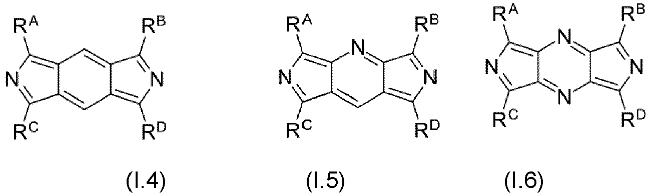 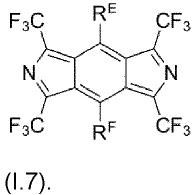
wherein R^{A}, R^{B}, R^{C}, and R^{D} are independently selected from the formulas (11.1) to (11.46) as defined herein,
wherein R^{E} and R^{F} are independently selected from the formulas (11.1) to (11.46) as defined herein.

A preferred embodiment are compounds of formula (I), in particular compounds which are selected from compounds of the following formulae (1.1.01) - (1.1.40):

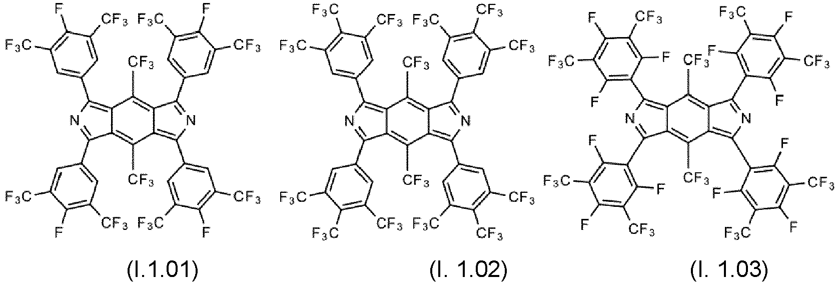

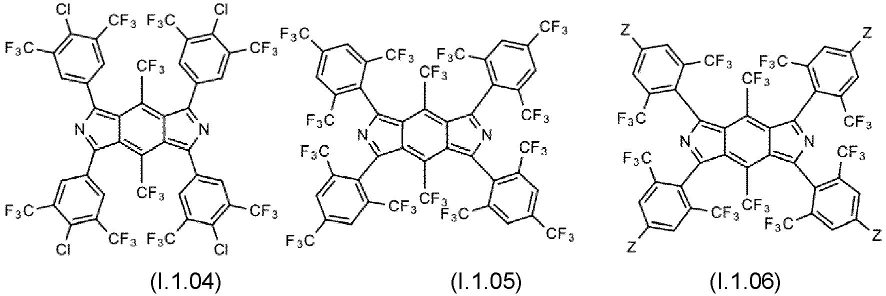

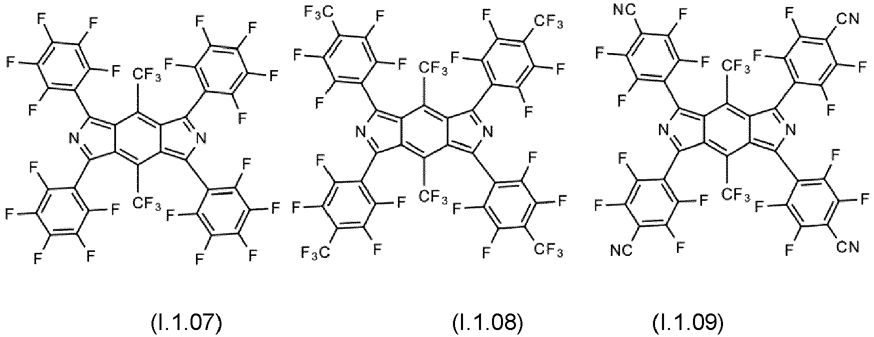

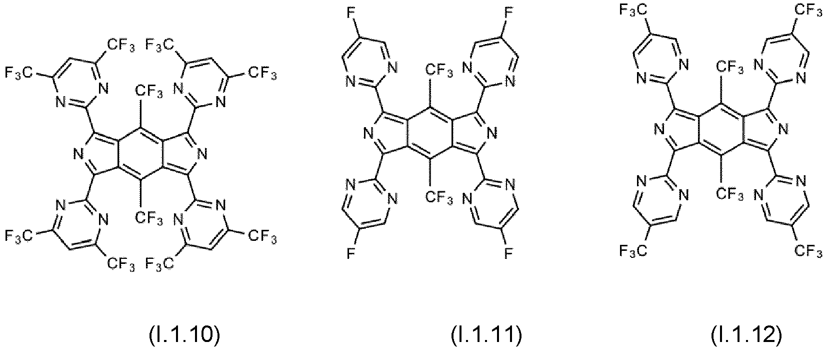

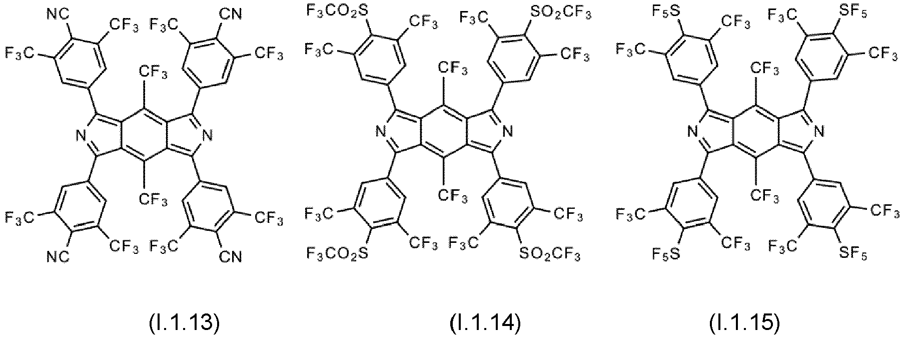

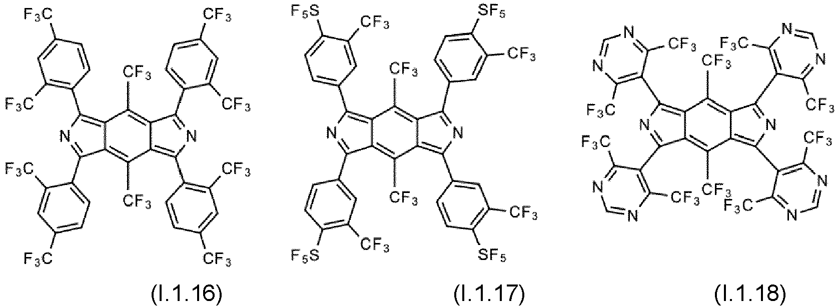

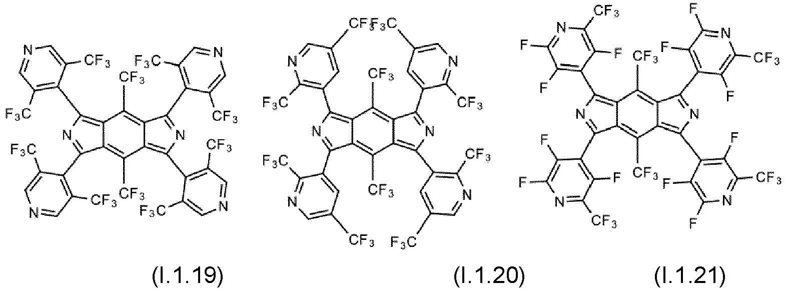

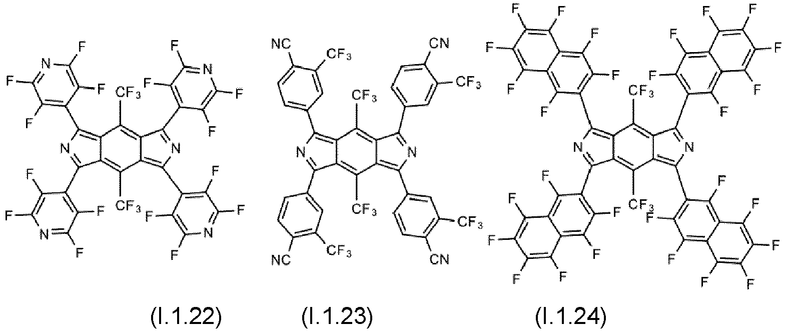

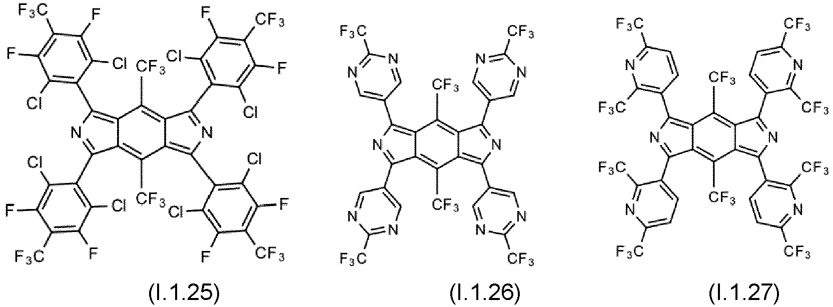

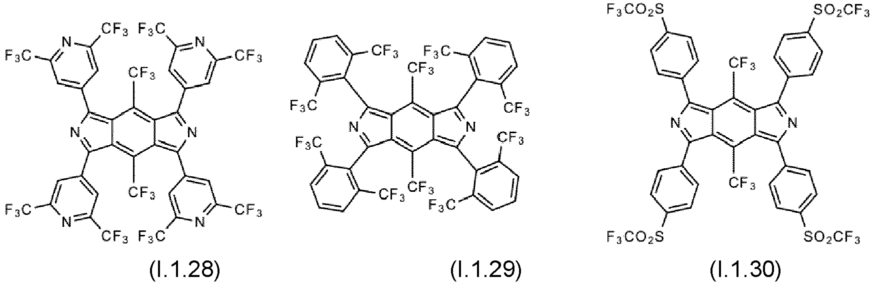

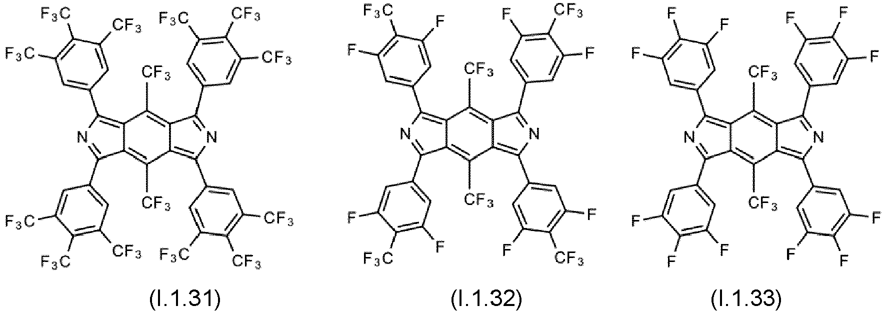

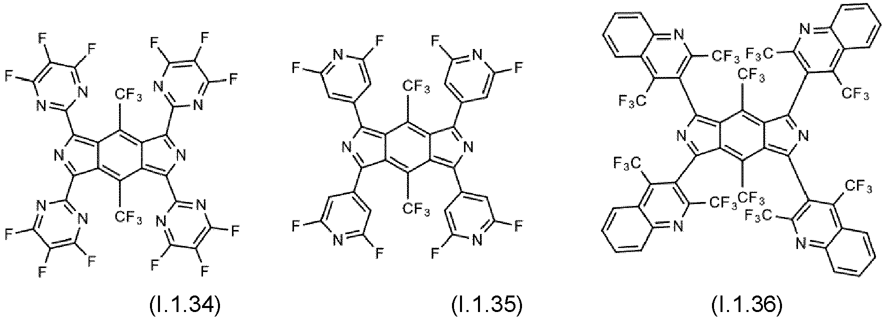

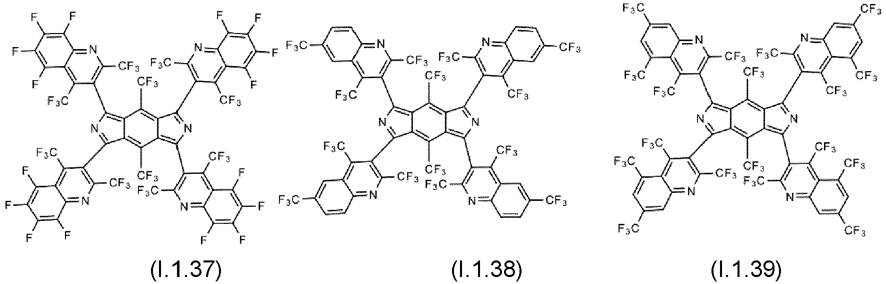

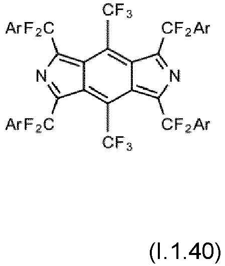

In the context of this invention Ar is selected from one of the formulas (111.1) to (III.20):

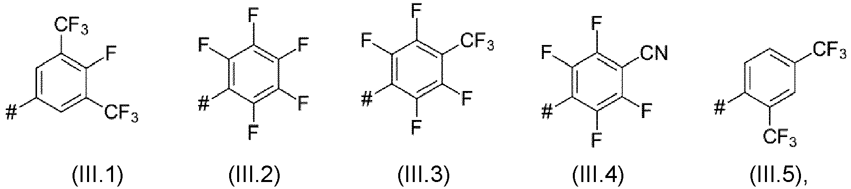

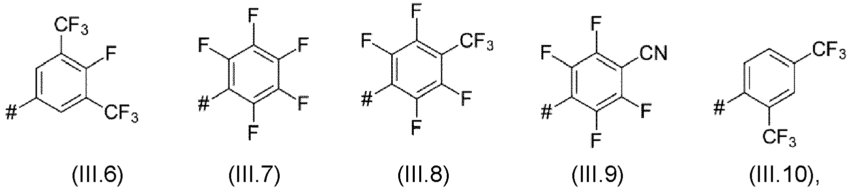

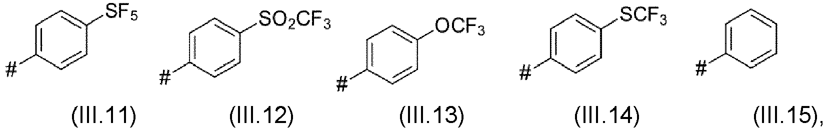

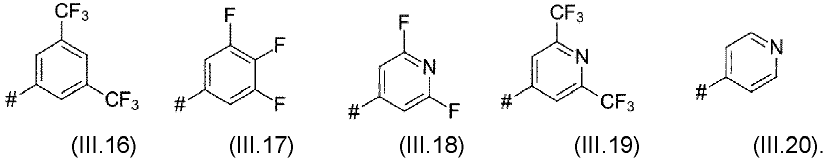

A preferred embodiment are compounds of formula (I), in particular compounds which are selected from compounds of the following formulae (1.2.01) - (1.2.41):

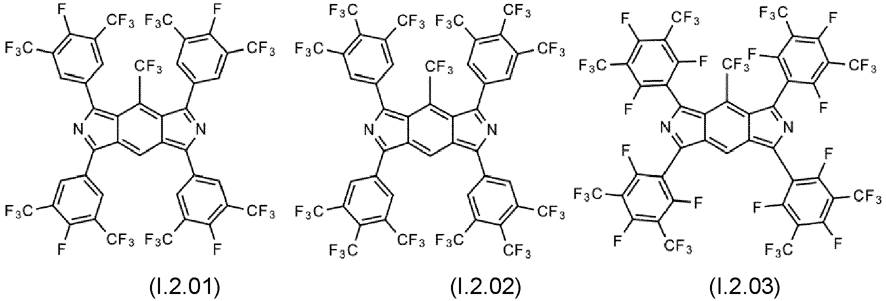

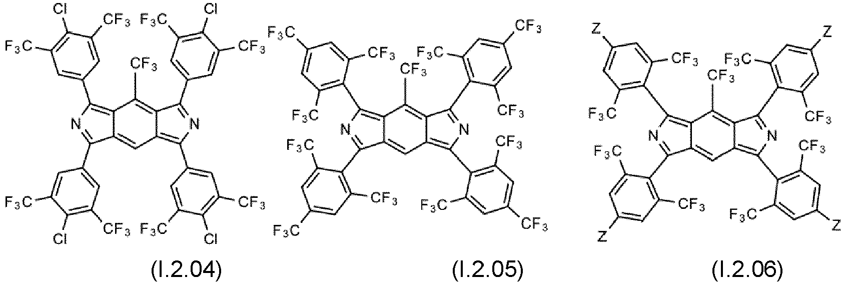

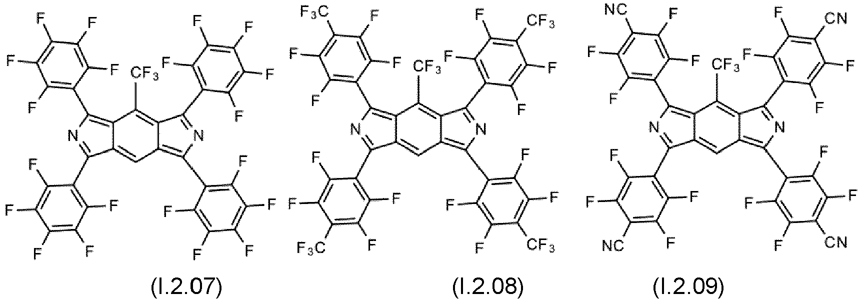

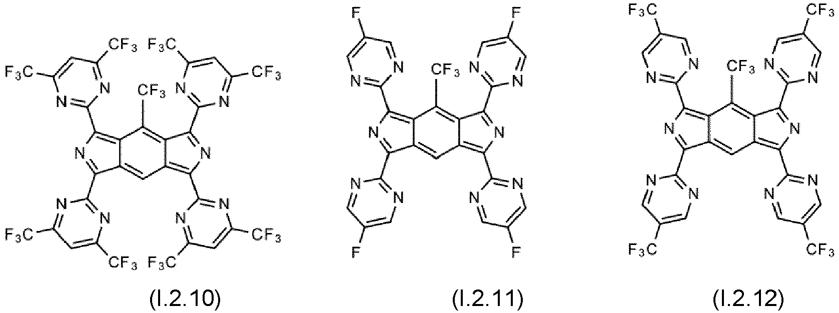

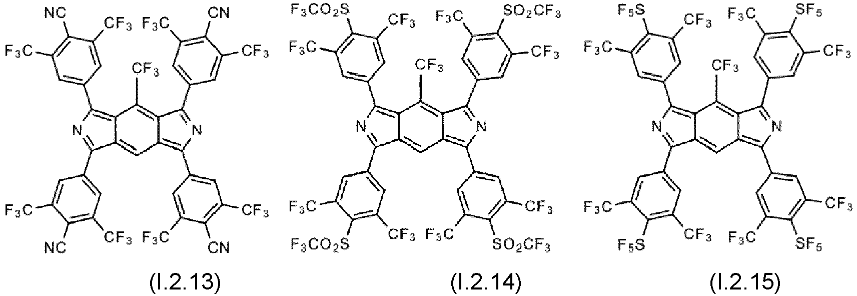

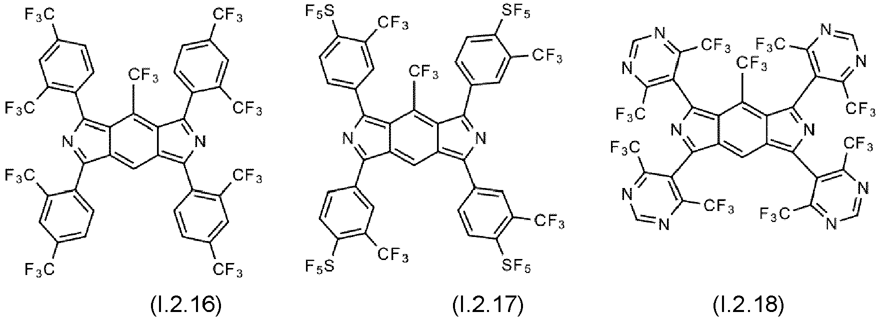

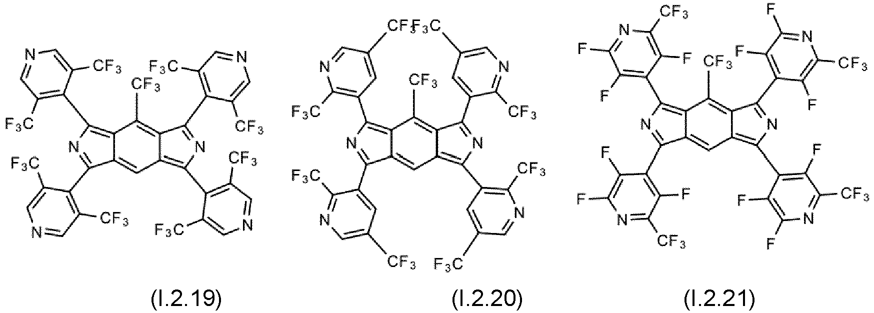

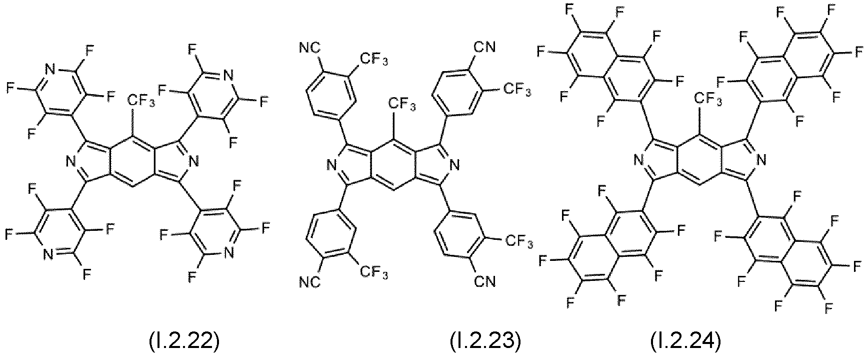

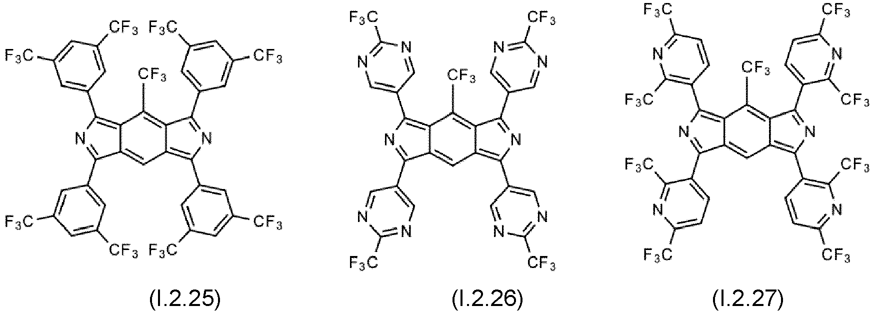

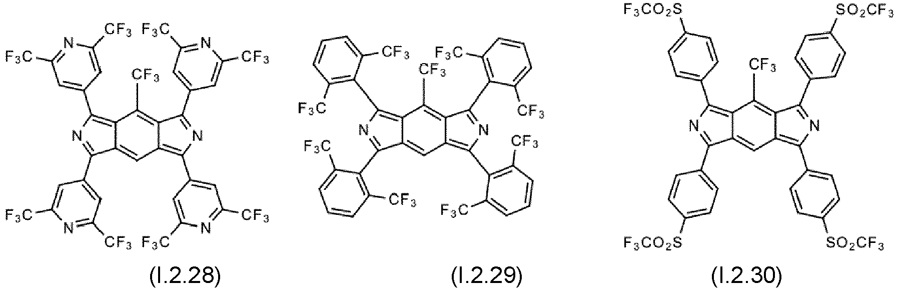

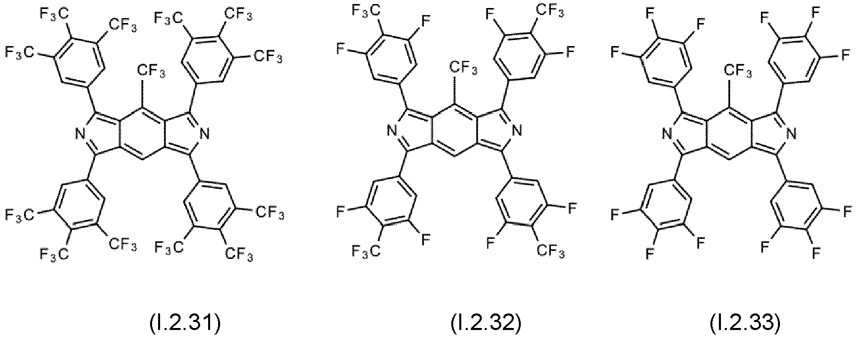

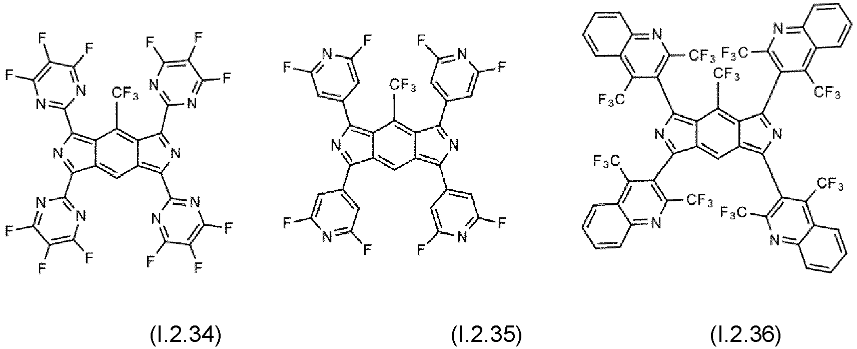

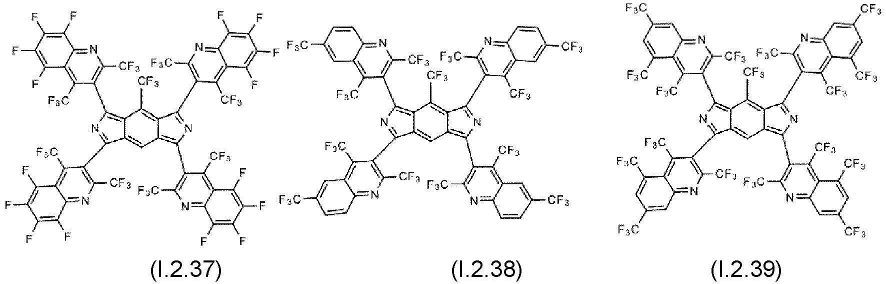

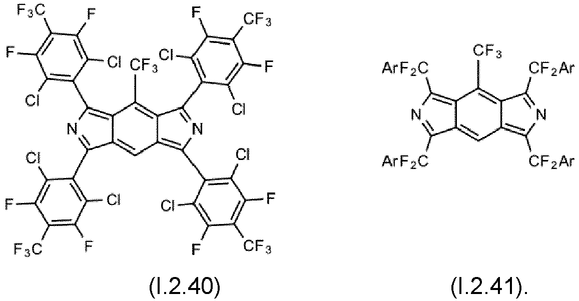

A preferred embodiment are compounds of formula (I), in particular compounds which are selected from compounds of the following formulae (1.3.01) - (1.3.41):

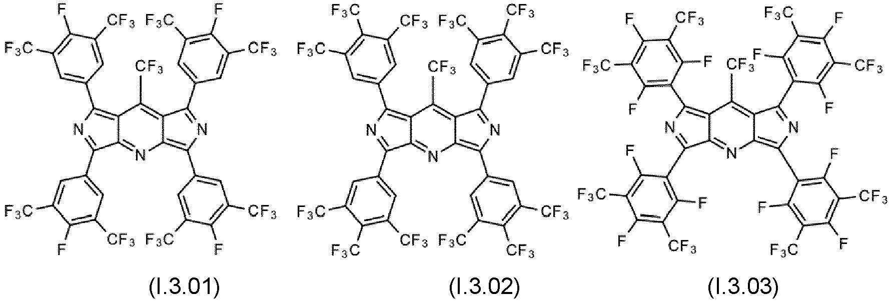

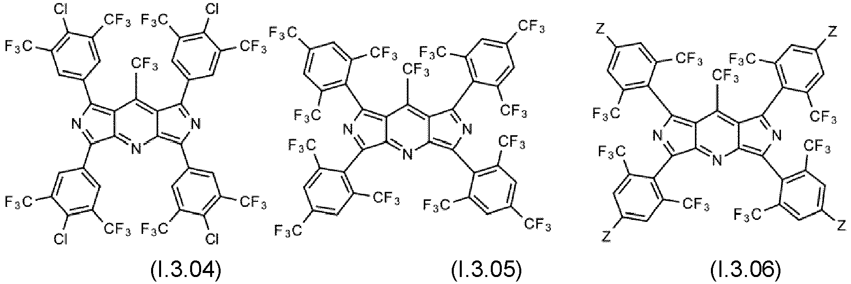

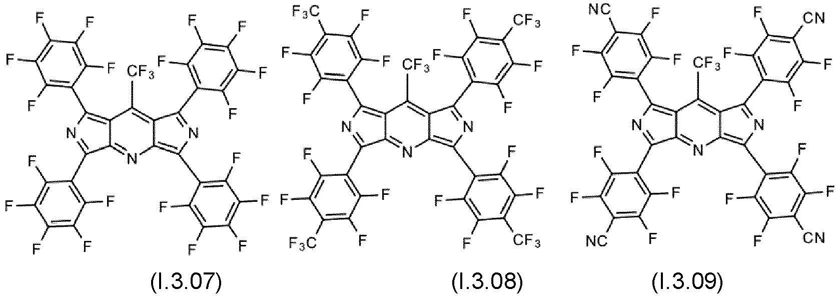

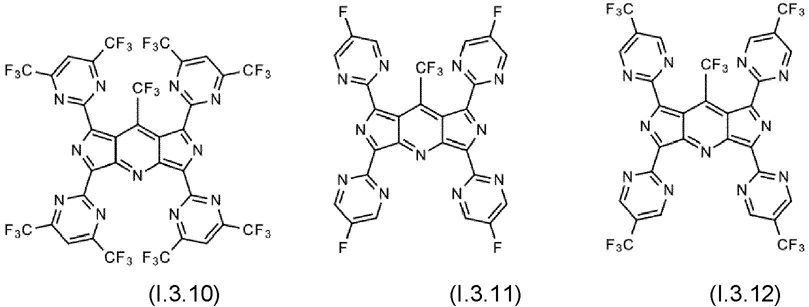

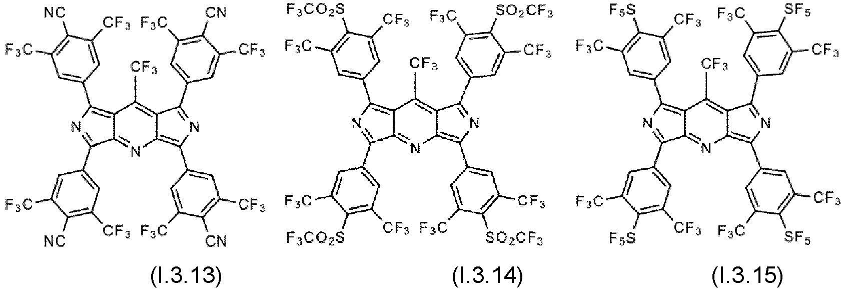

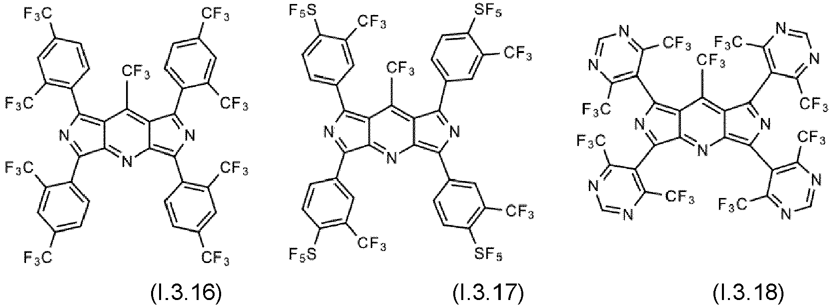

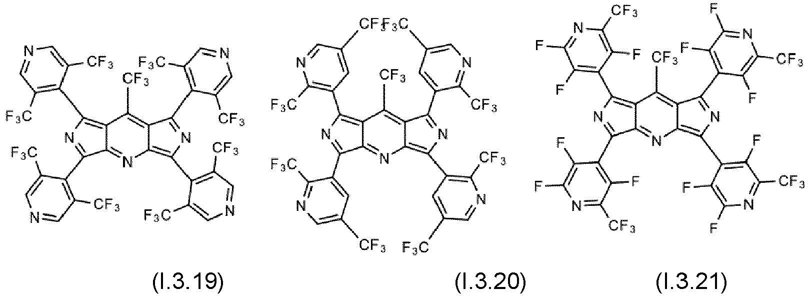

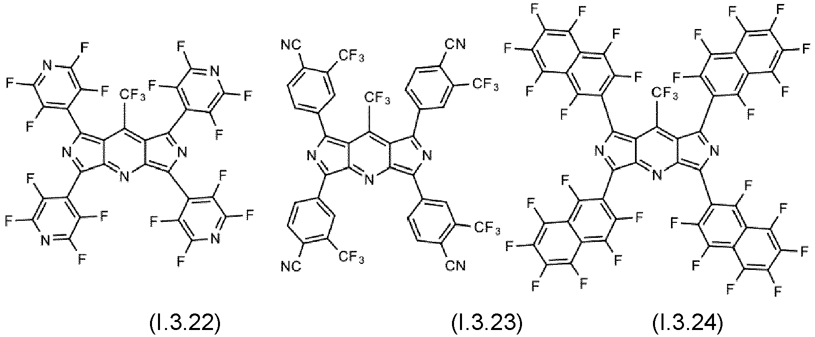

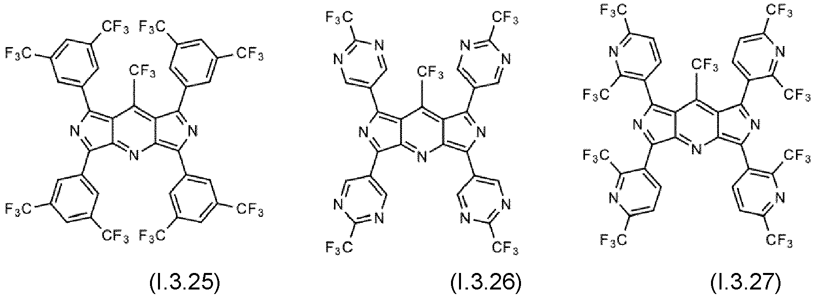

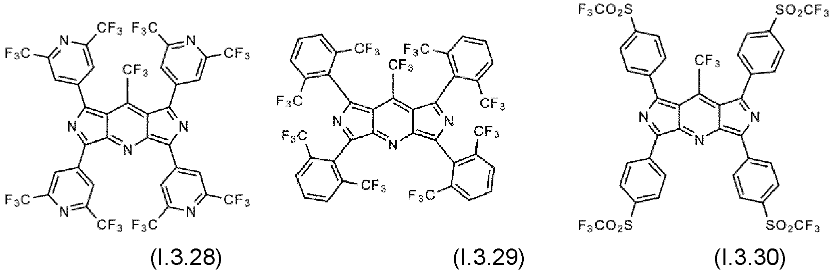

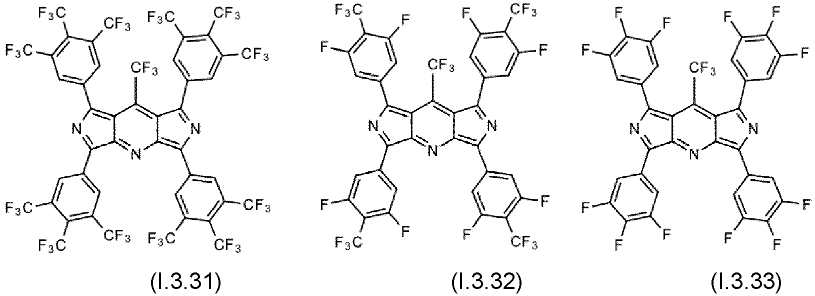

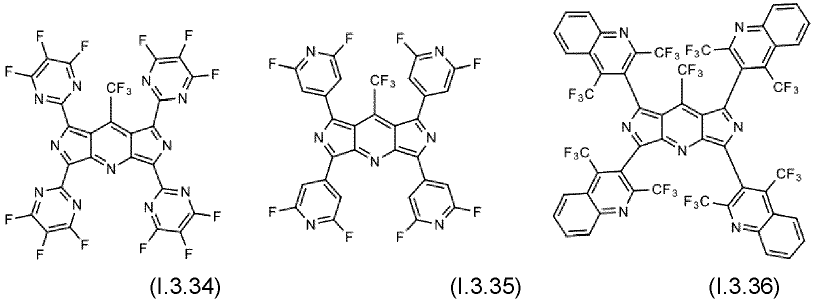

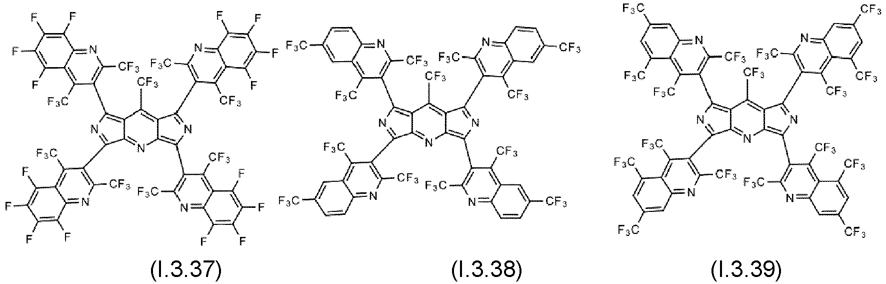

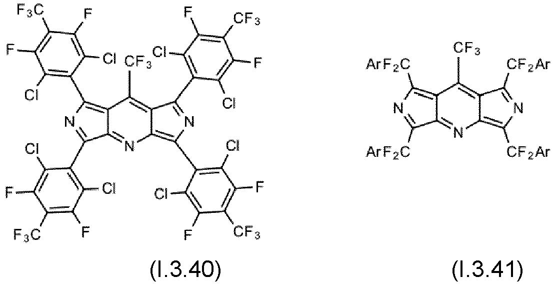

A preferred embodiment are compounds of formula (I), in particular compounds which are selected from compounds of the following formulae (1.4.01) - (1.4.38):

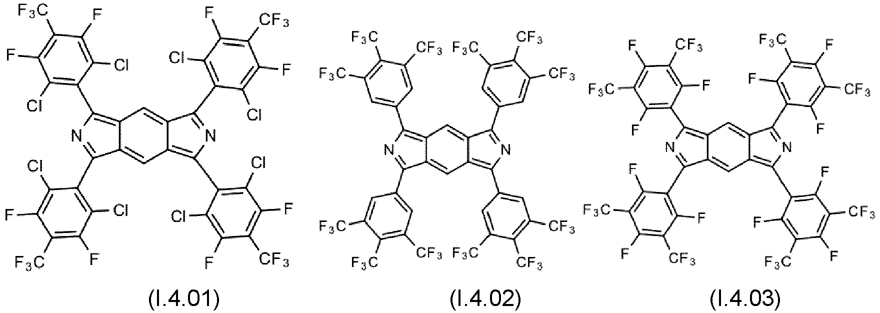

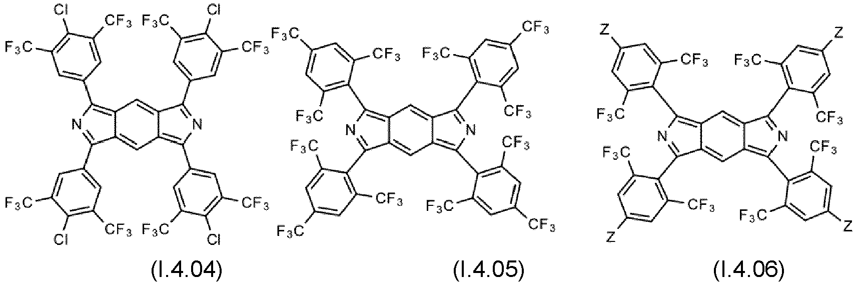

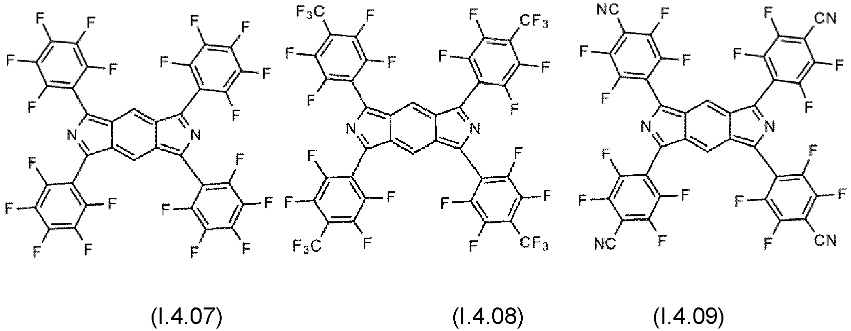

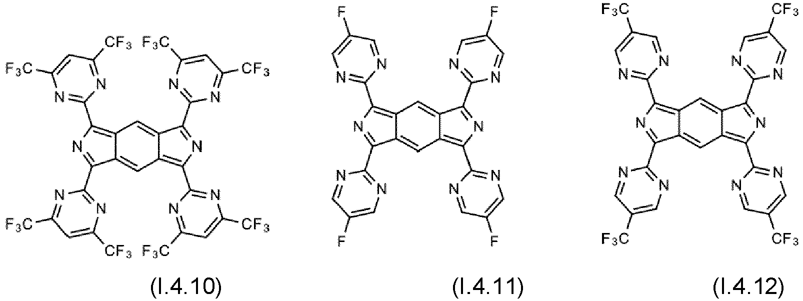

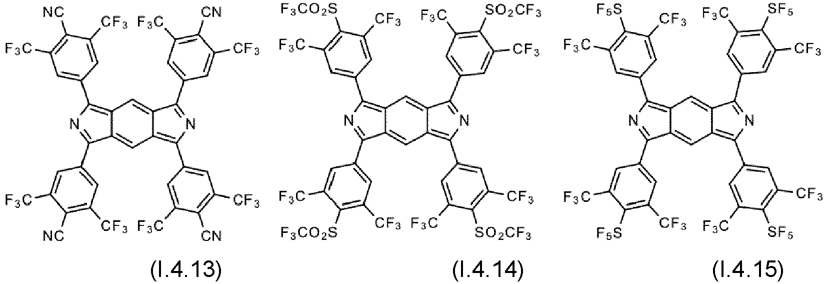

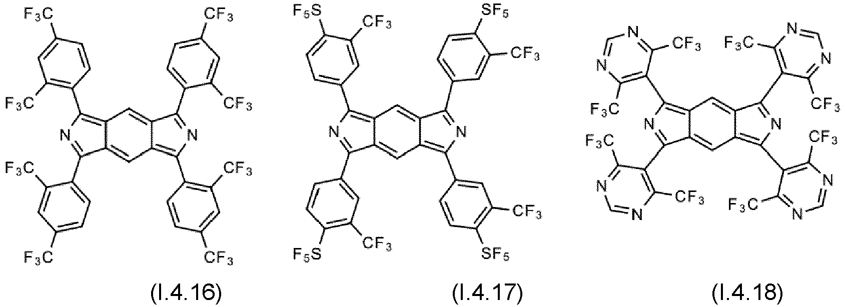

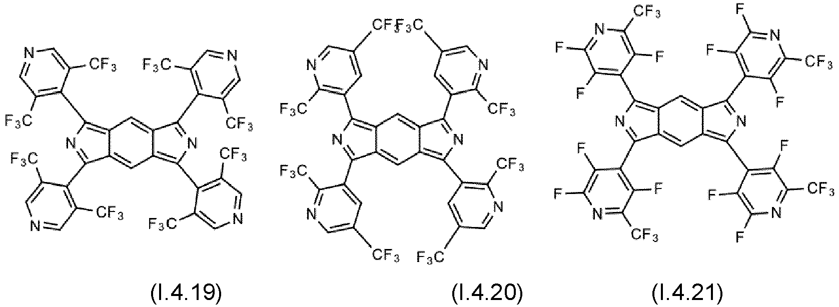

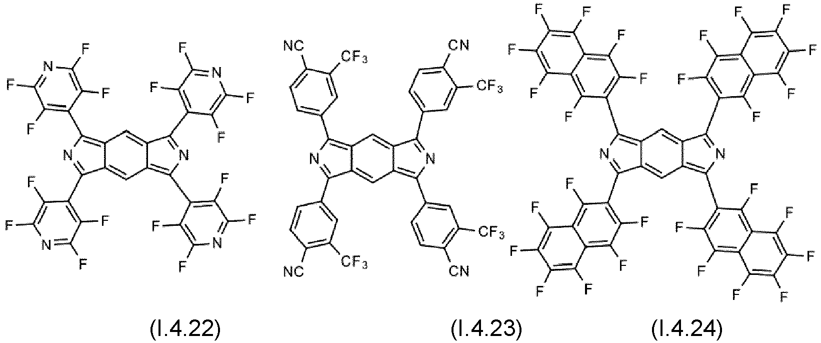

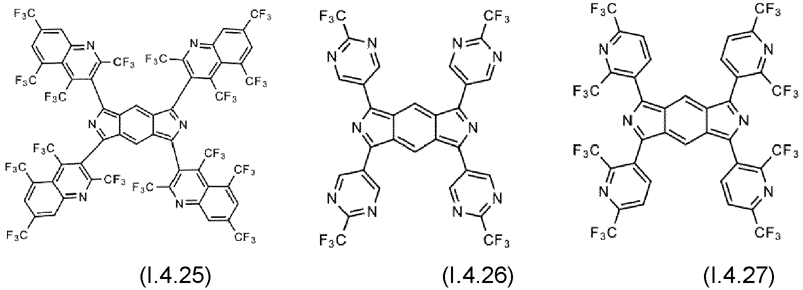

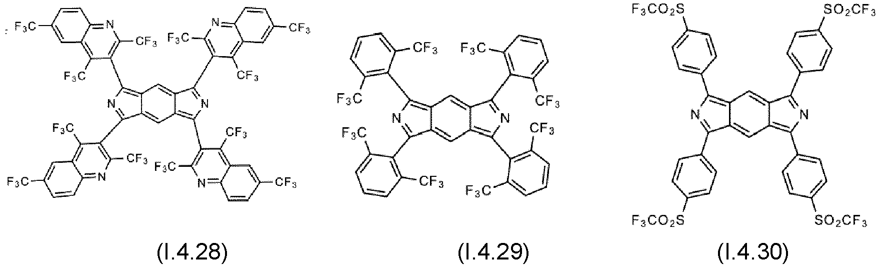

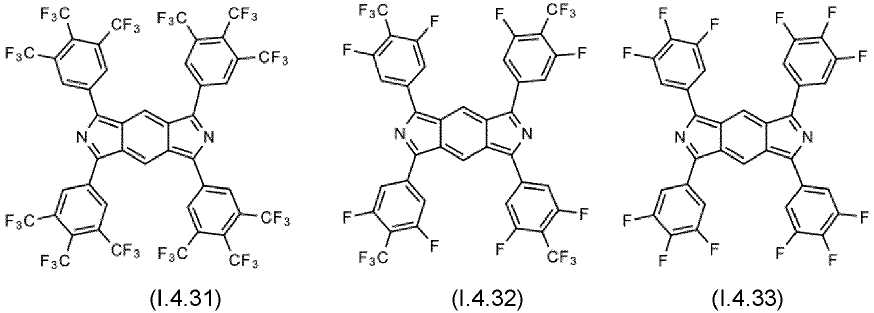

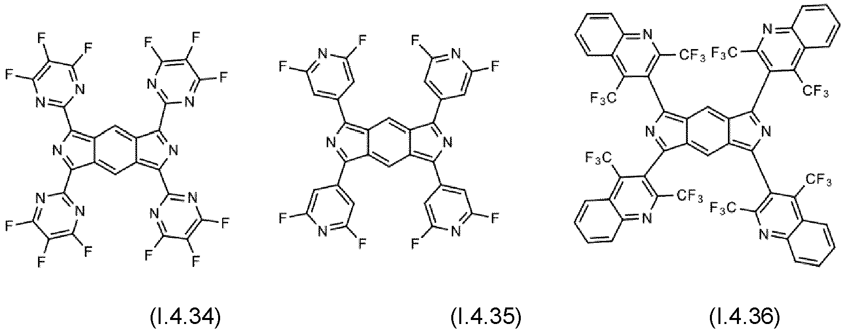

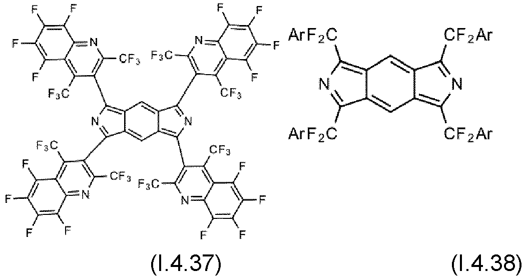

A preferred embodiment are compounds of formula (I), in particular compounds which are selected from compounds of the following formulae (I.5.01) - (I.5.41):

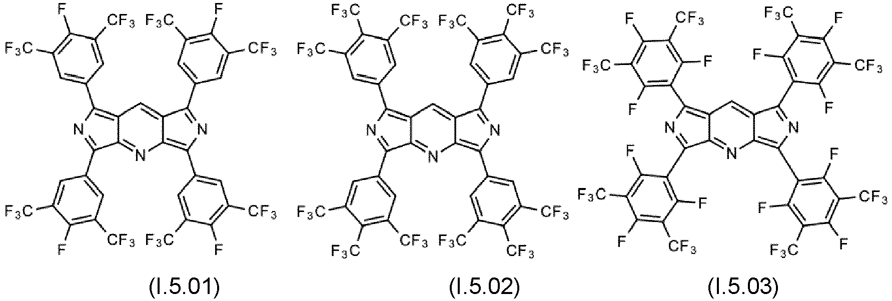

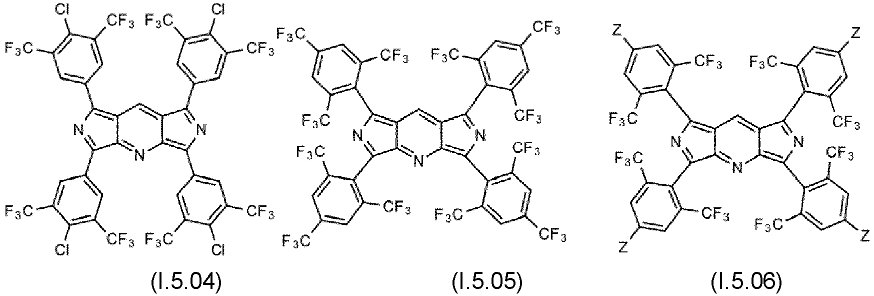

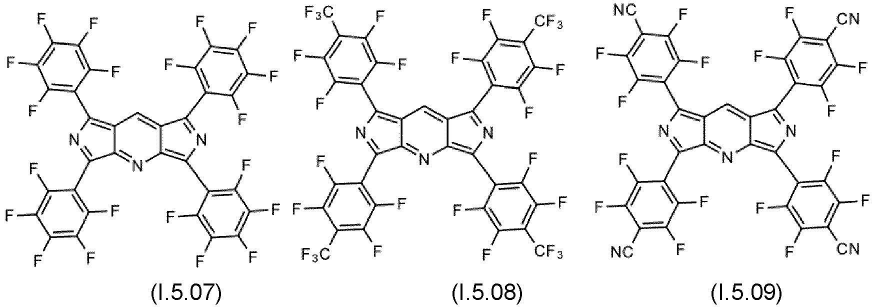

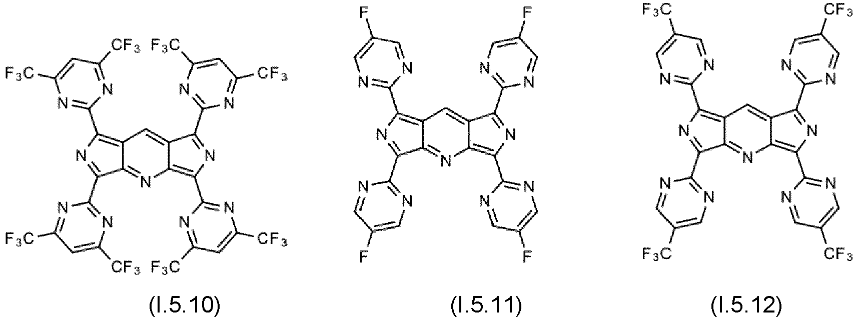

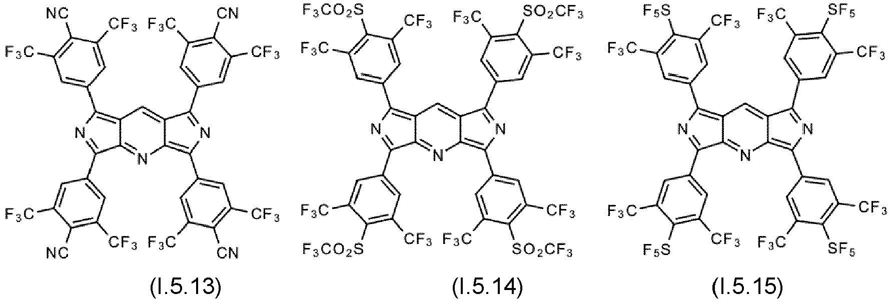

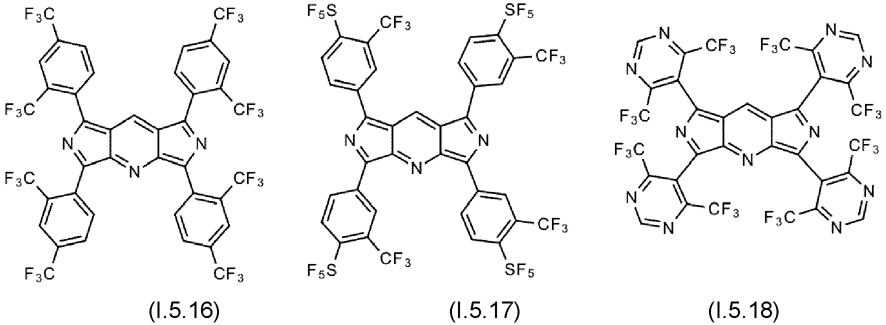

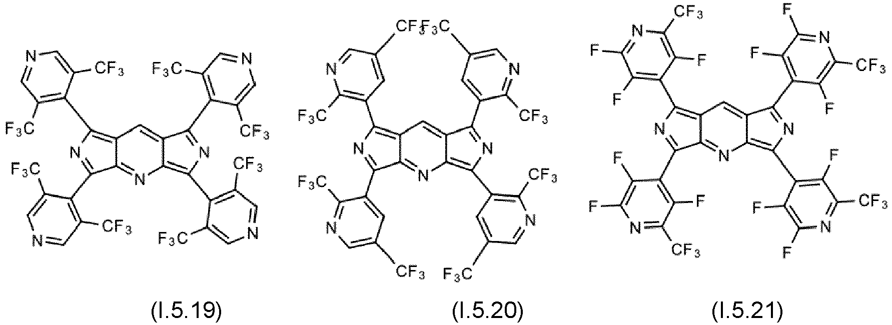

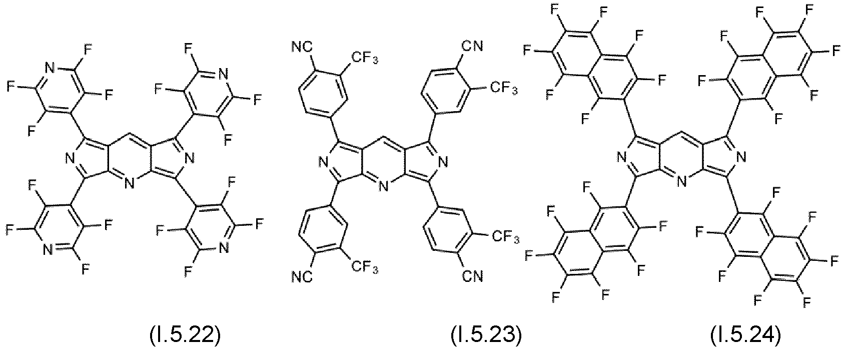

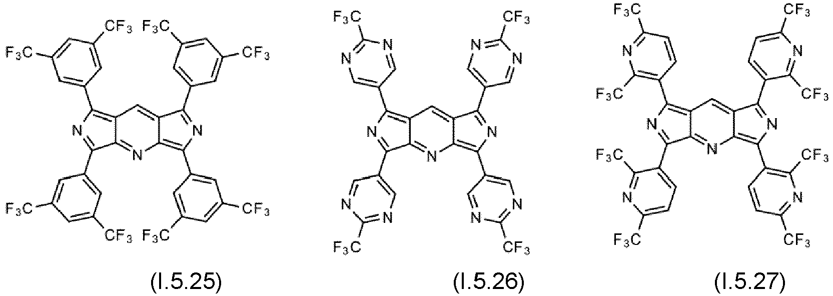

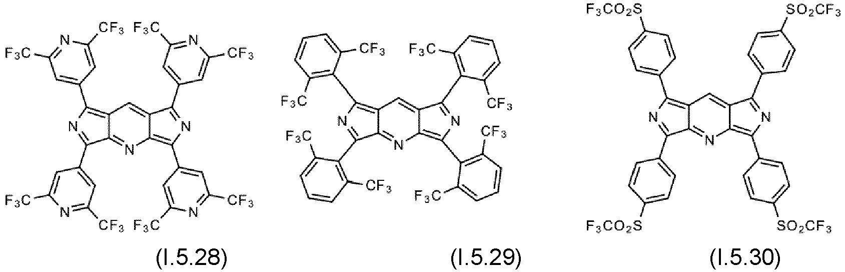

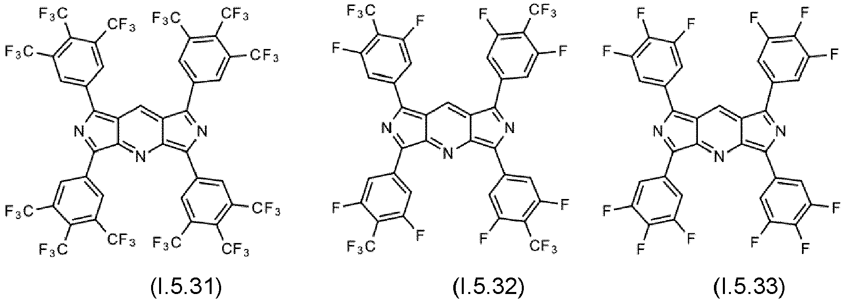

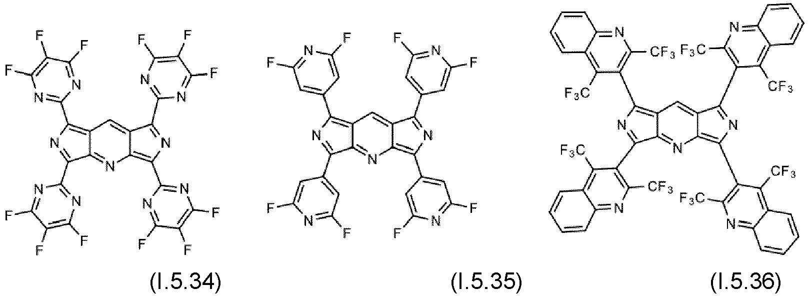

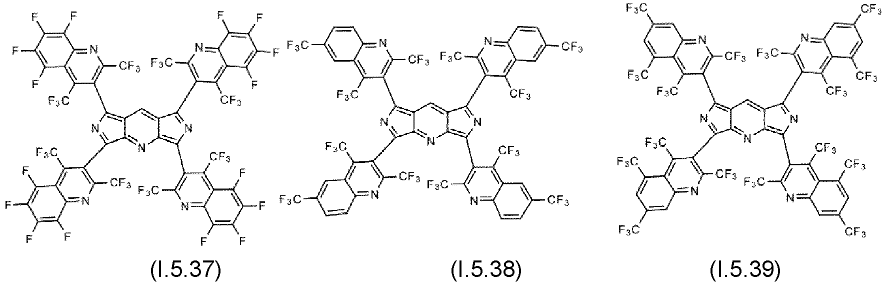

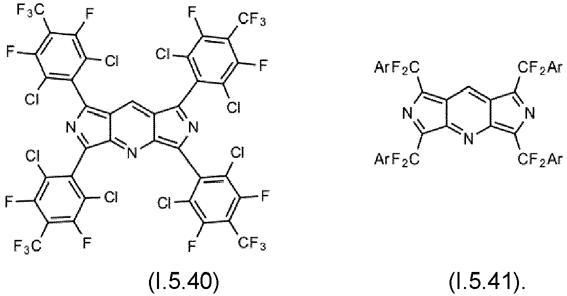

A preferred embodiment are compounds of formula (I), in particular compounds which are selected from compounds of the following formulae (1.6.01) - (1.6.40):

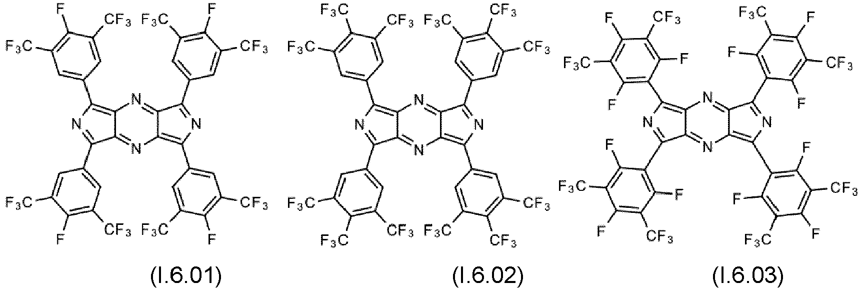

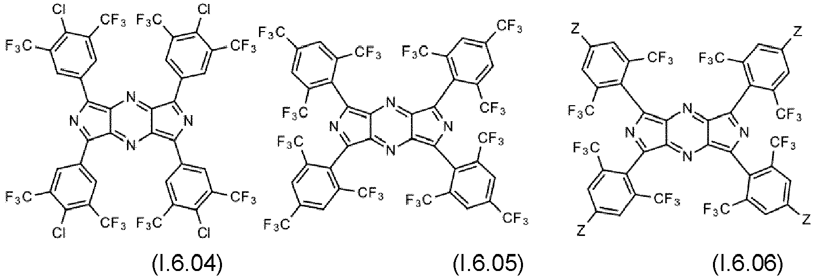

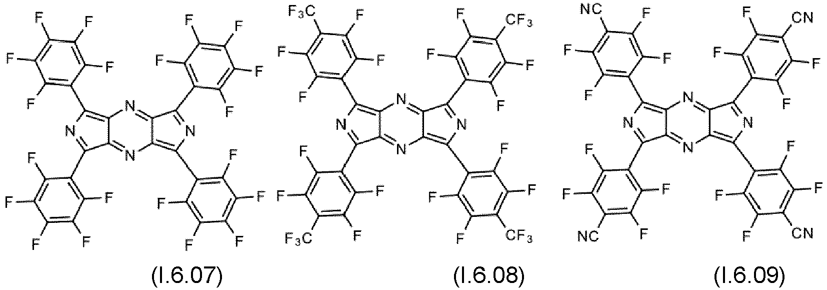

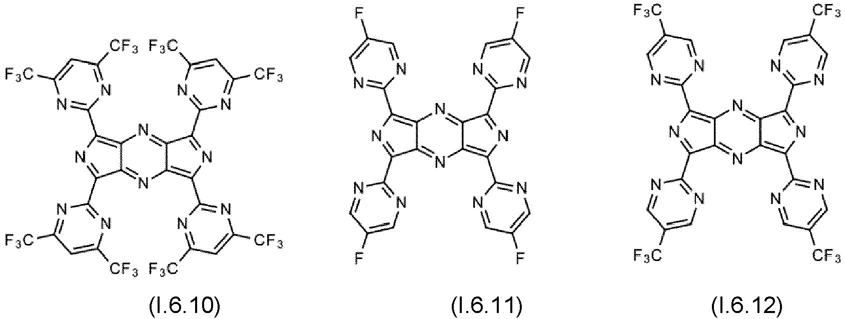

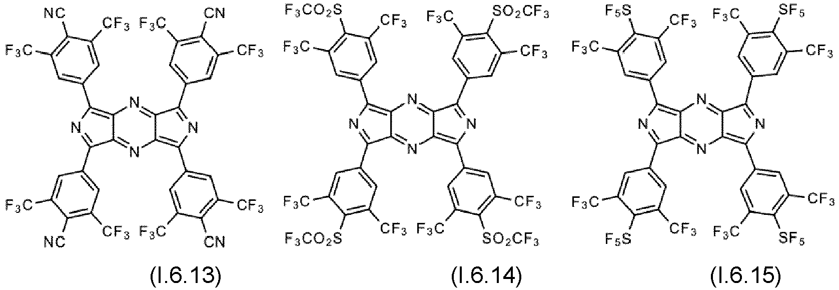

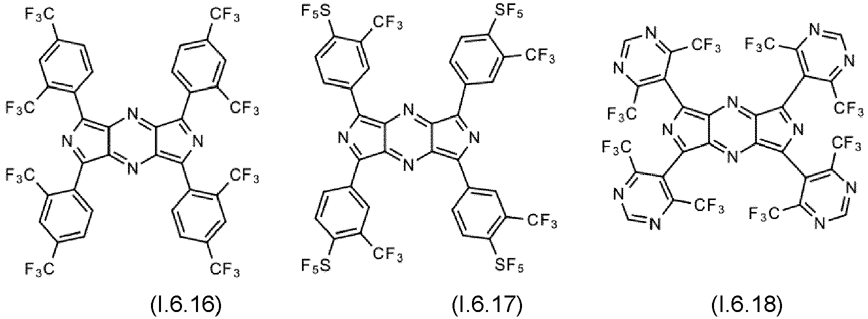

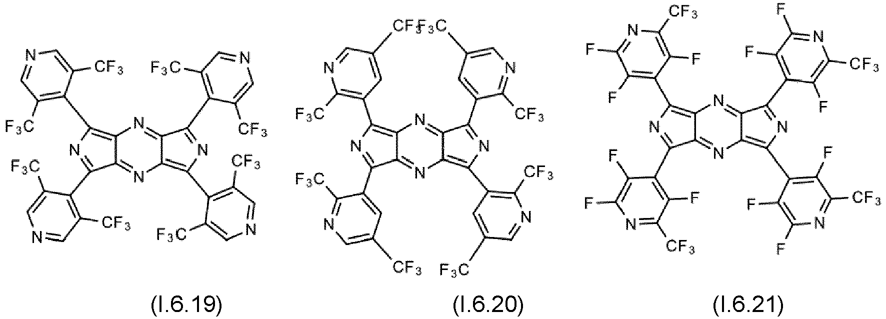

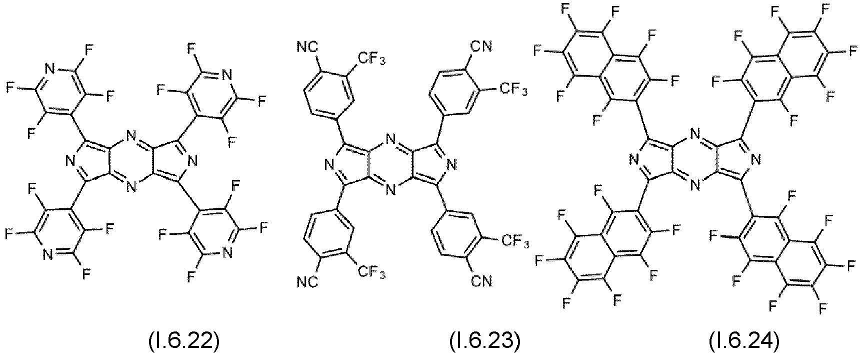

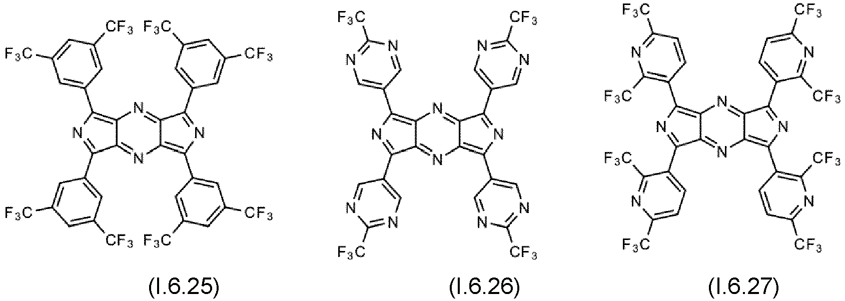

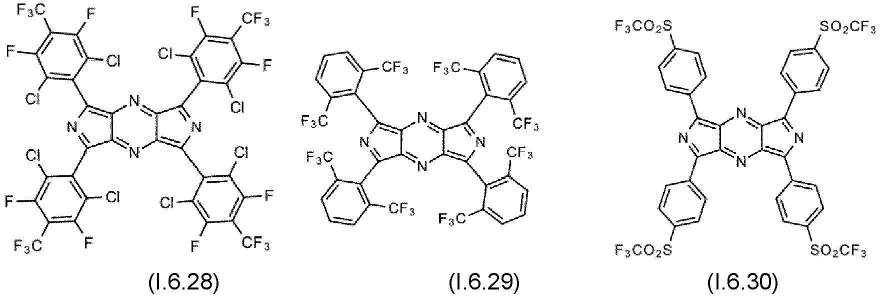

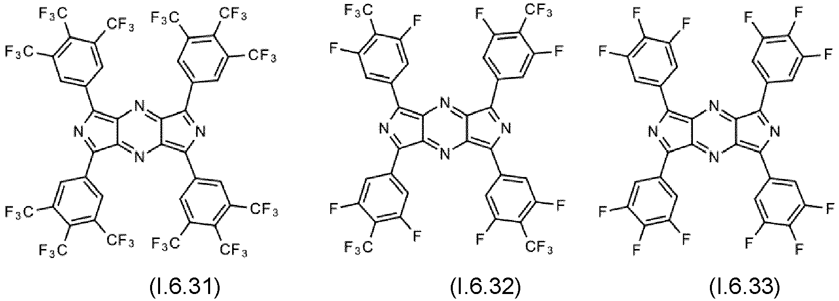

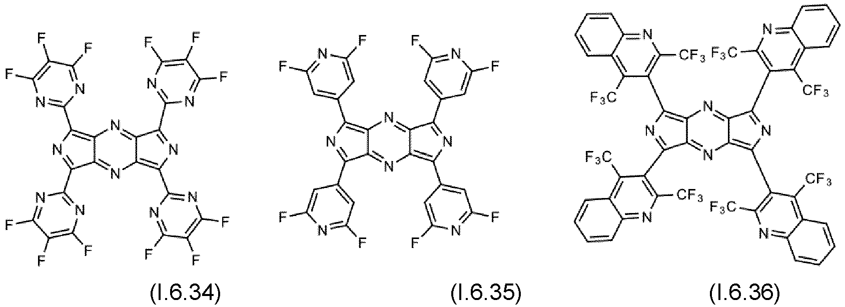

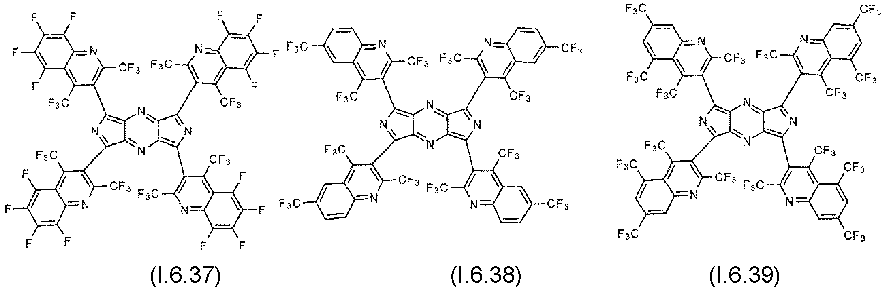

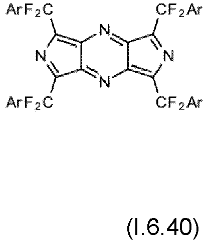

A preferred embodiment are compounds of formula (I), in particular compounds which are selected from compounds of the following formulae (I.7.01) - (I.7.40):

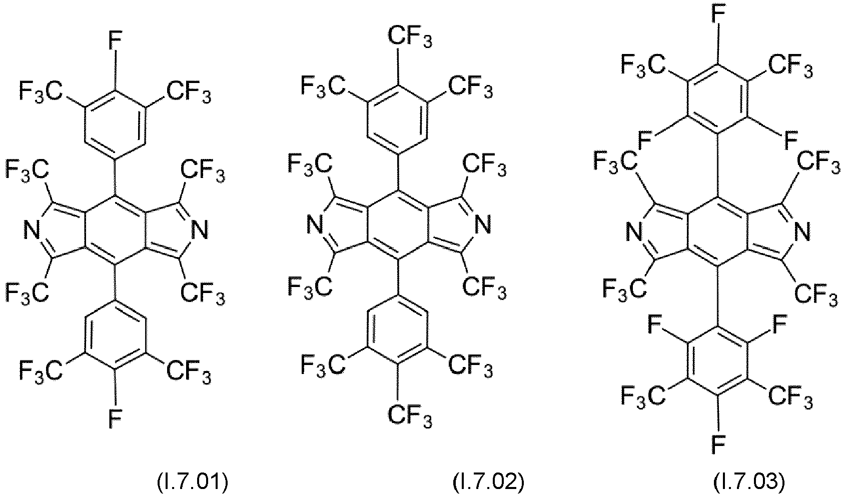

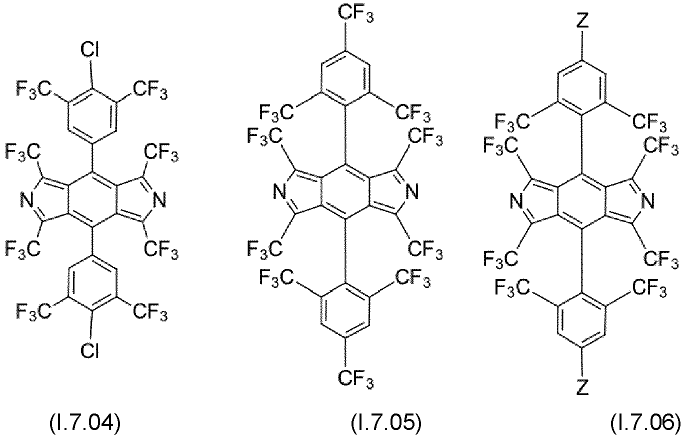

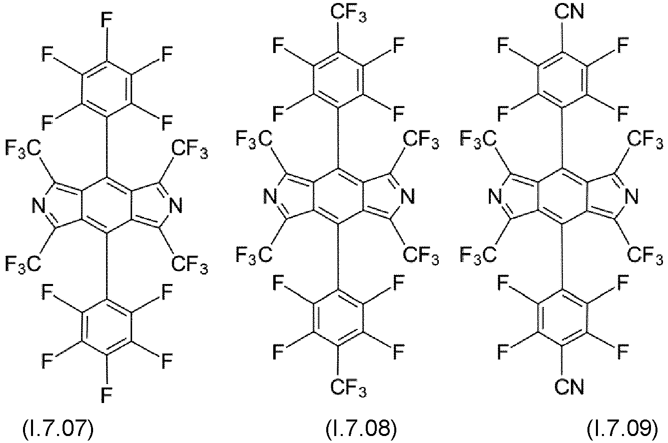

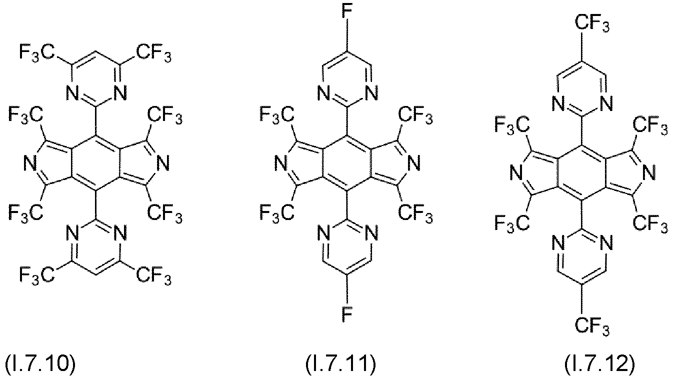

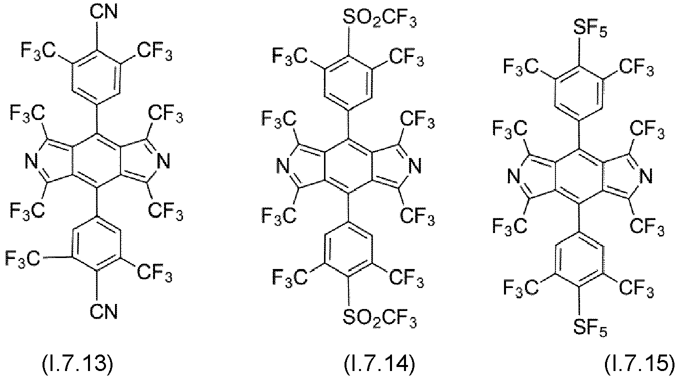

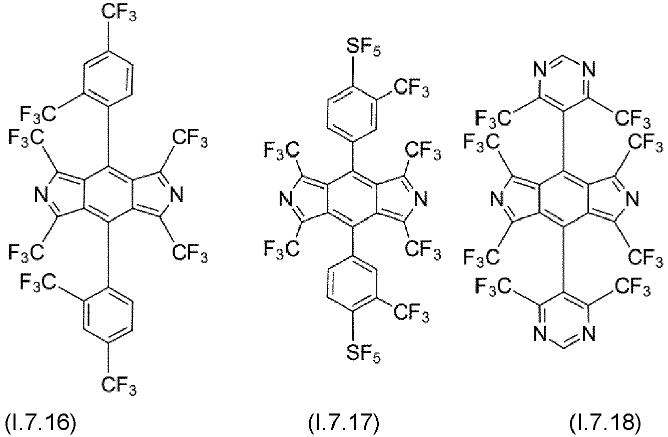

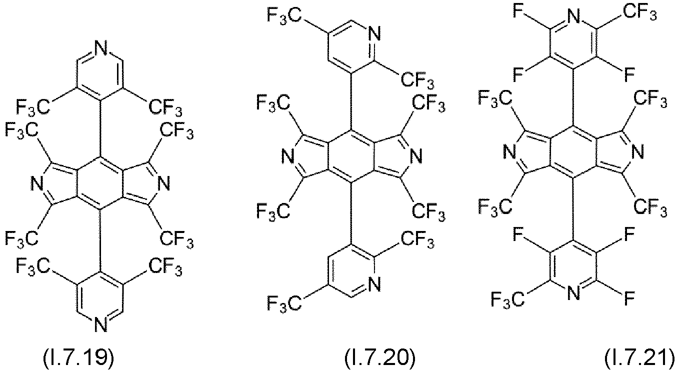

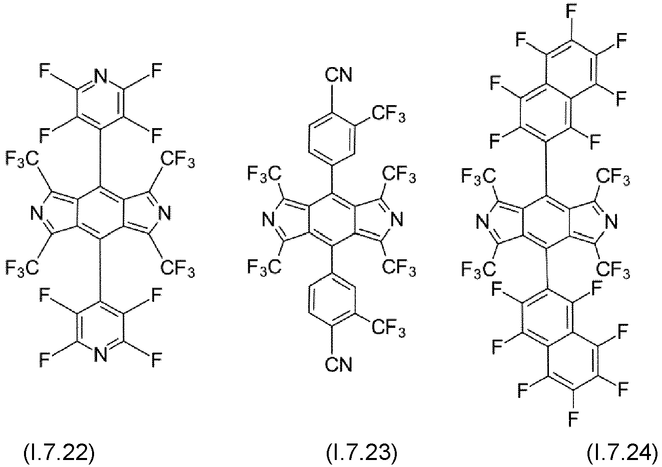

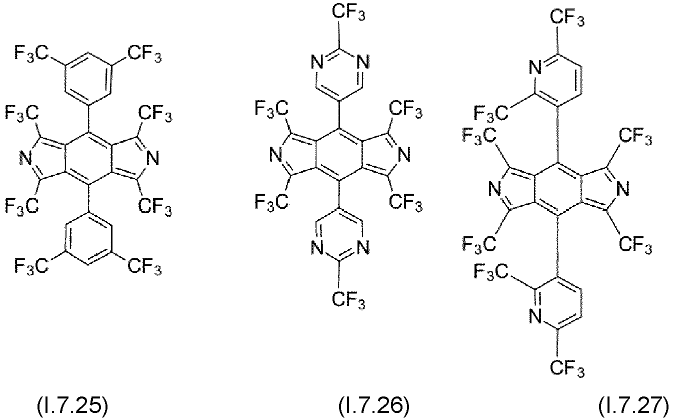

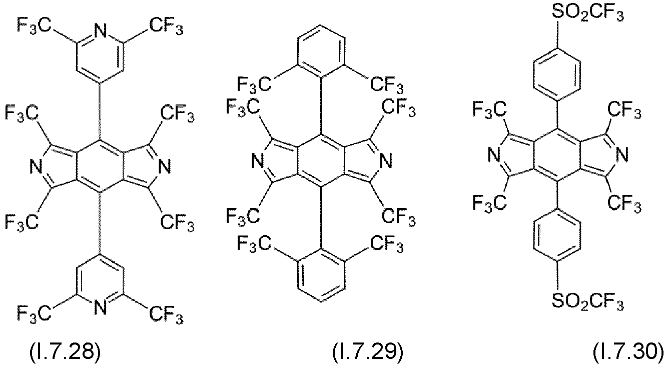

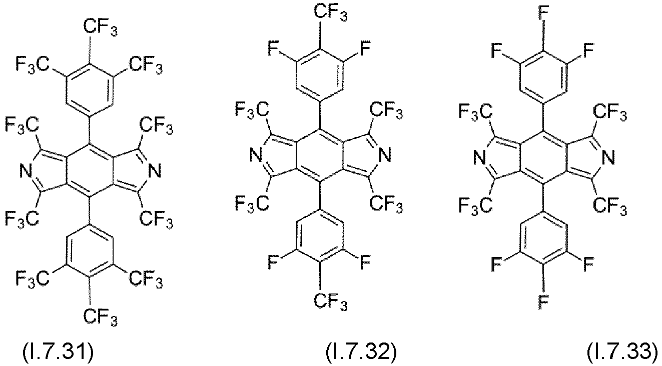

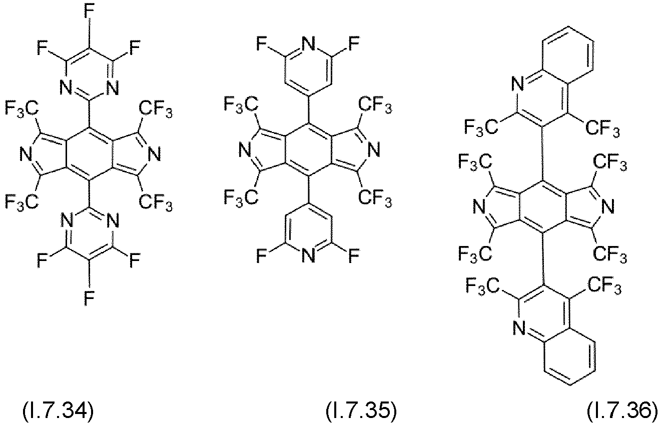

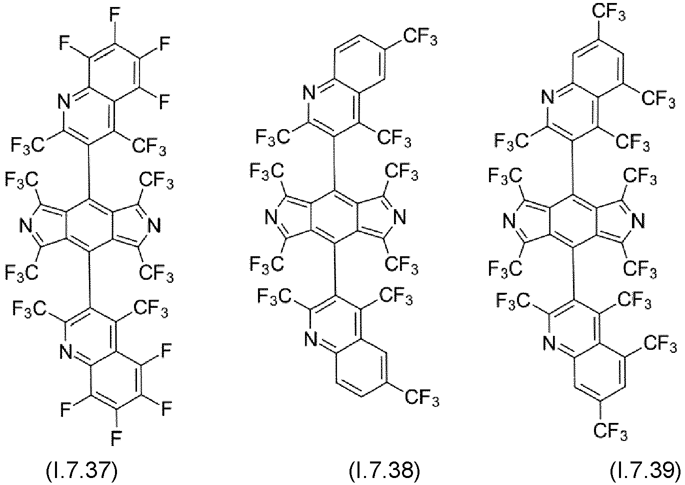

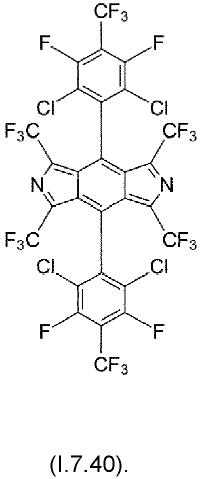

Another emodiment of the invention is the use of compounds of formula (I), preferably compounds of formulae (1.1.01), (1.1.02), (1.1.03), (1.1.04), (1.1.05), (1.1.06), (1.1.07), (1.1.08), (1.1.09), (1.1.10), (1.1.11), (1.1.12), (1.1.13), (1.1.14), (1.1.15), (1.1.16), (1.1.17), (1.1.18), (1.1.19), (1.1.20), (1.1.21), (1.1.22), (1.1.23), (1.1.24), (1.1.25), (1.1.26), (1.1.27), (1.1.28), (1.1.29), (1.1.30), (1.1.31), (1.1.32), (1.1.33), (1.1.34), (1.1.35), (1.1.36), (1.1.37), (1.1.38), (1.1.39), and (1.1.40) as defined herein and/or
(1.2.01), (1.2.02), (I.2.03), (I.2.04), (I.2.05), (I.2.06), (1.2.07), (I.2.08), (I.2.09), (1.2.10), (1.2.11), (1.2.12), (1.2.13), (1.2.14), (1.2.15), (1.2.16), (1.2.17), (1.2.18), (1.2.19), (I.2.20), (1.2.21), (I.2.22), (I.2.23), (I.2.24), (I.2.25), (I.2.26), (I.2.27), (I.2.28), (I.2.29), (I.2.30), (1.2.31), (I.2.32), (I.2.33), (I.2.34), (I.2.35), (I.2.36), (I.2.37), (I.2.38), (I.2.39), (I.2.40), and (1.2.41) as defined herein and/or
(1.3.01), (1.3.02), (1.3.03), (1.3.04), (1.3.05), (1.3.06), (1.3.07), (1.3.08), (1.3.09), (1.3.10), (1.3.11), (1.3.12), (1.3.13), (1.3.14), (1.3.15), (1.3.16), (1.3.17), (1.3.18), (1.3.19), (1.3.20), (1.3.21), (1.3.22), (1.3.23), (1.3.24), (1.3.25), (1.3.26), (1.3.27), (1.3.28), (1.3.29), (1.3.30), (1.3.31), (1.3.32), (1.3.33), (1.3.34), (1.3.35), (1.3.36), (1.3.37), (1.3.38), (1.3.39), (1.3.40), and (1.3.41) as defined herein and/or
(1.4.01), (I.4.02), (I.4.03), (I.4.04), (I.4.05), (1.4.06), (I.4.07), (I.4.08), (I.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (I.4.23), (I.4.24), (I.4.25), (I.4.26), (I.4.27), (I.4.28), (I.4.29), (1.4.30), (1.4.31), (I.4.32), (I.4.33), (I.4.34), (1.4.35), (I.4.36), (I.4.37), and (I.4.38) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), (1.5.28), (1.5.29), (1.5.30), (1.5.31), (1.5.32), (1.5.33), (1.5.34), (1.5.35), (1.5.36), (1.5.37), (1.5.38), (1.5.39), (1.5.40), and (1.5.41) as defined herein and/or
(1.6.01), (I.6.02), (I.6.03), (1.6.04), (I.6.05), (I.6.06), (I.6.07), (I.6.08), (1.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), (I.6.28), (I.6.29), (I.6.30), (1.6.31), (I.6.32), (I.6.33), (I.6.34), (I.6.35), (I.6.36), (I.6.37), (I.6.38), (I.6.39), and (I.6.40) as defined herein and/or
(1.7.01), (1.7.02), (1.7.03), (1.7.04), (1.7.05), (1.7.06), (1.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), (1.7.26), (1.7.27), (1.7.28), (1.7.29), (1.7.30), (1.7.31), (1.7.32), (1.7.33), (1.7.34), (1.7.35), (1.7.36), (1.7.37), (1.7.38), (1.7.39), and (1.7.40) as defined herein, or their radical anions, radical anionic salts, dianions, dianionic salts, or their charge transfer complexes with donors ,as organic doping agent for the doping of an organic semiconductive matrix material, as transport layer, as blocker layer, as hole injection layer, as organic semiconductor itself, as organic semiconductive matrix material.

In the compounds in accordance with the invention the position of the LUMO is advantageously so low that further technically interesting hole transport materials can now be efficiently doped. Due to the low position of the LUMO and to the associated high reduction potential of the compounds even performance efficiencies of solar cells can be significantly improved. The doping effect of a certain magnitude (e.g. a doped layer of a certain conductivity) can be achieved with a substantially lower amount of dopant material to be used compared to conventional dopants under otherwise unchanged conditions. Furthermore, the charge carrier injection from contacts into the doped layer can be improved by the doping agents.

Using the indacenes present in this invention as p-doping agents, in particular in a doped semiconductive matrix material, a sufficient electrical conductivity of the doped semiconductor layer is reached due to the advantageous electron affinity. In addition, the indacenes present in this invention can be used as p-doping agents in an hole injection layer resulting in a sufficient conductivity in the adjacent hole transport layer due to the advantageous electron affinity. In addition, these compounds have a low diffusivity, i.e. they have a low diffusion coefficient, due to their comparably large Stokes radius. This ensures a component structure that is stable in time, i.e., it has a high lifetime. Accordingly, the hole transport layers comprising indacens according to this invention can have an improved long-time stability, for example a reduction or loss of the conductivity over time.

This furthermore concerns the stability of the doped layer that is arranged adjacent to non-doped layers of an electro-optical component in a way that the electro-optical components show an increased long-time stability of their electro optical properties, such as light emission quantum yield, or the efficiency of a solar cell or the like.

Compounds of formula (I), in particular compounds of formulae (1.1.01), (1.1.02), (1.1.03), (1.1.04), (1.1.05), (1.1.06), (1.1.07), (1.1.08), (1.1.09), (1.1.10), (1.1.11), (1.1.12), (1.1.13), (1.1.14), (1.1.15), (1.1.16), (1.1.17), (1.1.18), (1.1.19), (1.1.20), (1.1.21), (1.1.22), (1.1.23), (1.1.24), (1.1.25), (1.1.26), (1.1.27), (1.1.28), (1.1.29), (1.1.30), (1.1.31), (1.1.32), (1.1.33), (1.1.34), (1.1.35), (1.1.36), (1.1.37), (1.1.38), (1.1.39), and (1.1.40) as defined herein and/or
(1.2.01), (I.2.02), (I.2.03), (I.2.04), (1.2.05), (I.2.06), (I.2.07), (I.2.08), (I.2.09), (1.2.10), (1.2.11), (1.2.12), (1.2.13), (1.2.14), (1.2.15), (1.2.16), (1.2.17), (1.2.18), (1.2.19), (1.2.20), (1.2.21), (I.2.22), (I.2.23), (I.2.24), (1.2.25), (I.2.26), (I.2.27), (I.2.28), (I.2.29), (1.2.30), (1.2.31), (1.2.32), (I.2.33), (I.2.34), (1.2.35), (I.2.36), (I.2.37), (I.2.38), (I.2.39), (1.2.40), and (1.2.41) as defined herein and/or
(1.3.01), (1.3.02), (1.3.03), (1.3.04), (1.3.05), (1.3.06), (1.3.07), (1.3.08), (1.3.09), (1.3.10), (1.3.11), (1.3.12), (1.3.13), (1.3.14), (1.3.15), (1.3.16), (1.3.17), (1.3.18), (1.3.19), (1.3.20), (1.3.21), (1.3.22), (1.3.23), (1.3.24), (1.3.25), (1.3.26), (1.3.27), (1.3.28), (1.3.29), (1.3.30), (1.3.31), (1.3.32), (1.3.33), (1.3.34), (1.3.35), (1.3.36), (1.3.37), (1.3.38), (1.3.39), (1.3.40), and (1.3.41) as defined herein and/or
(1.4.01), (I.4.02), (1.4.03), (I.4.04), (I.4.05), (I.4.06), (I.4.07), (1.4.08), (I.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (1.4.23), (I.4.24), (I.4.25), (I.4.26), (I.4.27), (1.4.28), (I.4.29), (I.4.30), (1.4.31), (1.4.32), (1.4.33), (I.4.34), (I.4.35), (I.4.36), (I.4.37), and (1.4.38) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), (1.5.28), (1.5.29), (1.5.30), (1.5.31), (1.5.32), (1.5.33), (1.5.34), (1.5.35), (1.5.36), (1.5.37), (1.5.38), (1.5.39), (1.5.40), and (1.5.41) as defined herein and/or
(1.6.01), (1.6.02), (I.6.03), (1.6.04), (I.6.05), (I.6.06), (I.6.07), (I.6.08), (1.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), (I.6.28), (I.6.29), (I.6.30), (1.6.31), (1.6.32), (I.6.33), (I.6.34), (I.6.35), (I.6.36), (I.6.37), (I.6.38), (I.6.39), and (I.6.40) as defined herein and/or
(1.7.01), (1.7.02), (1.7.03), (1.7.04), (1.7.05), (1.7.06), (I.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), (1.7.26), (1.7.27), (1.7.28), (1.7.29), (1.7.30), (1.7.31), (1.7.32), (1.7.33), (1.7.34), (1.7.35), (1.7.36), (1.7.37), (1.7.38), (1.7.39), and (1.7.40) as defined herein.

A further object of the invention is a **use** of at least one compound of formula (I), in particular compounds of formulae (1.1), (1.2), (1.3), (1.4), (1.5), (1.6), and (1.7),
preferably compounds of formulae (1.1.01), (1.1.02), (1.1.03), (1.1.04), (1.1.05), (1.1.06), (1.1.07), (1.1.08), (1.1.09), (1.1.10), (1.1.11), (1.1.12), (1.1.13), (1.1.14), (1.1.15), (1.1.16), (1.1.17), (1.1.18), (1.1.19), (1.1.20), (1.1.21), (1.1.22), (1.1.23), (1.1.24), (1.1.25), (1.1.26), (1.1.27), (1.1.28), (1.1.29), (1.1.30), (1.1.31), (1.1.32), (1.1.33), (1.1.34), (1.1.35), (1.1.36), (1.1.37), (1.1.38), (1.1.39), and (1.1.40) as defined herein and/or
(1.2.01), (I.2.02), (I.2.03), (I.2.04), (I.2.05), (I.2.06), (1.2.07), (I.2.08), (I.2.09), (1.2.10), (1.2.11), (1.2.12), (1.2.13), (1.2.14), (1.2.15), (1.2.16), (1.2.17), (1.2.18), (1.2.19), (I.2.20), (1.2.21), (I.2.22), (I.2.23), (I.2.24), (I.2.25), (I.2.26), (I.2.27), (I.2.28), (I.2.29), (I.2.30), (1.2.31), (1.2.32), (I.2.33), (I.2.34), (I.2.35), (I.2.36), (I.2.37), (I.2.38), (I.2.39), (I.2.40), and (1.2.41) as defined herein and/or
(1.3.01), (1.3.02), (1.3.03), (1.3.04), (1.3.05), (1.3.06), (1.3.07), (1.3.08), (1.3.09), (1.3.10), (1.3.11), (1.3.12), (1.3.13), (1.3.14), (1.3.15), (1.3.16), (1.3.17), (1.3.18), (1.3.19), (1.3.20), (1.3.21), (1.3.22), (1.3.23), (1.3.24), (1.3.25), (1.3.26), (1.3.27), (1.3.28), (1.3.29), (1.3.30), (1.3.31), (1.3.32), (1.3.33), (1.3.34), (1.3.35), (1.3.36), (1.3.37), (1.3.38), (1.3.39), (1.3.40), and (1.3.41) as defined herein and/or
(1.4.01), (I.4.02), (I.4.03), (I.4.04), (I.4.05), (1.4.06), (I.4.07), (I.4.08), (I.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (I.4.23), (I.4.24), (I.4.25), (I.4.26), (I.4.27), (I.4.28), (I.4.29), (1.4.30), (1.4.31), (1.4.32), (I.4.33), (I.4.34), (1.4.35), (I.4.36), (I.4.37), and (I.4.38) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), (1.5.28), (1.5.29), (1.5.30), (1.5.31), (1.5.32), (1.5.33), (1.5.34), (1.5.35), (1.5.36), (1.5.37), (1.5.38), (1.5.39), (1.5.40), and (1.5.41) as defined herein and/or
(1.6.01), (1.6.02), (1.6.03), (1.6.04), (1.6.05), (I.6.06), (I.6.07), (1.6.08), (I.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), (I.6.28), (I.6.29), (I.6.30), (1.6.31), (1.6.32), (I.6.33), (I.6.34), (I.6.35), (I.6.36), (I.6.37), (I.6.38), (I.6.39), and (1.6.40) as defined herein and/or
(1.7.01), (1.7.02), (1.7.03), (1.7.04), (1.7.05), (1.7.06), (1.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), (1.7.26), (1.7.27), (1.7.28), (1.7.29), (1.7.30), (1.7.31), (1.7.32), (1.7.33), (1.7.34), (1.7.35), (1.7.36), (1.7.37), (1.7.38), (1.7.39), and (1.7.40) as defined herein, have been found to be specifically useful to perform the invention.

Advantageously, these compounds are able to dope all common OLED hole transport materials. Especially, hole transport materials with a wide range of HOMO levels can be doped. In addition, these compounds can be strong electron acceptors and form easily radical anion salts (where the indacene compound can carry for instance one or two negative charges) or charge-transfer complexes with electron donor compounds. Such radical ion salts (radical anions) or charge-transfer complexes have a variety of different useful applications such as to for charge injection layers, charge transport layers.

By carrying out p-doping experiments, it was found that the compounds according to the invention gave very good doping properties. It is especially important to note that the substitution pattern defined by those compounds give strongly accepting compounds with a reduction potential above 0V vs. Fc/Fc+ when the compounds according to the invention were tethered by related electron withdrawing groups. Fc/Fc+ denoted as usual the Ferrocene/ Ferrocenium redox couple. Reduction potentials can be considered as measures for the LUMO of a molecule. This is preferably measured by cyclovoltammetry.

For p-doped OLED or organic solar cell, often hole-transporting materials are doped by electron acceptor compounds. The layer sequence is for instance: Anode/ p-doped HIL/ (p-doped) HTL/ EBL/ EML/ ETL/ EIL/ Cathode. Herein, HIL denotes a hole injection layer, HTL denotes an hole transport layer, EBL denotes an electron blocking layer, EML denotes a (light) emitting layer, ETL denoted an electron transport layer, EIL denotes electron injection layer.

There is a needto achieve good doping results in host materials which are conventionally used as HTL or EBL materials. They often have a oxidation potential in the range of 0 to 0.5 V vs. Fc/Fc+. Oxidation potential can be considered as a measure for the HOMO of a molecule. It is remarkable, that the selected dopants provide high conductivities in a HIL type host and a HTL type host.

### Electronic component

In the context of the invention, an electronic component is understood to be a discrete or integrated electrical component that utilizes the properties of compounds of the general formula (I) or semiconductor layers that contain a compound of the general formula (I).

In the context of the present specification the term "compound of the general formula (I)" means a compound that corresponds to the formula (I) according to the invention as defined herein. An electronic component which comprises a compound of the general formula (I) may comprise each compound which is included in one of the preferred embodiments of the compounds as described herein. This also applies to the term "compound of the formula (I)".

All specifications for the compounds and preferred embodiments of the compounds apply analogously to the electronic component.

In a particular embodiment, the electronic component has a layered structure comprising 2 to 50 layers, preferably 3 to 30 layers, more preferably 5 to 20 layers, wherein at least one of the layers comprises at least one compound of general formula (I). However, each of the layers may also comprise inorganic materials, or the component may also comprise layers composed entirely of inorganic materials.

Preferably, the electronic component is selected from
- a light-emitting device, preferably a light-emitting electrochemical cell or an organic electroluminescent device, more preferably an organic light-emitting diode (OLED), especially a triple-stack organic light-emitting diode, or a quadrupole-stack organic light-emitting diode,
- a display device,
- a photovoltaic cell, preferably an organic solar cell, preferably a single-stack organic solar cell, a tandem-stack organic solar cell, a triple-stack organic solar cell, a quadrupole-stack organic solar cell, a Perovskite solar cell, or a dye sensitized solar cell,
- an organic photodetector,
- an organic transistor, preferably organic thin-film transistors (OTFTs),
- an organic diode,
- an organic laser diode,
- devices for electrophotography, or
a battery.

Preferably, the matrix material for the hole transport layer is selected from
- A fully substituted triaryl amine and its derivatives
- A hole transport material that has a HOMO-level of less than -4.8 eV
- A hole transport material that has a HOMO-level higher than -5.2 eV
- A hole transport material that has a HOMO-level higher than the HOMO-level of BPAPF, i.e. a HOMO-level shallower than the HOMO-level of BPAPF, when measured with the same method
- A hole transport material that has partially or fully substituted thiophene units or is an oligo- or polythiophene
- A hole transport material that consists of partially or fully substituted aryl or heteroaryl rings, but does not contain any triarylamine functional units
- A hole transport material that includes substituted carbazole units
- A matrix material selected according to EP3859808

More preferably, the electronic component according to the invention is in the form of an organic light-emitting diode, an organic solar cell, a perovskite solar cell, an organic photodiode or an organic thin-film transistor.

In a preferred embodiment the electronic component according to the invention comprises at least one hole transport layer and/or at least one hole injection layer and/or at least one hole extraction layer, which comprises at least one or more of the compounds of formula (I). The compound of formula (I) comprised in the hole transport layer may be the same or different from the compound of formula (I) in the hole injection or extraction layer.

Generally, a hole injection layer is a layer which facilitates hole injection from the anode into the organic semiconductor matrix material. The hole injection layer can be placed directly adjacent to the anode. A hole transport layer transports the holes from the anode to the emitting layer and is located between a hole injection layer and an emitting layer.

The hole injection layer may be composed of a first sub-layer comprising a compound of formula (I) and a second sub-layer comprising a matrix material, wherein the first sub-layer is closer to the anode and the second sub-layer is closer to the emitting layer. The first sub-layer may also consist of a compound of formula (I). The second sub-layer may or may not comprise a compound of formula (I) in addition to a semiconductor matrix material.

The hole-injection layer and/or hole-transport layer in an electronic component according to the invention may also comprise a second p-dopant different from compounds of formula (I), for example each of the layers may also comprise doping materials selected from the following list (I):

### List (I):

The class of 3-radialenes, preferrably α,α',α"-1,2,3-Cyclopropanetriylidenetris[4-cyano-2,3,5,6-tetrafluorobenzeneacetonitrile], from the class of dicyanochinodimethane-derivatives, preferrably 2,3,5,6-Tetrafluor-7,7,8,8-tetracyanochindimethan, 2,2'-(1,3,4,5,7,8-Hexafluoro-2,6-naphthalenediylidene)bis[propanedinitrile], 2,2'-[4,8-Bis[2,4-bis(trifluoromethyl)phenyl]benzo[1,2-d:4,5-d']bisoxazole-2,6-diylidene]bis[propanedinitrile], from the class of metal complexes, in particular cerium(IV) diketonates and derivatives or from the class of benzobisoxazole and derivatives such as 2,2'-[4,8-Bis[2,4-bis(trifluoromethyl)phenyl]benzo[1,2-d:4,5-d']bisoxazole-2,6-diylidene]bis[propanedinitrile].

The second p-dopant may be present in the same or a different layer or sub-layer than the compound of formula (I).

Preferably, the electronic component also comprises a substrate (a metal, glass, or plastic substrate), an anode layer with or without sublayers, and a cathode layer.

The anode layer may be composed of a metal or a transparent conductive oxide. The anode layer may comprise a first and a second sub-layer, wherein the first sub-layer comprises a metal, and the second sub-layer comprises a transparent conductive oxide, and the second sub-layer is closer to the hole injection layer.

In a preferred embodiment, the electronic component comprises an electrode, in particular an anode, which comprises at least two sublayers. A first sublayer is preferably positioned between the substate and a second sublayer and the first sublayer comprises a metal with a work function between 3 eV and 7 eV, preferably between 4 eV and 6 eV. The second sublayer may comprise a transparent material, in particular a tranparent conductive oxide, e.g. indium tin oxide. Accordingly, the energy level alignment can be enhanced.

In a preferred embodiment an electronic component according to the invention, comprises at least one pn-junction, which comprises at least one or more of the compounds of formula (I). The pn-junction may be a charge-generation layer, for example connecting two light-emitting units. The pn-junction may also be a charge conversion contact or recombination contact, for example connecting two light-absorbing units. The pn-junction may also be used to connect an anode or a cathode to a light-emitting unit or an absorbing unit.

The electronic component may specifically be an organic electroluminescent device, particularly in the form of an organic light-emitting diode (OLED). An organic electroluminescent device comprises a cathode, an anode and at least one emitting layer. It may also include other layers in addition to these layers, for example, one or more each of hole injection layers, hole transport layers, hole blocking layers, electron transport layers, electron injection layers, electron blocking layers, exciton blocking layers, charge conversion contacts and/or charge generation layers, both also referred to as pn-junctions. Not each of these layers must necessarily be present.

In a preferred embodiment, an electronic component, particularly in the form of an OLED, the layer comprising at least one of the compounds of formula (I) is a hole injection layer. A hole injection layer is generally a layer that facilitates hole injection from the anode into the organic semiconductor layer. The hole injection layer can be placed directly adjacent to the anode. The anode may or may not be composed of several sublayers. The hole injection layer may be purely composed of a compound of formula (I). Preferably, the hole injection layer is composed of a semiconductor matrix material and one or more compound(s) of formula (I). The electronic component may also, in addition, include a pn-junction or a charge-generation layer, which comprises a p-dopant different from compounds of formula (I), e.g. selected from list (I).

In a preferred embodiment, an electronic component, particularly in the form of an OLED, the layer comprising at least one of the compounds of formula (I) is a hole transport layer. Preferably, the hole transport layer is composed of a semiconductor matrix material and one or more compound(s) of formula (I). Specifically, the hole transport layer may be located between a hole injection layer and an emitting layer, where it transports holes from the anode to the emitting layer. Between the hole transport layer and the emitting layer may be other layers, such as electron blocking layers, exciton blocking layers, and prime layers. In another embodiment, preferably a tandem- or triple-stack OLED, the hole transport layer transports holes from a charge generation layer to an emitting layer. Between the hole transport layer and the emitting layer may be other layers, such as electron blocking layers, exciton blocking layers, and prime layers. The electronic component may also, in addition, include a hole-injection layer, which comprises a p-dopant different from compounds of formula (I) , e.g. selected from list (I). The electronic component may also, in addition, include a pn-junction or charge-generation layer, which comprises a p-dopant different from compounds of formula (I), e.g. selected from list (I).

In a preferred embodiment, an electronic component, particularly in the form of a tandem or triple or quadruple-stack OLED, the layer comprising the compound of formula (I) is part of a pn-junction, particularly in form of a charge-generation layer. The pn-junction may be composed of a hole-transport layer, an electron-transport layer, and optionally one or more interlayers. Preferably, the layer comprising a compound of formula (I) is the hole-transport layer. Preferably, this hole transport layer is composed of a semiconductor matrix material and one or more compound(s) of formula (I). A compound of formula (I) may also be used in an interlayer. The electronic component may also, in addition, include a hole injection and/or hole-transport layer, which comprises a p-dopant different from compounds of formula (I), e.g. selected from list (I).

A preferred embodiment is an electronic component in the form of an organic solar cell. Organic solar cells generally have a layered structure and typically include at least the following layers: anode, at least one photoactive layer and cathode. The photoactive region of the solar cell may comprise two layers, each having a homogeneous composition and forming a planar donor-acceptor heterojunction. A photoactive region may also comprise a mixed layer and form a donor-acceptor heterojunction in the form of a donor-acceptor bulk heterojunction. In addition to these layers, the organic solar cell may also comprise other layers, e.g., selected from electron extraction layer, hole extraction layer, electron transport layer (ETL), hole transport layers (HTL), exciton blocking layer, hole blocking layer, electron blocking layers, charge conversion layer, also referred to as charge recombination layer, optical spacers, and multiplier layers. Preferably, these layers do not absorb UV-visible light.

A preferred embodiment is an electronic component, particularly in the form of an organic solar cell, wherein the layer comprising at least one of the compounds of formula (I) is a hole extraction layer. Preferably, this hole extraction layer is composed of a semiconductor matrix material and one or more compound(s) of formula (I). The hole extraction layer may be placed directly adjacent to the anode. The electronic component may also, in addition, include a pn-junction or charge-conversion layer, which comprises a p-dopant different from compounds of formula (I), e.g. selected from list (I).

A preferred embodiment is an electronic component, particularly in the form of an organic solar cell, wherein the layer comprising at least one of the compounds of formula (I) is a hole transport layer. Preferably, this hole transport layer is composed of a semiconductor matrix material and one or more compound(s) of formula (I). The hole transport layer may be placed between a photoactive layer and an anode or between a photoactive layer and a charge conversion layer or a charge recombination layer. The electronic component may also, in addition, include a pn-junction or charge-generation layer, which comprises a p-dopant different from compounds of formula (I), e.g. selected from list (I).

Preferably, the electronic component according to the invention is in the form of an organic solar cell, particularly in the form of a single, tandem, triple or quadruple-stack organic solar cell, wherein the layer comprising at least one of the compounds of formula (I) is a pn-junction. The pn-junction may be a charge conversion or recombination contact, connecting a light-absorbing unit to an additional light-absorbing unit in a multi-stack device and/or a pn-junction (or conversion contact) connecting a cathode or an anode to a light-absorbing unit in a single or multi-stack device. The electronic component may also, in addition, include a hole extraction and/or hole transport layer, which comprises a p-dopant different from compounds of formula (I), e.g. selected from list (I).

Preferably, the electronic component according to the invention is in the form of an organic or hybrid solar cell, which are exciton solar cells, dye sensitized solar cells (DSSCs) or perovskite solar cells. Preferred devices for electrophotography are photoconductive materials in organic photoconductors (OPCs).

Preferred are **electronic components** comprising at least one compound of the formula (I): 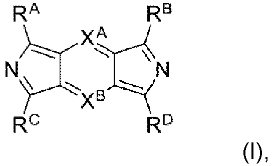 in which
X^{A} is selected from C-H, nitrogen (N), C-CF₃ and C-R^{E},
X^{B} is selected from C-H, nitrogen (N), C-CF₃ and C-R^{F}, and
wherein in compounds of formula (I) R^{A}, R^{B}, R^{C}, and R^{D} are independently selected from
C₆-C₁₄-aryl or heteroaryl,
Wherein heteroaryl has 4 to 13 carbon atoms,
wherein heteroaryl has 1, 2 or 3 identical or different heteroatoms or heteroatom-containing groups as ring members, selected from N, O, S, SO and SO₂, wherein C₆-C₁₄-aryl and heteroaryl are unsubstituted or substituted by 1, 2, 3, 4 or 5 identical or different radicals R^{G};
wherein R^{G} is selected from CN, F, CI, OCF₃, SCF₃, SF₅, SO₂CF₃, C₁-C₄-alkyl, C₁-C₄-haloalkyl or C₆-C₁₄-aryl, which is unsubstituted or substituted by 1, 2 or 3 identical or
different radicals selected from F, CN, C₁-C₄-alkyl and C₁-C₄-haloalkyl,
wherein in compounds of formula (I) R^{E} and R^{F} are independently selected from C₆-C₁₄-aryl or heteroaryl,
Wherein heteroaryl has 4 to 13 carbon atoms,
wherein heteroaryl has 1, 2 or 3 identical or different heteroatoms or heteroatom-containing groups as ring members, selected from N, O, S, SO and SO₂, wherein C6-C14-aryl and heteroaryl are unsubstituted or substituted by 1, 2, 3, 4 or 5 identical or different radicals R^{G};
wherein R^{G} is selected from CN, F, CI, OCF₃, SCF₃, SF₅, SO₂CF₃, C₁-C₄-alkyl, C₁-C₄-haloalkyl or C₆-C₁₄-aryl, which is unsubstituted or substituted by 1, 2 or 3 identical or
different radicals selected from F, CN, C₁-C₄-alkyl and C₁-C₄-haloalkyl,
with the proviso that 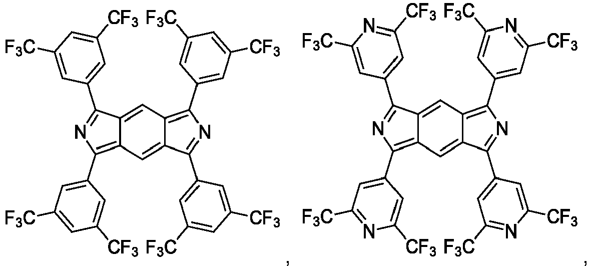 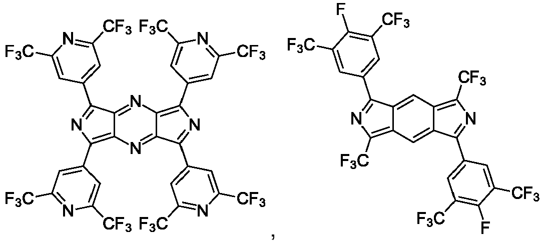 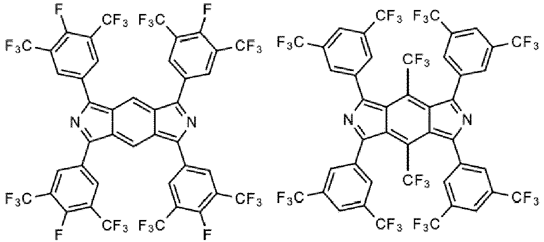
are excluded.

Preferred are electronic components comprising at least one or more of the compounds of the formula (I): 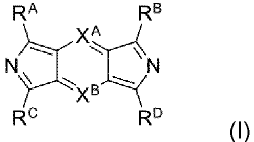
or their radical anions, radical anionic salts, dianions, dianionic salts, or their charge transfer complexes with donors,
in which
X^{A} can be chosen from C-H, nitrogen (N), C-CF₃ and C-R^{E},
X^{B} can be chosen from C-H, nitrogen (N), C-CF₃ and C-R^{F}, and
wherein in compounds of formula (I) R^{A}, R^{B}, R^{C}, and R^{D} are independently selected from one of
the formulas (11.1) - (11.46): 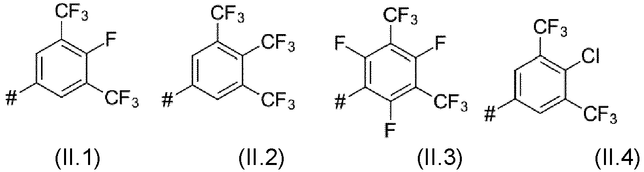 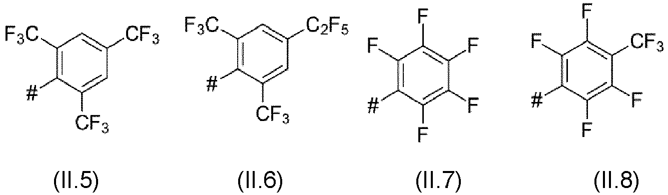 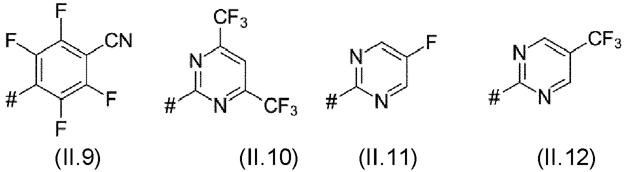 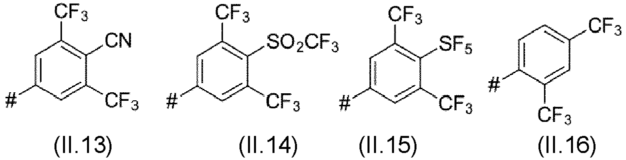 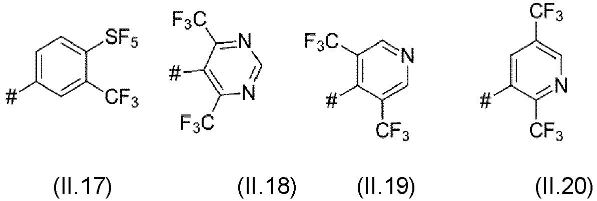 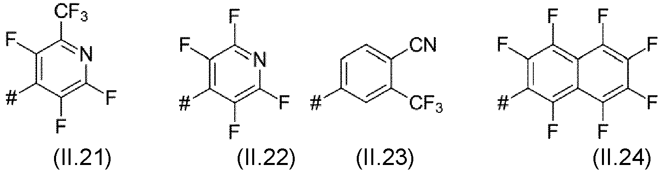 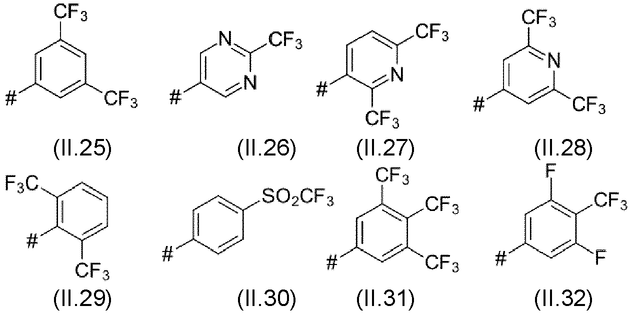 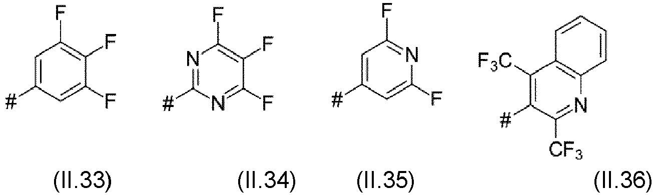 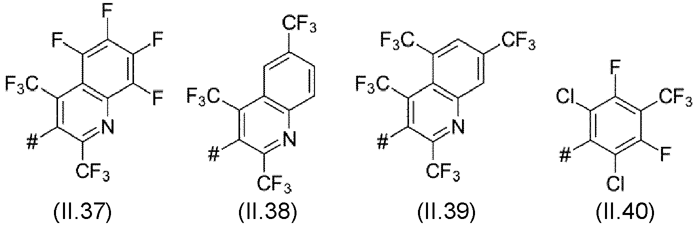 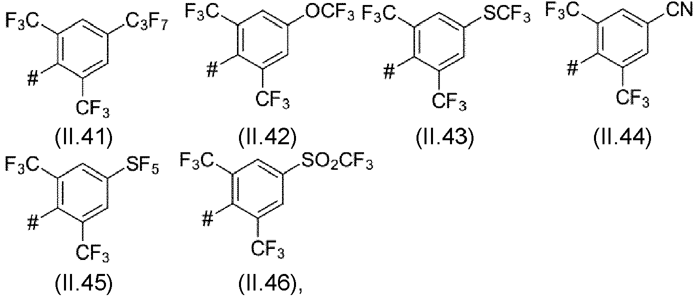 where # denotes the bond to the remaining molecule of formula (I),
wherein in compounds of formula (I) R^{E}, and R^{F} are independently selected from one of the formulas (11.1) - (11.46): 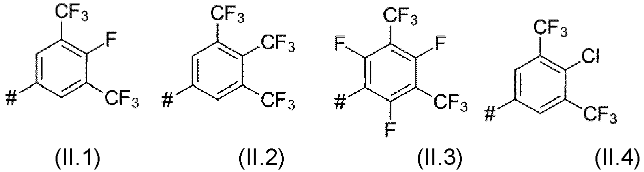 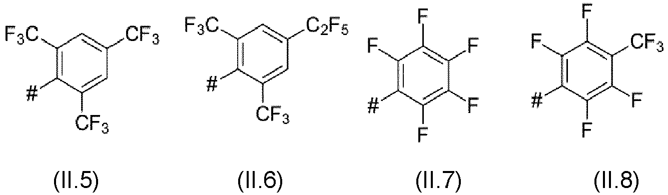 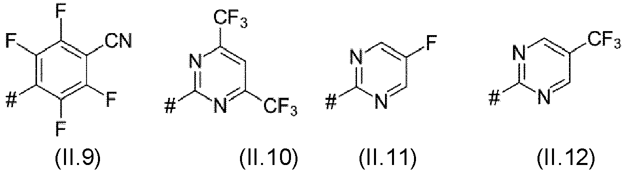 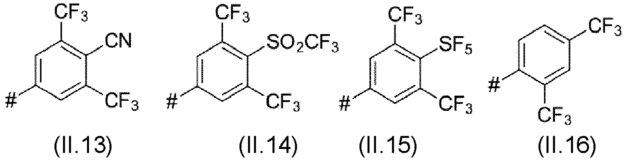 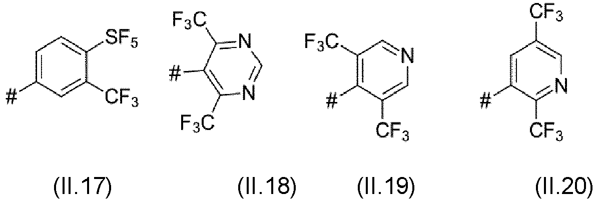 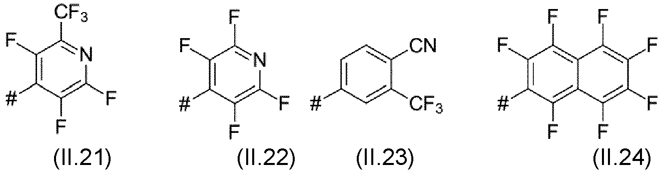 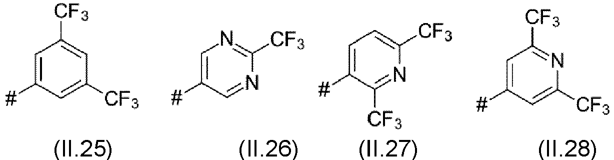 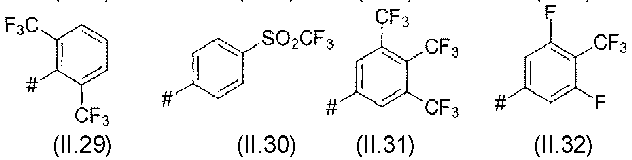 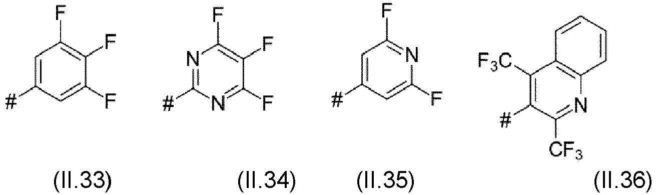 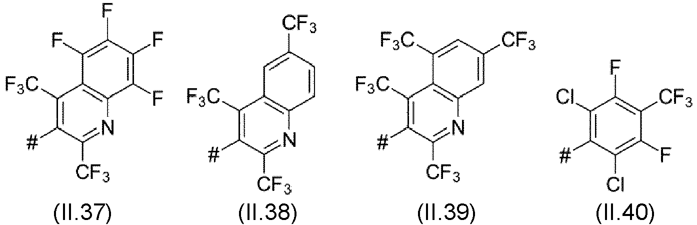 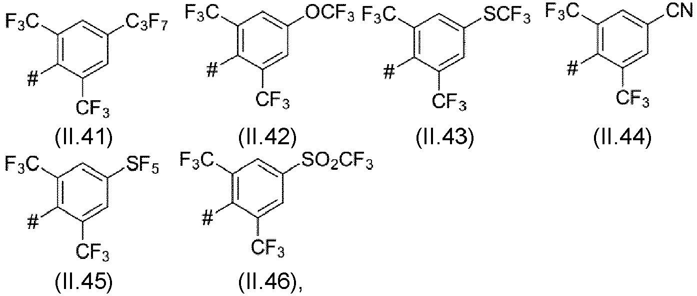 where # denotes the bond to the remaining molecule of formula (I),
   with the proviso that 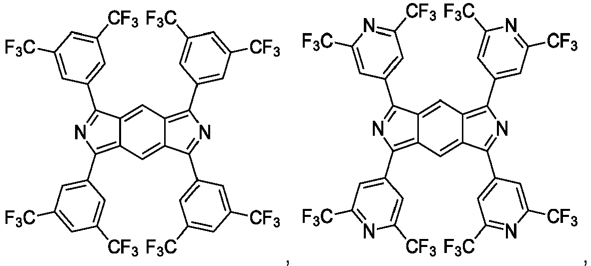 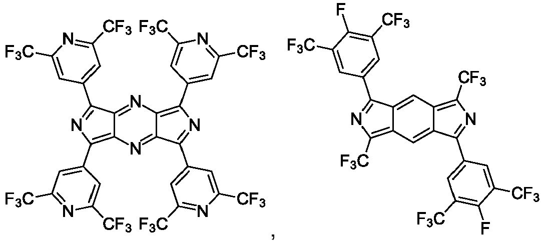 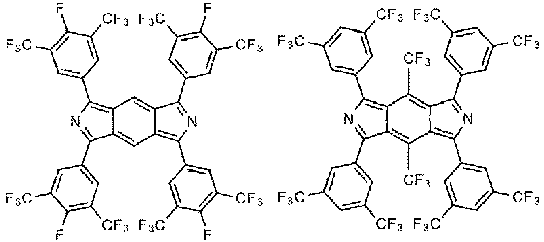
are excluded.

In a preferred embodiment, the electronic component comprises a compound of formula (I), wherein X^{A} and X^{B} are C-H.

In one embodiment of the electronic component, the electronic component comprises compounds of formula (I), which are selected from a compound of the following formulae (1.1) - (1.7): 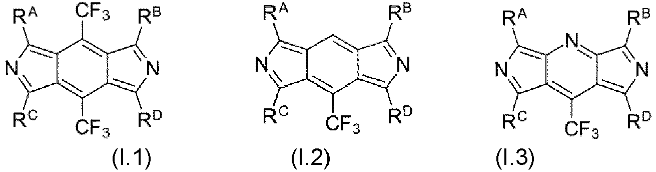 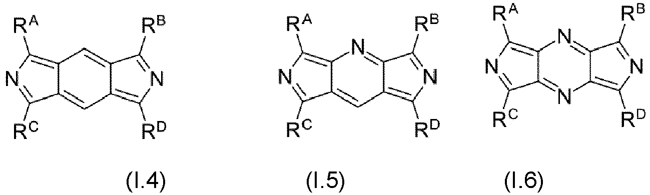 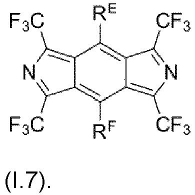
wherein R^{A}, R^{B}, R^{C}, and R^{D} are independently selected from the formulas (11.1) to (11.46) as defined herein,
wherein R^{E}, and R^{F} are independently selected from the formulas (11.1) to (11.46) as defined herein.

In a preferred embodiment the electronic component comprises a compound of formula (I) which is selected from formulae (1.1.01), (1.1.02), (1.1.03), (1.1.04), (1.1.05), (1.1.06), (1.1.07), (1.1.08), (1.1.09), (1.1.10), (1.1.11), (1.1.12), (1.1.13), (1.1.14), (1.1.15), (1.1.16),
(1.1.17), (1.1.18), (1.1.19), (1.1.20), (1.1.21), (1.1.22), (1.1.23), (1.1.24), (1.1.25), (1.1.26), (1.1.27), (1.1.28), (1.1.29), (1.1.30), (1.1.31), (1.1.32), (1.1.33), (1.1.34), (1.1.35), (1.1.36), (1.1.37), (1.1.38), (1.1.39), and (1.1.40) as defined herein and/or
(1.2.01), (I.2.02), (I.2.03), (I.2.04), (1.2.05), (I.2.06), (I.2.07), (I.2.08), (I.2.09), (1.2.10), (1.2.11), (1.2.12), (1.2.13), (1.2.14), (1.2.15), (1.2.16), (1.2.17), (1.2.18), (1.2.19), (I.2.20), (1.2.21), (I.2.22), (I.2.23), (I.2.24), (I.2.25), (I.2.26), (I.2.27), (I.2.28), (I.2.29), (I.2.30), (1.2.31), (1.2.32), (I.2.33), (I.2.34), (I.2.35), (I.2.36), (I.2.37), (I.2.38), (I.2.39), (I.2.40), and (1.2.41) as defined herein and/or
(1.3.01), (1.3.02), (1.3.03), (1.3.04), (1.3.05), (1.3.06), (I.3.07), (1.3.08), (1.3.09), (1.3.10), (1.3.11), (1.3.12), (1.3.13), (1.3.14), (1.3.15), (1.3.16), (1.3.17), (1.3.18), (1.3.19), (1.3.20), (1.3.21), (1.3.22), (1.3.23), (1.3.24), (1.3.25), (1.3.26), (1.3.27), (1.3.28), (1.3.29), (1.3.30), (1.3.31), (1.3.32), (1.3.33), (1.3.34), (1.3.35), (1.3.36), (1.3.37), (1.3.38), (1.3.39), (1.3.40), and (1.3.41) as defined herein and/or
(1.4.01), (I.4.02), (1.4.03), (I.4.04), (I.4.05), (I.4.06), (I.4.07), (1.4.08), (I.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (I.4.23), (I.4.24), (I.4.25), (I.4.26), (I.4.27), (I.4.28), (I.4.29), (I.4.30), (1.4.31), (1.4.32), (I.4.33), (I.4.34), (I.4.35), (I.4.36), (1.4.37), and (I.4.38) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), (1.5.28), (1.5.29), (1.5.30), (1.5.31), (1.5.32), (1.5.33), (1.5.34), (1.5.35), (1.5.36), (1.5.37), (1.5.38), (1.5.39), (1.5.40), and (1.5.41) as defined herein and/or
(1.6.01), (I.6.02), (I.6.03), (I.6.04), (1.6.05), (I.6.06), (I.6.07), (I.6.08), (I.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), (I.6.28), (I.6.29), (I.6.30), (1.6.31), (1.6.32), (I.6.33), (I.6.34), (I.6.35), (I.6.36), (I.6.37), (I.6.38), (I.6.39), and (I.6.40) as defined herein and/or
(1.7.01), (1.7.02), (1.7.03), (1.7.04), (1.7.05), (1.7.06), (1.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), (1.7.26), (1.7.27), (1.7.28), (1.7.29), (1.7.30), (1.7.31), (1.7.32), (1.7.33), (1.7.34), (1.7.35), (1.7.36), (1.7.37), (1.7.38), (1.7.39), and (1.7.40) as defined herein.

A plurality of electronic components or equipment containing them can be produced using the organic compounds in accordance with the invention. In particular, the doping agents in accordance with the invention can be used to produce organic, light-emitting diodes (OLED), organic solar cells, organic diodes or organic field effect transistors. The conductivity of the doped layers and/or the improvement of the charge carrier injection or extraction at the contacts can be improved by the doping agents in accordance with the invention.

Preferred is an electronic component, which comprises an organic semi-conductive matrix material that is doped with at least one doping agent for changing the electronic properties of the semi-conductive matrix material using at least one at least one compounds of formula (I), in particular compounds of formulae (1.1), (1.2), (1.3), (1.4), (1.5), (1.6), and (I.7), preferably compounds of formulae (1.1.01), (1.1.02), (1.1.03), (1.1.04),
(1.1.05), (1.1.06), (1.1.07), (1.1.08), (1.1.09), (1.1.10), (1.1.11), (1.1.12), (1.1.13), (1.1.14), (1.1.15), (1.1.16), (1.1.17), (1.1.18), (1.1.19), (1.1.20), (1.1.21), (1.1.22), (1.1.23), (1.1.24), (1.1.25), (1.1.26), (1.1.27), and (1.1.28) as defined herein
   and/or
(1.2.01), (I.2.02), (I.2.03), (1.2.04), (1.2.05), (I.2.06), (I.2.07), (I.2.08), (I.2.09), (1.2.10), (1.2.11), (1.2.12), (1.2.13), (1.2.14), (1.2.15), (1.2.16), (1.2.17), (1.2.18), (1.2.19), (I.2.20), (1.2.21), (I.2.22), (I.2.23), (I.2.24), (I.2.25), (I.2.26), (I.2.27), and (1.2.28) as defined herein and/or
(1.3.01), (1.3.02), (1.3.03), (1.3.04), (1.3.05), (1.3.06), (1.3.07), (1.3.08), (1.3.09), (1.3.10), (1.3.11), (1.3.12), (1.3.13), (1.3.14), (1.3.15), (1.3.16), (1.3.17), (1.3.18), (1.3.19), (1.3.20), (1.3.21), (1.3.22), (1.3.23), (1.3.24), (1.3.25), (1.3.26), (1.3.27), and (1.3.28) as defined herein and/or
(1.4.01), (1.4.02), (I.4.03), (I.4.04), (I.4.05), (1.4.06), (1.4.07), (I.4.08), (I.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (I.4.23), (I.4.24), (I.4.25), (I.4.26), (I.4.27), and (I.4.28) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), and (1.5.28) as defined herein and/or
(1.6.01), (I.6.02), (I.6.03), (1.6.04), (I.6.05), (I.6.06), (I.6.07), (I.6.08), (1.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), and (I.6.28) as defined herein and/or
(1.7.01), (1.7.02), (1.7.03), (1.7.04), (1.7.05), (1.7.06), (1.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), and (I.6.26) as defined herein.

### Matrix materials

The present invention describes suitable doping agents for organic semiconductive materials such as hole transport materials (HTMs) that are customarily used in OLEDs or organic solar cells. The semiconductive materials are preferably intrinsically hole-conducting. The following gives an exemplary description of materials that can be applied in conjunction with doping agents of the compounds according to the invention.

Another aspect of the invention is a doped semiconductor layer comprising at least one electron donor, which can also be referred to as organic matrix compound, and at least one doping agent, wherein the doping agent is one or more compounds of formula (I), in particular compounds of formulae (1.1), (1.2), (1.3), (1.4), (1.5), (1.6), and (1.7), preferably compounds of formulae (1.1.01), (1.1.02), (1.1.03), (1.1.04), (1.1.05), (1.1.06), (1.1.07), (1.1.08), (1.1.09), (1.1.10), (1.1.11), (1.1.12), (1.1.13), (1.1.14), (1.1.15), (1.1.16), (1.1.17), (1.1.18), (1.1.19), (1.1.20), (1.1.21), (1.1.22), (1.1.23), (1.1.24), (1.1.25), (1.1.26), (1.1.27), (1.1.28), (1.1.29), (1.1.30), (1.1.31), (1.1.32), (1.1.33), (1.1.34), (1.1.35), (1.1.36), (1.1.37), (1.1.38), (1.1.39), and (1.1.40) as defined herein and/or
(1.2.01), (1.2.02), (I.2.03), (I.2.04), (I.2.05), (1.2.06), (I.2.07), (I.2.08), (I.2.09), (1.2.10), (1.2.11), (1.2.12), (1.2.13), (1.2.14), (1.2.15), (1.2.16), (1.2.17), (1.2.18), (1.2.19), (I.2.20), (1.2.21), (I.2.22), (I.2.23), (I.2.24), (I.2.25), (I.2.26), (I.2.27), (I.2.28), (I.2.29), (I.2.30), (1.2.31), (1.2.32), (I.2.33), (I.2.34), (I.2.35), (I.2.36), (I.2.37), (I.2.38), (I.2.39), (I.2.40), and (1.2.41) as defined herein and/or
(1.3.01), (1.3.02), (1.3.03), (1.3.04), (1.3.05), (1.3.06), (1.3.07), (1.3.08), (1.3.09), (1.3.10), (1.3.11), (1.3.12), (1.3.13), (1.3.14), (1.3.15), (1.3.16), (1.3.17), (1.3.18), (1.3.19), (1.3.20), (1.3.21), (1.3.22), (1.3.23), (1.3.24), (1.3.25), (1.3.26), (1.3.27), (1.3.28), (1.3.29), (1.3.30), (1.3.31), (1.3.32), (1.3.33), (1.3.34), (1.3.35), (1.3.36), (1.3.37), (1.3.38), (1.3.39), (1.3.40), and (1.3.41) as defined herein and/or
(1.4.01), (I.4.02), (I.4.03), (I.4.04), (1.4.05), (I.4.06), (I.4.07), (I.4.08), (I.4.09), (1.4.10), (1.4.11), (1.4.12), (1.4.13), (1.4.14), (1.4.15), (1.4.16), (1.4.17), (1.4.18), (1.4.19), (I.4.20), (1.4.21), (I.4.22), (I.4.23), (I.4.24), (I.4.25), (I.4.26), (I.4.27), (I.4.28), (1.4.29), (I.4.30), (1.4.31), (1.4.32), (I.4.33), (1.4.34), (I.4.35), (I.4.36), (I.4.37), and (1.4.38) as defined herein and/or
(1.5.01), (1.5.02), (1.5.03), (1.5.04), (1.5.05), (1.5.06), (1.5.07), (1.5.08), (1.5.09), (1.5.10), (1.5.11), (1.5.12), (1.5.13), (1.5.14), (1.5.15), (1.5.16), (1.5.17), (1.5.18), (1.5.19), (1.5.20), (1.5.21), (1.5.22), (1.5.23), (1.5.24), (1.5.25), (1.5.26), (1.5.27), (1.5.28), (1.5.29), (1.5.30), (1.5.31), (1.5.32), (1.5.33), (1.5.34), (1.5.35), (1.5.36), (1.5.37), (1.5.38), (1.5.39), (1.5.40), and (1.5.41) as defined herein and/or
(1.6.01), (1.6.02), (I.6.03), (I.6.04), (I.6.05), (I.6.06), (1.6.07), (I.6.08), (I.6.09), (1.6.10), (1.6.11), (1.6.12), (1.6.13), (1.6.14), (1.6.15), (1.6.16), (1.6.17), (1.6.18), (1.6.19), (I.6.20), (1.6.21), (I.6.22), (I.6.23), (I.6.24), (I.6.25), (I.6.26), (I.6.27), (I.6.28), (I.6.29), (I.6.30), (1.6.31), (1.6.32), (I.6.33), (I.6.34), (I.6.35), (I.6.36), (I.6.37), (I.6.38), (I.6.39), and (I.6.40) as defined herein and/or
(1.7.01), (1.7.02), (1.7.03), (1.7.04), (1.7.05), (1.7.06), (I.7.07), (1.7.08), (1.7.09), (1.7.10), (1.7.11), (1.7.12), (1.7.13), (1.7.14), (1.7.15), (1.7.16), (1.7.17), (1.7.18), (1.7.19), (1.7.20), (1.7.21), (1.7.22), (1.7.23), (1.7.24), (1.7.25), (1.7.26), (1.7.27), (1.7.28), (1.7.29), (1.7.30), (1.7.31), (1.7.32), (1.7.33), (1.7.34), (1.7.35), (1.7.36), (1.7.37), (1.7.38), (1.7.39), and (1.7.40) as defined herein.

According to the invention, a doped semiconductor layer is a combination of two substances or two compounds, in particular, of an organic matrix compound, and at least one doping agent. The doping agent serves as an electron acceptor.

The matrix material can consist partially (> 10 or > 25% by weight) or substantially (> 50 % by weight or > 75% by weight) or totally of a metal phthalocyanine complex, a porphyrine complex, especially metal porphyrine complex, oligothiophene-, oligophenyl-, oligophenylene vinylene- or oligofluorene compound, in which the oligomer preferably comprises 2-500 or more, preferably 2-100 or 2-50 or 2-10 or more monomeric units. The oligomer can also comprise > 4, > 6 or > 10 or more monomeric units, in particular also for the above-indicated ranges, thus, e.g., 4 or 6-10 monomeric units, 6 or 10-100 monomeric units or 10-500 monomeric units. Polymeric matrix materials can also be used. The monomers and oligomers can be substituted or unsubstituted and even block- or mixed polymerizates of the cited oligomers can be present as well as a compound with a triarylamine unit or a spiro-bifluorene compound. The cited matrix materials can also be present in combination with each other, optionally also in combination with other matrix materials. The matrix materials can have electron-donating substitutents such as alkyl- or alkoxy groups that have a reduced ionizing energy or reduce the ionizing energy of the matrix material.

The metal phthalocyanine complexes or porphyrine complexes used as matrix material can have a main group metal atom or subgroup metal atom. The metal atom Me can be coordinated 4-, 5- or 6-fold, e.g., in the form of oxo(Me=O), dioxo- (O=Me=O) imine-, diimine-, hydroxo-, dihydroxo-, amino- or diamino complexes, without being limited to them. The phthalocyanine complex or porphyrine complex can each be partially hydrogenated, however, the mesomeric ring system is preferably not disturbed. The phthalocyanine can contain, e.g., magnesium, zinc, iron, nickel, cobalt, magnesium, copper or vanadyl (=VO) as central atom. The same or other metal atoms or oxometal atoms can be present in the case of porphyrine complexes.

In one preferred embodiment the matrix compound is either selected from phthalocyanine metal (Me) complexes (MePc) or triarylamino based or thiopheno based hole transport materials (HTM).

In particular, such dopable hole transport materials HTM can be arylated benzidines, e.g., N,N'-perarylated benzidines or other diamines such as of the type TPD (in which one, several or all of the aryl groups can have aromatic heteroatoms), suitable arylated starburst compounds such as N,N',N"-perarylated starburst compounds such as the compound TDATA (in which one, several or all of the aryl groups can have aromatic heteroatoms). The aryl groups can comprise phenyl, naphthyl, pyridine, quinoline, isoquinoline, peridazine, pyrimidine, pyrazine, pyrazole, imidazole, oxazole, furan, pyrrole, indole or the like, especially for each of the above-cited compounds. The phenyl groups of the particular compounds can be partially or completely replaced by thiophene groups.

It is understood that even other suitable organic matrix materials/matrix compounds, in particular hole-conducting materials can be used that have semi-conductive properties.

In particular matrix /matrix comprises at least one matrix compound and at least one compound of the formula (I), wherein the matrix compound is selected from4,4',4"-tris(N-(2-naphthyl)-N-phenyl-amino)triphenylamine (2-TNATA), 4,4',4"-tris(N-3-methylphenyl-N-phenyl-amino)triphenylamine (m-MTDATA), N,N,N',N'-tetrakis(4-methoxy-phenyl)benzidine (MeO-TPD), (2,2',7,7'-tetrakis-(N,N-diphenylamino)-9,9'-spirobifluorene (spiro-TTB), N,N'-bis(naphthalen-1-yl)-N,N'-bis(phenyl)-benzidine, N,N'-bis(naphthalen-1-yl)-N,N'-bis(phenyl)-9,9-spiro-bifluorene, 9,9-bis[4-(N,N-bis-biphenyl-4-yl-amino)phenyl]-9H-fluorene, 2,2'-bis[N,N-bis(biphenyl-4-yl)amino]-9,9-spiro-bifluorene, N,N'-((9H-fluoren-9,9-diyl)bis(4,1-phenylen))bis(N-([1,1'-biphenyl]-4-yl)-[1,1'-biphenyl]-4-amine) (BPAPF), N,N'-bis(phenanthren-9-yl)-N,N'-bis(phenyl)-benzidine, 1,3,5-tris{4-[bis(9,9-dimethyl-fluoren-2-yl)amino]phenyl}benzene, tri(terphenyl-4-yl)amine, N-(4-(6-((9,9-dimethyl-9H-fluoren-2-yl)(6-methoxy-[1,1'-biphenyl]-3-yl)amino)-1,3,3-trimethyl-2,3-dihydro-1H-inden-1-yl)phenyl)-N-(6-methoxy-[1,1'-biphenyl]-3-yl)-9,9-dimethyl-9H-fluoren-2-amine, N-([1,1'-biphenyl]-4-yl)-N-(4-(6-([1,1'-biphenyl]-4-yl(9,9-dimethyl-9H-fluoren-2-yl)amino)-1,3,3-trimethyl-2,3-dihydro-1H-inden-1-yl)phenyl)-9,9-dimethyl-9H-fluoren-2-amine, N,N-di([1,1'-biphenyl]-4-yl)-3-(4-(di([1,1'-biphenyl]-4-yl)amino)phenyl)-1,1,3-trimethyl-2,3-dihydro-1H-inden-5-amine, N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-(4-(6-(9,9'-spirobi[fluoren]-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9'-spirobi[fluoren]-2-amine, N-(4-(6-(dibenzo[b,d]furan-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)dibenzo[b,d]furan-2-amine, 9-(4-(6-(9H-carbazol-9-yl)-1,3,3-trimethyl-2,3-dihydro-1H-inden-1-yl)phenyl)-9H-carbazole, N-([1,1'-biphenyl]-4-yl)-3-(4-([1,1'-biphenyl]-4-yl(4-methoxyphenyl)amino)phenyl)-N-(4-methoxyphenyl)-1,1,3-trimethyl-2,3-dihydro-1H-inden-5-amine, 3-(4-(bis(6-methoxy-[1,1'-biphenyl]-3-yl)amino)phenyl)-N,N-bis(6-methoxy-[1,1'-biphenyl]-3-yl)-1,1,3-trimethyl-2,3-dihydro-1H-inden-5-amine, N1-([1,1'-biphenyl]-4-yl)-N1-(4-(6-([1,1'-biphenyl]-4-yl(4-(diphenylamino)phenyl)amino)-1,3,3-trimethyl-2,3-dihydro-1H-inden-1-yl)phenyl)-N4,N4-diphenylbenzene-1,4-diamine, N,N-di([1,1'-biphenyl]-4-yl)-4'-(6-(4-(di([1,1'-biphenyl]-4-yl)amino)phenyl)-1,3,3-trimethyl-2,3-dihydro-1H-inden-1-yl)-[1,1'-biphenyl]-4-amine, N-(4-(5-(bis(9,9-dimethyl-9H-fluoren-2-yl)amino)-1,3,3-trimethyl-2,3-dihydro-1 H-inden-1-yl)phenyl)-N-(9,9-dimethyl-9H-fluoren-2-yl)-9,9-dimethyl-9H-fluoren-2-amine, N-(4-(6-(bis(9,9-dimethyl-9H-fluoren-2-yl)amino)-1,3,3-trimethyl-2,3-dihydro-1 H-inden-1-yl)phenyl)-N-(9,9-dimethyl-9H-fluoren-2-yl)-9,9-dimethyl-9H-fluoren-2-amine, N,N'-bis(9,9-dimethyl-fluoren-2-yl)-N,N'-diphenyl-benzidine (BF-DPB), N,N'-((9H-fluorene-9,9-diyl)bis(4,1-phenylene))bis(N-([1,1'-biphenyl]-4-yl)-[1,1'-biphenyl]-4-amine) (BPAPF), N4,N4,N4',N4'-tetrakis(9,9-dimethyl-9H-fluoren-2-yl)-[1,1'-biphenyl]-4,4'-diamine (TDM FB), N-([1,1'-biphenyl]-2-yl)-N-(9,9-dimethyl-9H-fluoren-2-yl)-9,9'-spirobi[fluoren]-2-amine, (2,7-bis[N,N-bis(4-methoxyphenyl)amino]-9,9-spirobi[9*H*-fluorene] (spiro-MeO-TPD), a mixture of N-(4-(5-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine and N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-([1,1'-biphenyl]-4-yl)-9,9-dimethyl-N-(4-(9-phenyl-9H-carbazol-3-yl)phenyl)-9H-fluoren-2-amine and mixtures thereof.

### Doping

The doping can take place in particular in such a manner that the molar ratio of matrix molecule to doping agent, or in the case of oligomeric matrix materials the ratio of matrix monomer number to doping agent, is in the range from 1:100000 to 1:2, preferably in the range from 1:10000 to 1:1, especially preferably in the range from 1:5 to 1:1000, e.g., in the range from 1:10 to 1:100, e.g., in the range from 1:50 to 1:100 or in the range from 1:25 to 1:50.

### Evaporation of the doping agents and preparation of the doped semiconductor layer

The doping of the particular matrix material (either indicated here as hole-conducting matrix material HTM or as electron-conducting material ETM) with the doping agents to be used in accordance with the invention can be produced by one or a combination of the following processes:
a) Mixed evaporation in the vacuum with a source for HTM or ETM and one for the doping agent.
b) Sequential deposition of HTM or ETM and doping agent with subsequent inward diffusion of the doping agent by thermal treatment
c) Doping of an HTM layer or ETM layer by a solution of doping agent with subsequent evaporation of the solvent by thermal treatment
d) Surface doping of an HTM layer or an ETM layer by a layer of doping agent applied on either or both surfaces of the HT layer.
e) Making a solution of host and dopant and form a film from the solution for instance by coating, casting or printing techniques or other film making techniques known to a person skilled in the art.

The deposition rate on a substrate with the compound used in accordance with the invention can be determined, e.g., using a quartz thickness monitor, as is customarily used, e.g., in the production of OLEDs. In particular, the ratio of the deposition rates of matrix materials and doping agent can be measured by independent measurements of them using two separate quartz thickness monitors in order to adjust the doping ratio.

It is understood that the compounds used in accordance with the invention are preferably such that they evaporate more or less or practically non-decomposed. However, if necessary, even purposeful precursors can be used as doping source that release the compounds used in accordance with the invention, e.g., acid addition salts, e.g., of a volatile or non-volatile inorganic or organic acid, or their charge transfer complexes, which acids and/or electron donors are preferably not volatile or only slightly volatile or the charge transfer complex itself acts as doping agent.

The doping agent used according to the invention is preferably selected in such a manner that the semiconductive organic material doped with it still has ≥20%, preferably ≥30%, especially preferably ≥50% or 60% of the conductivity (s/cm) of the value at 100°C after a temperature change of 100°C to RT (20°C).

Preferred is a method for the preparation of a doped layer according to the invention of a doped layer, which preferably has been prepared by the method according to the invention, wherein the doped matrix material is heated at a temperature of at least 50-120°C, preferably 80°-105°C, for a time of 1 - 500 minutes, preferably 5 to 200 minutes, more preferably 10 - 150 minutes, even more preferably 20 - 50 minutes.

Annealing of the deposited layers by heating, preferably at temperatures between 50°C and 120°C, preferably for 1 to 200 min, can advantageously further increase the conductivity of the doped semiconductor layer.

The doping can take place in such a manner that the doping agent is evaporated out of a precursor compound that releases the doping agent under heating and/or irradiation. The irradiation can take place by electromagnetic radiation, especially visible light, UV light or IR light, e.g., by laser light or also by other radiation types. The heat necessary for evaporation can substantially be made available by the irradiation and can also be radiated in a purposeful manner into certain bands of the compounds or precursors or compound complexes such as charge transfer complexes to be evaporated in order to facilitate the evaporation of the compounds by dissociation of the complexes by conversion into excited states. It is understood that the evaporation conditions described in the following are directed to those without irradiation and that uniform evaporation conditions are to be used for purposes of comparison.

For example, the following can be used as precursor compounds:
a) Mixtures or stoichiometric or mixed crystalline compounds of the doping agent and an inert, non-volatile substance, e.g., a polymer, molecular sieve, aluminum oxide, silica gel, and oligomers or another organic or inorganic substance with high evaporation temperature, in which the doping agent is bound primarily by van der Waals forces and/or hydrogen bridge bonding to this substance.
b) Mixture or stoichiometric or mixed crystalline compound of the doping agent and one non-volatile compound V more or less of the electron donor type, in which a more or less complete charge transfer occurs between the doping agent and the compound V as in charge transfer complexes with more or less electron-rich polyaromatics or heteroaromatics or another organic or inorganic substance with high evaporation temperature.
c) Mixture or stoichiometric or mixed crystalline compound of the doping agent and a substance that evaporates together with the doping agent and has the same or higher ionizing energy as the substance HT to be doped, so that the substance does not form a trap for holes in the organic matrix material. According to the invention the substance can also be identical to the matrix material here, e.g., be a metal phthalocyanine or benzidine derivative. Further suitable volatile co-substances such as hydroquinones, 1,4-phenylene diamines or 1-amino-4-hydroxybenzene or other compounds form quinhydrones or other charge transfer complexes.

### EXAM PLES

The following examples illustrate the invention without limiting it in any way.

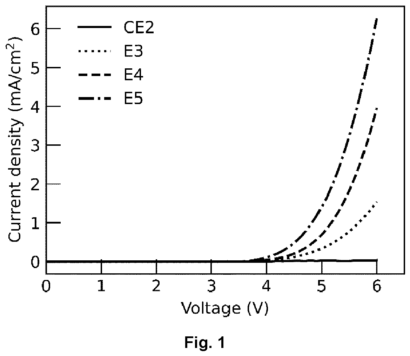

Figure 1: Diagram shows a current voltage characteristic.

### Sample preparation and conductivity measurement

### Synthesis of Example C4

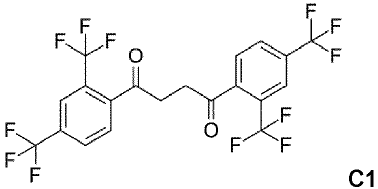

The compound **C1** was prepared according to the procedure for synthesizing 1,4-diketones in: Chem. Sci., 2020,11, 6370-6382

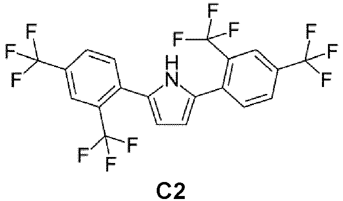

Compound **C1** (19.7 g, 38.6 mmol) and ammonium acetate (5.95 g, 77.2 mmol) were dissolved in EtOH (160 mL) and heated to reflux for 1.5 h.

The solvent was removed under reduced pressure and brine (100 mL) and CH₂Cl₂ (200 mL) were added. The organic layer was isolated and the aqueous layer was washed with CH₂Cl₂ (2x100 mL).

The solvent was removed under reduced pressure and the crude product recrystallized from toluene to give 15.5 g (78%) of the title compound **C2.**
**APCI-MS:** m/z = 491.9 [M+H]⁺

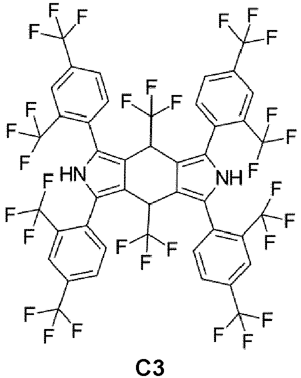

To a mixture of diarylpyrrole **C2** (8.95 g, 18.22 mmol) in borontrifluoride etherate (70 mL) was added trifluoroacetaldehyde methyl hemiacetal (90%, 6.0 mL, 7.9 mmol, 54.7 mmol) under an argon atmosphere. The mixture was stirred at 60 °C over 1 day and was then poured into ice. The mixture was neutralized with sodium bicarbonate and then extracted twice with ethyl acetate. The solvent was removed and the residue was washed with petroleum ether. The crude product was recrystallized from chlorobenzene to obtain compound **C3** (3.50 g, 3.06 mmol, 34 %) as colorless solid. **APCI-MS:** m/z = 1142.9 [M+H]⁺

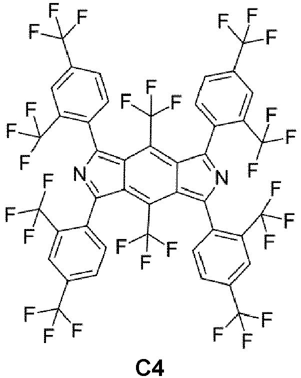

To a mixture of compound **C3** (2.34 g, 2.05 mmol), cesium carbonate (6.67 g, 20.47 mmol), azobisisobutyronitrile (6.7 mg, 40.8 µmol) and sodium iodide (25.0 mg, 166.8 µmol) in benzotrifluoride (34 mL) was added sulfuryl chloride (0.50 mL, 0.84 g, 6.22 mmol) under an argon atmosphere. The mixture was stirred 2 days at 80 °C and then 1 day at 100 °C. The reaction mixture was allowed to cool to room temperature and the solids were filtered off and washed with benzotrifluoride (5 mL). Through the dark green solution was bubbled dry nitrogen over 3 days to remove the solvent. The material was subjected to high vacuum sublimation (1.5 × 10⁻⁶ mbar, 190 °C) to obtain compound **C4** (373.0 mg, 327.6 µmol, 16 %) as a greenish black solid.
**APCI-MS:** m/z = 1138.9 [M+H]⁺

To determine the evaporation temperature, 15 mg of the material was filled in an aluminum oxide crucible of a point source and heated in a vacuum chamber (base pressure <5 × 10-7 mbar) at 5 K/min until an evaporation rate of 0.3 Å/s is reached. The evaporation rate is monitored with a quartz crystal microbalance (QCM). The rate is kept constant for 10 min by controlling the heating and the evaporation temperature is determined by measuring the temperature at the bottom of the crucible with a thermocouple.

To achieve stable evaporation rates and to avoid cross contamination in mass production of organic electronic devices, such as OLEDs or organic solar cells, it is advantageous to use materials with a high evaporation temperature of at least above 120°C.

For the measurement of the **lateral conductivity,** a transmission line method was used. Interdigitated ITO (indium tin oxide) electrodes were formed by photolithography on a glass substrate with four different channel lengths (40 µm, 80 µm, 120 µm, 160 µm). Then organic layers were deposited by thermal evaporation under ultrahigh vacuum conditions (base pressure <5 × 10-7 mbar) by controlling the evaporation rates with quartz crystal microbalances (QCMs). First, a 10 nm thick p-doped layer was prepared by co-evaporation of the p-dopant and the semiconductor matrix material. To obtain a specific dopant concentration, the individual deposition rates were controlled with independent QCMs. These films were covered with 100 nm of intrinsic semiconductor matrix material to mimic the typical layer stack (common hole-injection layer + common hole-transport layer) in OLED display. Samples were encapsulated with glass lid and getter material under nitrogen atmosphere and characterized ex-situ at room temperature. Current-voltage characteristics (-10 V to 10 V) were measured using a source-measure unit Keithley 2400 and the lateral conductivity was determined from the slope of the resistance vs. channel length plot and by normalizing to the thickness of the p-doped layer, accounting for almost the entire current.

Compound C4 was found to have an evaporation temperature of 161 °C at 0.3 Å/s, when determined as described above. This temperature is well suited for mass production of electronic components, such as OLEDs or organic solar cells. Dynamic scanning calorimetry (DSC) was conducted in a Mettler Toledo DSC3 with an Aluminum crucible weighing in 2 mg of analyte at a heating rate of 5K / min between RT and 400°C under a nitrogen atmosphere. For compound C4. The exothermic decomposition onset was >250°C. The thermostability gap of more than 20 K, i.e. the difference between the evaporation temperature at 0.3 Å/s, when determined as described above, and the onset of decomposition as measured with DSC of more than 20 K, is advantageous for mass production.

As semiconductor matrix material, HT-1 (N-([1,1'-Biphenyl]-4-yl)-9,9-dimethyl-N-(4-(9-phenyl-9H-carbazol-3-yl)phenyl)-9H-fluoren-2-amine) and HT-2 (N-(9,9-Diphenyl-9H-fluoren-2-yl)-N,9-diphenyl-9H-carbazol-3-amine) were used. HT-1 and HT-2 have a HOMO level of about -5.15 eV and -5.08 eV, respectively, wherein the HOMO level is measured by cyclic voltammetry as described herein. Hole transport materials with a shallow HOMO > -5.2 eV, when determined by cyclic voltammetry as described herein, are typically used in OLED displays to ensure a good energy level alignment with the anode.

The HOMO level was determined by cyclic voltammetry measured with a platinum working and counter electrode, an Ag/AgCI reference electrode and Ferrocene/Ferrocenium as an internal standard and a scan rate of 0.1V/s. As electrolyte, acetonitrile with 0.1M tetrabutylammonium hexafluorophosphate was used. The HOMO level was calculated from E(HOMO) = -4.79 eV - E_{1/2}(oxidation vs. Fc/Fc+).

### Conductivity test

To optimize the electrical performance of an organic electronic component, particularly the voltage, it is beneficial that the conductivity of the doped semiconductor layer exceeds a certain value depending on the device structure and the application. For OLEDs, the hole injection layer usually needs to have a conductivity above 1E-06 S/cm to enable a low operating voltage.

**Table 1**

| p-Dopant | HTM | Dopant concentration (vol%) | Lateral conductivity in S/cm |
|---|---|---|---|
| none | HT-1 | 0 | <1E-8 |
| C4 | HT-1 | 2 | **3.26E-06** |
| C4 | HT-1 | 8 | **8.62E-06** |
| none | HT-2 | 0 | <1E-8 |
| C4 | HT-2 | 2 | **1.31E-06** |
| C4 | HT-2 | 8 | **4.30E-06** |

Table 1 shows that the conductivities of both HT-1 and HT-2 doped with C4 increase with increasing dopant concentration and are significantly higher than for the undoped layers. This proves that C4 can advantageously be used as a p-dopant. The conductivities of both HT-1 and HT-2 obtained at 2 vol% and 8 vol% doping with C4 are above 1E-6 S/cm, and therefore, C4 should be suitable for use in OLEDs or organic solar cells.

As the determined conductivities are below 1E-3 S/cm, doping of hole transport materials with this dopant can even allow desirable conductivities in displays. Advantageously, a doping with such a dopant can prevent pixel crosstalk which might be caused by too high conductivities (for example higher than 1E-3 S/cm or 1E-4 S/cm).

### OLED measurement

To verify this point, an OLED structure was prepared as follows. For Example 1, a glass substrate with pre-patterned 130 nm ITO anode was ultrasonically washed with dimethyl sulfoxide for 20 minutes, rinsed by Di-water for 5 minutes and ultrasonically washed with first Di-water and then with ethanol for 10 minutes. The substrate was then rinsed with Di-water and consequently dry-spined at 1500 rpm in a nitrogen stream, followed by oxygen plasma treatment to prepare the anode surface.

Then, 10 nm of HT-1 (9H-Fluoren-2-amine, N-[1,1'-biphenyl]-4-yl-9,9-dimethyl-N-[4-(9-phenyl-9H-carbazol-3-yl)phenyl]) doped with 4 vol% of C4 was vacuum deposited to form a hole-injection layer (HIL). Then, HT-1 was vacuum deposited on top of HIL to form hole transport layer (HTL) with a thickness of 100 nm. Then, an electron-blocking layer (EBL) was formed on the HTL by depositing 4-[Bis(1,1'-biphenyl-4-yl)amino]-4'-(9H-carbazol-9-yl)-1,1'-biphenyl with a thickness of 10 nm.

Then, a blue-emitting emission layer (EML) consisting of 97 vol% 2-Methyl-9,10-di-2-naphthalenylanthracene (MADN)as EML host and 3 vol% 4,4'-([1,1'-Biphenyl]-4,4'-diyldi-2,1-ethenediyl)bis[N,N-bis(4-methylphenyl)benzenamine (DPAVBi ) as fluorescent blue emitter dopant was vacuum deposited on the EBL with a thickness of 20 nm.

Then, a hole-blocking layer (HBL) was formed on the EML with a thickness of 10 nm by depositing 4,7-Diphenyl-1,10-phenanthroline (BPhen). The electron transport layer (ETL) was vacuum deposited on the HBL by co-evaporation of 4,7-Diphenyl-1,10-phenanthroline (BPhen) and Cs with a ratio of 1:1 and a thickness of 25 nm. Then, 100 nm of Al was deposited on the ETL to form a cathode layer.

The OLED structure was protected from ambient conditions by encapsulation glass lid that forms a cavity. This cavity contains a getter material, further ensuring the integrity and longevity of the OLED structure.

The OLED structure of Example 2 was prepared the same way as Example 1 but with 8 vol% of C4 instead of 4 vol%.

The OLED structure of Comparative Example 1 was prepared in the same way as Example 1, but the hole-injection layer does not contain a p-dopant.

The electro-optical performance parameters of the OLEDs were measured at the room temperature. The current-voltage characteristic is measured using source-measure unit Keithley 2400. The voltage is applied with the step of 0.1 V in the range from -2 V to 6 V. Current through the OLED device is detected at each voltage step. The light intensity is measured by the spectrometer CAS 140 CT. Additionally, the OLED light intensity is detected by the photodiode at each voltage step, the signal of which is sensed by another source-measure unit Keithley 2400. The OLEDs are further measured in the integrating sphere to calculate absolute external quantum efficiency. The integrating sphere is covered by a highly reflective white material so that all the emitted light from the OLED's hemisphere is collected by a detector. The OLEDs are measured in the same way as explained above. The intensity is measured with the spectrometer OceanOptics USB 4000 and the photodiode.

**Table 2**

| | p-Dopant | Dopant concentration (vol%) | Voltage [V] at 10 mA/cm² | Current efficiency [cd/A] at 10 mA/ cm² | External quantum efficiency [%] at 10 mA/ cm² | Power efficiency [lm/W] at 10 mA/ cm² |
|---|---|---|---|---|---|---|
| Comparative Example 1 | none | 0 | 5.85 | 9.43 | 7.56 | 7.10 |
| Example 1 | C4 | 4 | 4.59 | 11.84 | 7.93 | 9.45 |
| Example 2 | C4 | 8 | 3.77 | 12.65 | 8.03 | 11.86 |

Table 2 shows the technical effect. OLED structures comprising Compound C4 as p-dopant in the hole-injection layer have a significantly reduced driving voltage, better current efficiency and external quantum efficiency compared to components without p-dopant. Moreover, the power efficiency is considerably higher for the samples with the C4 compared to Comparative example 1. This advantageously results in lower power consumption, which is particularly relevant for battery-operated mobile applications.

### Pn-junction measurement

To test if compounds of formula (I) are suitable for an application in pn-junctions, i.e., in charge-generation layers (CGLs) of stack OLEDs, in particular tandem, triple, or quadruple OLEDs, pn test-structures can be used as described in, e.g., US 10,581,001 B2 or in J. Phys. Chem. C 2013, 117, 27, 13887-13893. These structures imitate the typical layer sequence comprised in stack OLEDs.

The test structure imitates the polarity of a tandem OLED. However, it excludes the charge injection at the electrodes. Hence, materials are chosen in a way that the energy barrier between the anode and first layer prevents hole injection, and the energy barrier between the cathode and last layer prevents electron injection. Thus, electrical current above the leakage level can only flow if charges are generated at the interface of the pn-junction, which is attributed to the so-called tunnel effect. When high tunnel currents occur, they initiate the so-called CGL effect, which is utilized in tandem, triple, or quadruple OLED structures.

The pn test-structures for Example 3 E3 and Example 4 E4 were fabricated as follows. The glass substrate with pre-structure ITO anode is prepared and cleaned in the same way as an Example 1. The ETL was formed on the ITO anode by vacuum deposition of Diphenyl-9,9'-spirobi[9H-fluoren]-2-ylphosphine oxide (SPPO1)with a thickness of 50 nm. Then, 15 nm of 9,9-Spirobifluoren-2-yl-diphenyl-phosphine oxide doped with 1 vol% of Yb was vacuum deposited as n-doped CGL. This is followed by p-doped CGL, consisting of 10 nm of HT-1 doped with 8 vol% of C4 for Example 3 E3 or 16 vol% of C4 for Example 4 E4. Then, 50 nm of HT-1 was vacuum deposited on p-doped CGL forming an HTL. A cathode layer of Al with a thickness of 100 nm was deposited on the HTL. The test structure is protected from ambient conditions by encapsulation glass lid that forms a cavity, which contains a getter material.

The pn test structure of Example 5 E5 was prepared in the same way as Example 3 and Example 4, but a connecting charge generation layer was formed by vacuum deposition of zinc phthalocyanine on top of the n-doped CGL. After this, p-doped CGL, HTL and Al were deposited in the same way as an Example 3 and Example 4.

Comparative example 2 CE2 of the pn test-structure is prepared in the same way as the pn test-structure in Example 3 and Example 4, but it does not include any p-doped CGL or any n-doped CGL.

The current-voltage characteristics of pn test-structures are measured using a source-measure unit (Keithley 2400). The voltage is applied from 0 V to 6 V. The current is detected at each voltage step.

The Diagram 1 in figure 1 shows a current voltage characteristic. The diagram 1 in figure 1 shows a current voltage characteristic of Example 3 E3, Example 4 E4, Example 5 E5 and Comparative Example 2 CE2. The current in the Comparative example 2 CE2 without p-dopant is very low, whereas the current in Example 3 E3 using 8 vol% of

C4in the p-CGL is much higher indicating the tunnel currents as explained therein. The current in Example 4 E4 using 16 vol% of C4 is even higher. The current increases further if the connecting charge generation layer is used as in Example 5 E5. The higher currents indicate the presence of the tunnel currents which correspond to the CGL effect used in tandem, triple or quadruple OLEDs.

These examples show that compounds of formula (I) can be advantageously used as p-dopants in pn-junctions of stacked OLEDs.

### List of reference numerals

| | |
|---|---|
| CE2 | Comparative Example 2 |
| E3 | Example 3 |
| E4 | Example 4 |
| E5 | Example 5 |

## Claims

1. **An electronic component** comprising at least one compound of the formula (I): 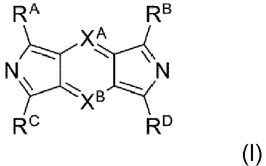
or their radical anions, radical anionic salts, dianions, dianionic salts, or their charge transfer complexes with donors,
in which
X^{A} is selected from C-H, nitrogen (N), C-CF₃ and C-R^{E},
X^{B} is selected from C-H, nitrogen (N), C-CF₃ and C-R^{F}, and
wherein in compounds of formula (I) R^{A}, R^{B}, R^{C}, R°, R^{E}, and R^{F} are independently selected from
C₆-C₁₄-aryl or heteroaryl,
Wherein heteroaryl has 4 to 13 carbon atoms,
wherein heteroaryl has 1, 2 or 3 identical or different heteroatoms or heteroatom-containing groups as ring members, selected from N, O, S, SO and SO₂,
wherein C₆-C₁₄-aryl and heteroaryl are unsubstituted or substituted by 1, 2, 3, 4 or 5 identical or different radicals R^{G};
wherein R^{G} is selected from CN, F, Cl, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or
different radicals selected from F, CN, C₁-C₄-alkyl and C₁-C₄-haloalkyl with the proviso that 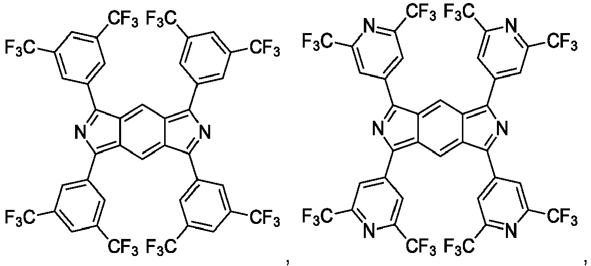 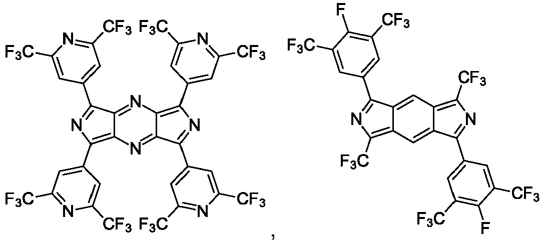 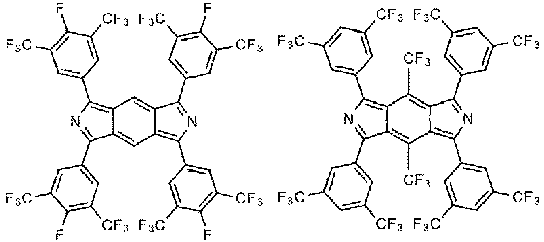
are excluded.

2. **An electronic component** according to claim 1, wherein in compounds of formula (I) each of R^{A}, R^{B}, R^{C}, R°, R^{E}, and R^{F} can be independently selected from one of the formulas (II.1) - (II.46): 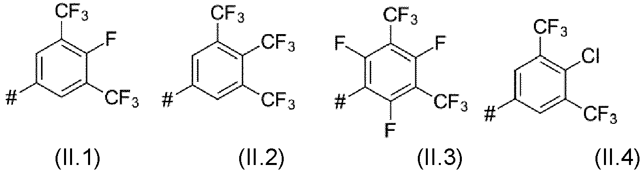 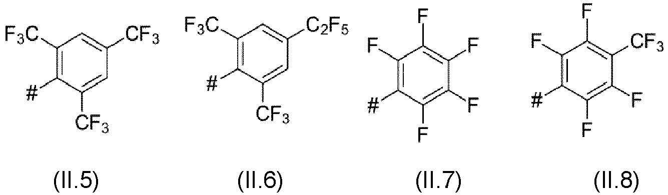 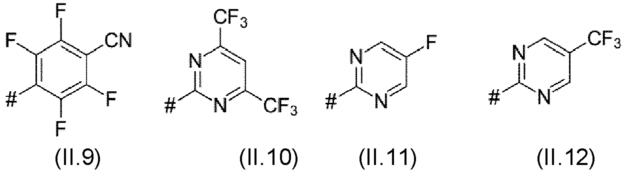 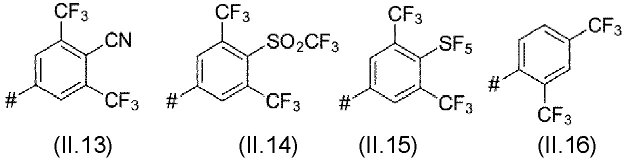 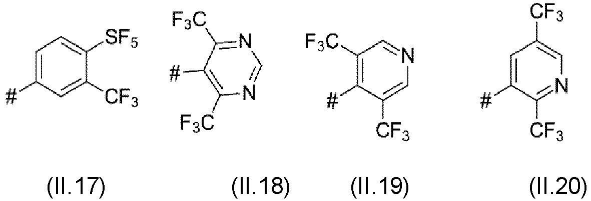 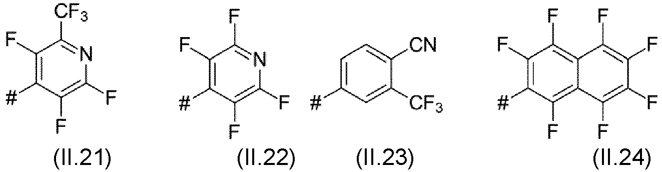 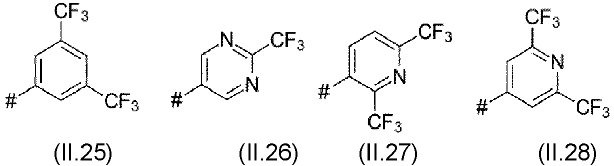 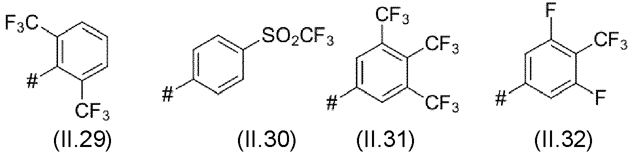 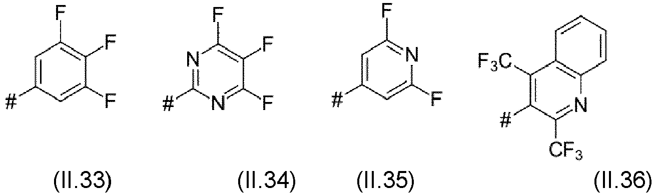 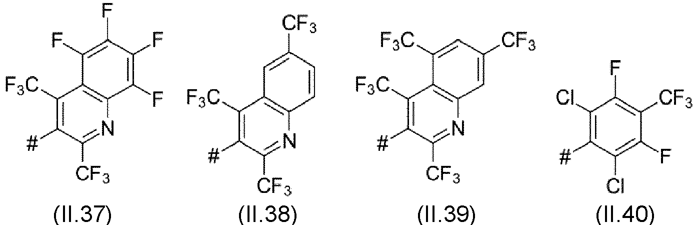 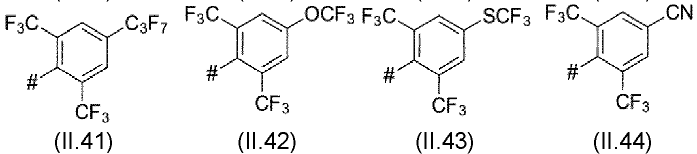 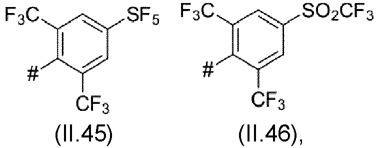 where # denotes the bond to the remaining molecule of formula (I).

3. The electronic component according to claim 1 or 2, wherein the compounds of formula (I) are selected from a compound of the following formulae: 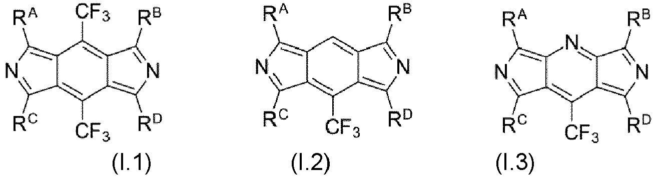 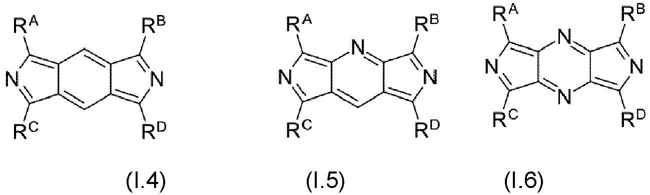 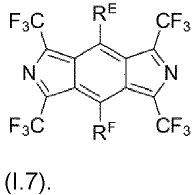 wherein in compounds of formula (I) R^{A}, R^{B}, R^{C}, R°, R^{E} and R^{F} are defined according to claim 1 or 2.

4. The electronic component according to one of the claims 1 to 3 in form of
- a light-emitting devices, preferably a light-emitting diode,
- a display device,
- a photovoltaic cell,
- an organic photodetector,
- an organic transistor,
- an organic diode,
- an organic laser diode,
- an organic or hybrid solar cell, preferably an organic solar cell or a perovskite solar cell,
- an organic transistor, preferably an organic vertical transistor, or
- a battery.

5. The electronic component according to one of the claims 1 to 4, comprising at least one hole transport layer and/or at least one hole injection layer and/or at least one hole extraction layer, which comprise at least one or more of the compounds of formula (I).

6. The electronic component according to one of the claims 1 to 5, comprising at least one pn-junction, which comprises at least one or more of the compounds of formula (I).

7. A compound of the formula (I): 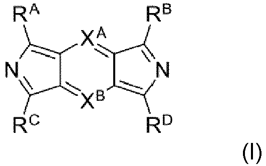
or their radical anions, radical anionic salts, dianions, dianionic salts, or their charge transfer complexes with donors,
in which
X^{A} is selected from C-H, nitrogen (N), C-CF₃ and C-R^{E},
X^{B} is selected from C-H, nitrogen (N), C-CF₃ and C-R^{F}, and
wherein in compounds of formula (I) R^{A}, R^{B}, R^{C}, R°, R^{E}, and R^{F} are independently selected from
C₆-C₁₄-aryl or heteroaryl,
wherein heteroaryl has 4 to 13 carbon atoms,
wherein heteroaryl has 1, 2 or 3 identical or different heteroatoms or heteroatom-containing groups as ring members, selected from N, O, S, SO and SO₂, wherein C₆-C₁₄-aryl and heteroaryl are unsubstituted or substituted by 1, 2, 3, 4 or 5 identical or different radicals R^{G};
wherein R^{G} is selected from CN, F, Cl, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or
different radicals selected from F, CN, C₁-C₄-alkyl and C₁-C₄-haloalkyl,
with the proviso that 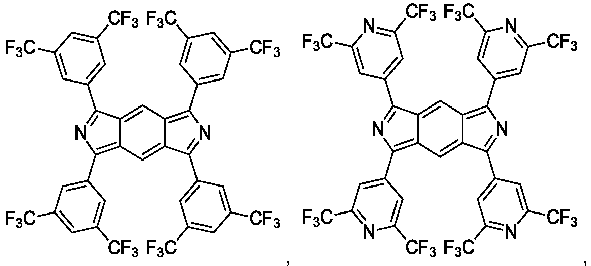 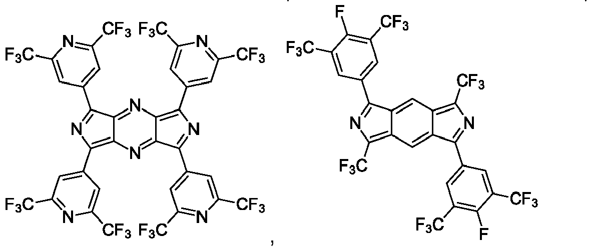 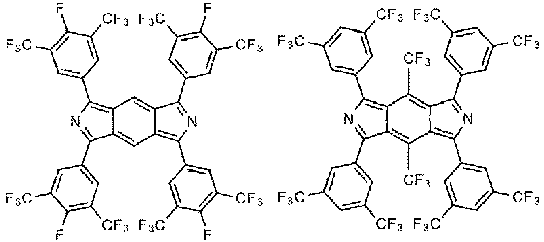
are excluded.

8. The compound according to claim 7, wherein the compounds of formula (I) are selected from a compound of the following formulae:

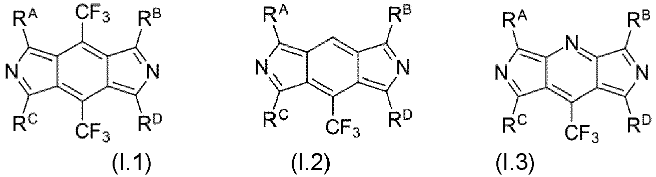

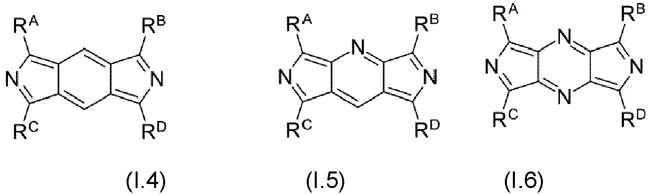

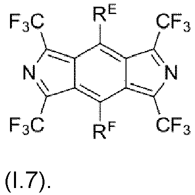

9. The compound according to claim 7, wherein in compounds of the formula (I) wherein X^{A} and X^{B} are C-H or wherein X^{A} and X^{B} are C-CF₃.

10. **A doped semiconductor layer** comprising at least one electron donor and at least one doping agent, wherein the doping agent is a compound of the formula (I) as defined in any one of the claims 7 to 9.

11. A **use** of the compound according to claim 7 to 9 as organic semiconductor,
- as a redox doping agent in organic semiconductor layers,
- as p-dopant in hole transport layers,
- as charge injector in a charge injection layer,
- as charge extractor in a charge extraction layer,
- as a sublayer of a pn-junction, especially as a sublayer of a charge-generation layer or a charge conversion layer
- as acceptor compound in charge-transfer complexes,
- as cathode material in organic and redox flow batteries,
- as electrochromic material.

12. The use of at least one compound of formula (I) as defined in any of the claims 7 to 9, preferably compounds of formulae (I.1) to (I.7) as defined in any of the claims 7 to 9, as organic doping agent for the doping of an organic semiconductive layer, as absorbing layer, as charge injection layer, or as organic semiconductor itself.

13. Use of radical anions and dianions of the compound of the general formula (I) as defined in any one of the claims 7 to 9 or of charge transfer complexes of a compound of formula (I) as defined in any one of claims 7 to 9 with electron donors as organic semiconductor or as electrochromic material.

14. A method for the preparation of a doped semiconductor layer, wherein a hole transport material and a compound of general formula (I) according to one of the claims 7 to 9 is used, comprising at least one of the following steps:
(a) Simultaneous evaporation of the hole transport material and the compound of formula (I).
(b) Evaporation of a pre-mixed material containing the hole transport material and at least one compound of general formula (I) from one single source.
(c) Sequential deposition of the hole transport material and at least one compound of general formula (I).
(d) Doping of a hole transport layer by a solution containing at least one compound of general formula (I) followed by evaporation of the solvent by thermal treatment.
(e) Surface doping of a layer of a hole transport material by a layer of at least one compound of general formula (I) applied to one or both surfaces of the layer of a hole transport material.
(f) Preparing a solution of a hole transport material and at least one compound of general formula (I) and forming a film from the solution.

15. The method for the preparation of a doped semiconductor layer according to claim 10 or of a doped semiconductor layer prepared by the method according to claim 14, wherein the doped matrix material is heated at a temperature of at least 50-120°C, for a time of 1 - 500 minutes.
